(19) Europäisches Patentamt

European Patent Office

Office européen des brevets

(11) **EP 1 135 853 B1**

(12) **EUROPEAN PATENT SPECIFICATION**

(45) Date of publication and mention
of the grant of the patent:
**08.09.2004 Bulletin 2004/37**

(51) Int Cl.⁷: **H03D 7/00**

(86) International application number:
**PCT/US1999/023921**

(21) Application number: **99954905.8**

(22) Date of filing: **18.10.1999**

(87) International publication number:
**WO 2000/024118 (27.04.2000 Gazette 2000/17)**

(54) **INTEGRATED FREQUENCY TRANSLATION AND SELECTIVITY WITH A VARIETY OF FILTER EMBODIMENTS**

INTEGRIERTE FREQUENZUMSETZUNG UND SELEKTIVITÄT MIT VERSCHIEDENEN FILTERDARSTELLUNGEN

TRANSLATION DE FREQUENCE ET SELECTIVITE DE FREQUENCE INTEGREES, A L'AIDE D'UNE GRANDE VARIETE DE MODES DE REALISATIONS DE FILTRES

(84) Designated Contracting States:
**AT BE CH CY DE DK ES FI FR GB GR IE IT LI LU MC NL PT SE**
Designated Extension States:
**AL LT LV MK RO SI**

(30) Priority: **21.10.1998 US 175966**
**21.10.1998 US 176022**
**16.04.1999 US 293095**
**16.04.1999 US 293283**
**16.04.1999 US 293342**

(43) Date of publication of application:
**26.09.2001 Bulletin 2001/39**

(73) Proprietor: **Parkervision, Inc.**
**Jacksonville, FL 32256 (US)**

(72) Inventors:
• **SORRELLS, David, F.**
**Middleburg, FL 32068 (US)**
• **BULTMAN, Michael, J.**
**Jacksonville, FL 32246 (US)**
• **COOK, Robert, W.**
**Switzerland, FL 32259 (US)**
• **LOOKE, Richard, C.**
**Jacksonville, FL 32257 (US)**
• **MOSES, Charley, D., Jr.**
**Jacksonville, FL 32217 (US)**
• **RAWLINS, Gregory, S.**
**Heathrow, FL 32746 (US)**
• **RAWLINS, Michael, W.**
**Lake Mary, FL 32746 (US)**

(74) Representative:
**Cross, James Peter Archibald et al**
**R.G.C. Jenkins & Co.,**
**26 Caxton Street**
**London SW1H 0RJ (GB)**

(56) References cited:
**WO-A-96/02977       WO-A-96/08078**
**WO-A-96/39750       DE-C- 4 237 692**
**US-A- 5 493 581       US-A- 5 557 641**
**US-A- 5 640 424**

• **A.V. OPPENHEIM AND R.W SCHAFER: "Digital Signal Processing", 1975, PRENTICE HALL, INC, ENGLEWOOD CLIFFS, N.J., USA**
• **L.R.RABINER AND B.GOLD: "Theory and Application of Digital Signal Processing", 1975, PRENTICE-HALL, INC, ENGLEWOOD CLIFFS, N.J., USA**

**Description**

*Field of the Invention*

The present invention is generally related to methods and apparatuses for down-converting and filtering an input signal.

*Related Art*

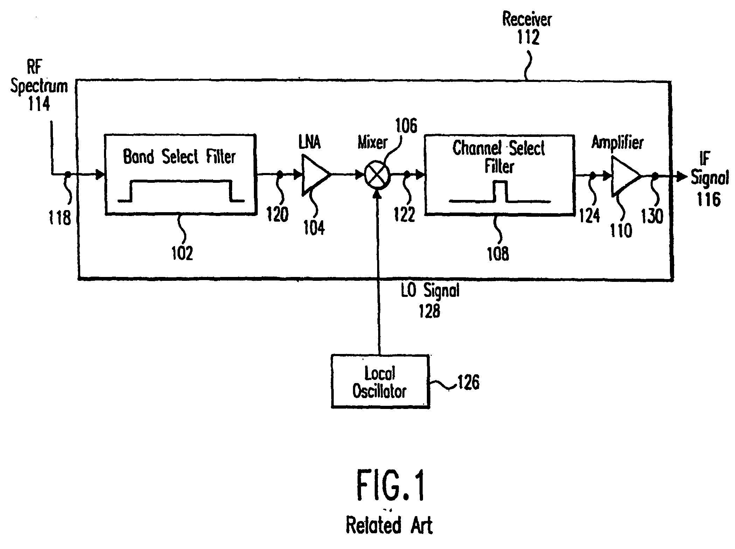

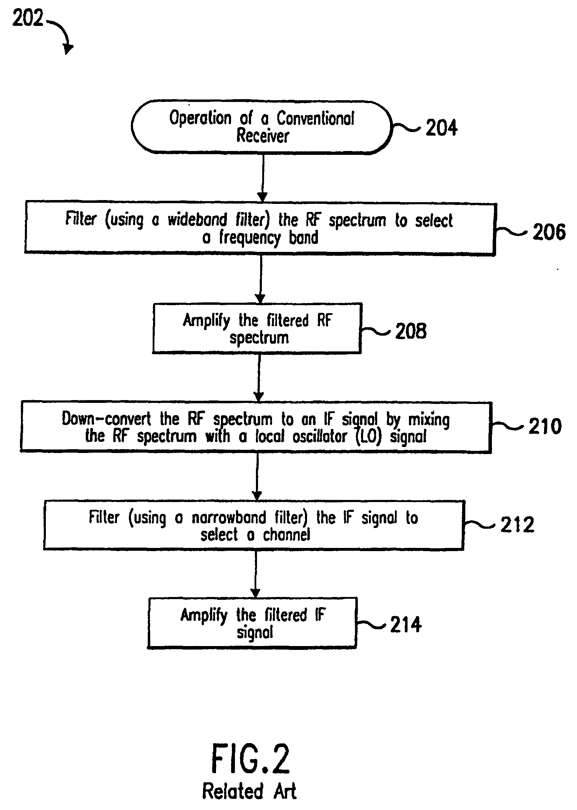

FIG. 1 is a block diagram of an example conventional receiver 112. FIG. 2 is a flowchart representing the operation of the receiver 112.

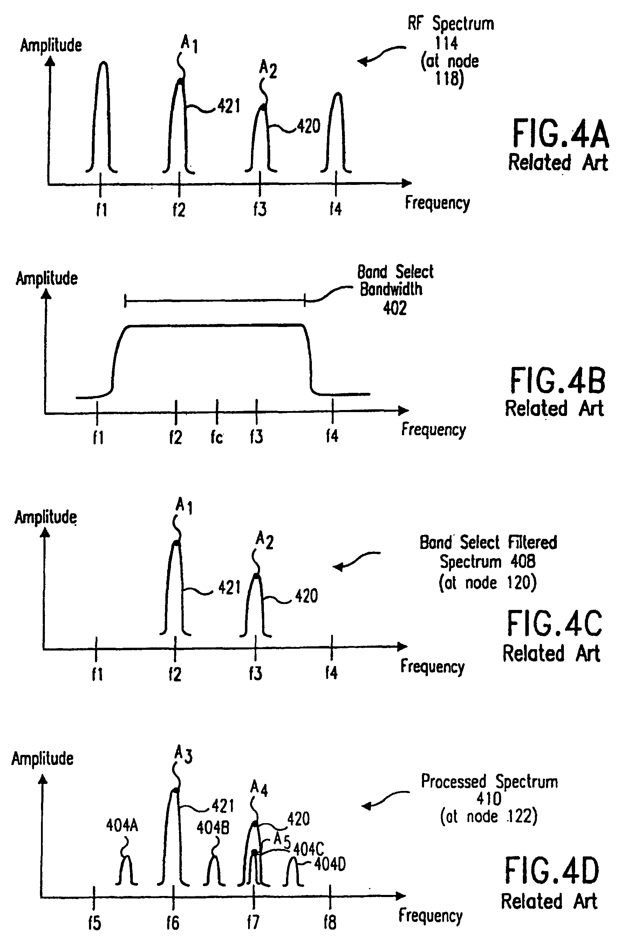

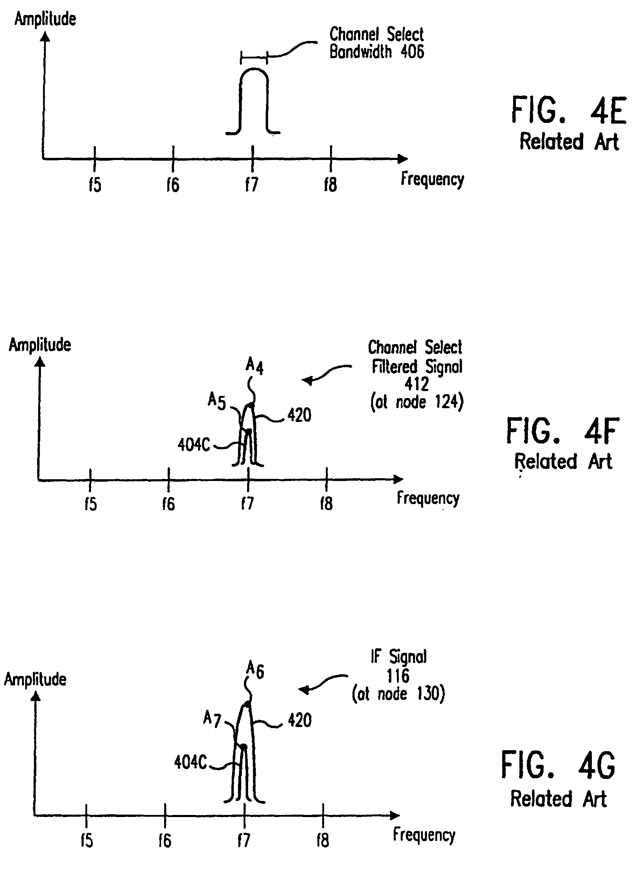

In step 206, a band-select filter 102 filters an RF (radio frequency) spectrum 114. An example RF spectrum 114 is shown in FIG. 4A. The RF spectrum 114 includes signal components at frequencies $f_1$, $f_2$, $f_3$, and $f_4$. Assume, for purposes of example, that the receiver 112 is configured to receive signals at frequency $f_3$.

Typically, the band-select filter 102 is a wide-band filter. The characteristics of the band-select filter 102 are generally illustrated in FIG. 4B. The band-select filter 102 has a center frequency $f_c$, and a band-select bandwidth 402. In the example shown in FIG. 1, where the receiver 112 is receiving an RF spectrum 114, the center frequency $f_c$ of the band-select filter 102 is within the RF range. For example, the center frequency $f_c$ may be 900 MHZ. Depending on the application, the band-select bandwidth 402 may be as much as 50 MHz, or greater. In the example where the center frequency $f_c$ is 900 MHZ and the band-select bandwidth 402 is 50 MHZ, the passband (i.e., the band of frequencies that pass through a filter with little loss, relative to frequencies outside of the band) of the band-select filter 102 is 875 Mhz to 925 MHz. According to these specifications, the quality factor of the band-select filter 102, or Q, is equal to 18 (as described further below, Q is equal to the center frequency divided by the bandwidth, or 904MHz ÷ 50Mhz in this example). This Q factor is typical for a band-pass filter operating at RF. In fact, generally, high Q factors at high frequencies are difficult to realize using conventional filter techniques, and have at best limited tuning capabilities.

The band-select filter 102 in step 206 operates to filter out signals outside its passband. For example purposes, assume that $f_1$ and $f_4$ are outside the passband of the band-select filter 102, and $f_2$ and $f_3$ are inside the passband of the band-select filter 102 (this is the case in the example of FIGS. 4A and 4B). Accordingly, in this example, the band-select filter 102 operates to filter out the signal components at frequencies $f_1$ and $f_4$. The band-select filter 102 passes the signal components at frequencies $f_2$ and $f_3$. The result of the operation of the band-select filter 102 is shown in FIG. 4C.

In steps 208 and 210, the signal output by the band-select filter 102 (herein called the band-select filtered spectrum 408 for reference purposes) is processed by a low-noise amplifier (LNA) 104 and a mixer 106. The LNA 104 operates to amplify the band-select filtered spectrum 408, and the mixer 106 operates to down-convert the band-select filtered spectrum 408 in a well known manner.

Both the LNA 104 and the mixer 106 have limited dynamic ranges over which their operation is linear. Outside of these ranges, the LNA 104 and the mixer 106 exhibit non-linear operation. The broader the band select filter 102 (i. e., the wider the pass band), the more energy is able to reach the LNA 104 and the mixer 106. Consequently, the broader the band select filter 102, the greater the chance that the respective dynamic ranges of the LNA 104 and the mixer 106 will be exceeded. For purposes of example, assume that the signal component 420 at frequency $f_3$ combined with the undesired signal component 421 at frequency $f_2$ exceed the linear ranges of the LNA 104 and the mixer 106 (this is a common practical example).

When operating on a signal that is outside their linear ranges (i.e., when operating in a non-linear manner), the LNA 104 and/or the mixer 106 generate spurious signal components. In the given example, when operating on the signal components 420 and 421, the LNA 104 and/or the mixer 106 generate spurious signal components 404. See FIG. 4D. Some of these spurious components 404 may coincide and interfere with signals at desired frequencies. For example, as noted above, the receiver 112 is tuned to receive signals at frequency $f_3$ (in the example of FIGS. 4A-4G, frequency $f_7$ corresponds to $f_3$ after downconversion; similarly, frequency $f_6$ corresponds to $f_2$ after downconversion).

In the process of operating on the signal components 420 and 421, the LNA 104 and/or the mixer 106 generate a spurious signal component 404C at frequency $f_7$. This spurious component 404C coincides with the desired signal component 420 at frequency $f_7$. This spurious component 404C interferes with the desired signal component 420.

In step 212, a channel-select filter 108 filters the signal generated by the LNA 104 and the mixer 106 (this signal is herein called the processed spectrum 410 for reference purposes). The characteristics of the channel-select filter 108 are generally shown in FIG. 4E. The channel-select filter 108 has a center frequency at frequency $f_7$ and a channel-select bandwidth 406. The center frequency $f_7$ of the channel select filter 108 is at a lower frequency than the center frequency of the band select filter 102. For example, the center frequency $f_7$ of the channel select filter 108 may be 10 MHZ. Depending on the application, the channel-select bandwidth 406 may be, for example, 50 KHz. According to these specifications, the quality factor of the channel-select filter 108, or Q, is equal to 200 (as indicated above, and described further below, Q is equal to the center frequency divided by the bandwidth, or 10MHz ÷ 50 KHz in this example). This Q factor is typical for a narrowband band-pass filter operating at IF (intermediate frequency). As this example illustrates, it is possible to realize higher Q factors at lower frequencies using conventional filter techniques.

As shown in FIG. 4F, the effect of the channel-select filter 108 in step 212 is to filter-out the signal component at frequency $f_6$ and spurious components 404A, 404B, and 404D, but to pass any signals at frequency $f_7$. Both the desired signal component 420 and the spurious component 404C exist at frequency $f_7$, and are within the passband of the channel-select filter 108. Thus, both the desired signal component 420 and the spurious component 404C are passed by the channel-select filter 108.

In step 214, an amplifier 110 amplifies the signal output from the channel-select filter 108 (this signal is called the channel select filtered signal 412; for reference purposes). The channel select filtered signal 412 includes both the desired signal component 420 and the spurious component 404C. Consequently, the amplifier 110 amplifies both the desired signal component 420 and the spurious component 404C.

In other words, once the spurious component 404C is generated, it follows the desired signal component 420 in all downstream processing.

As noted above, the spurious signal component 404C may make it difficult if not impossible to properly receive the desired signal component 420. Accordingly, because the receiver 112 utilized a wide-band, band-select filter 102 prior to amplification and frequency translation by non-linear components (i.e., by the LNA 104 and the mixer 106, respectively), the receiver 112 suffers from potentially degraded performance. The potential for signal interference as described above limits the receiver 112's applicability.

The document DE 4237692 C1 discloses a digital radio signal receiver which digitally converts an intermediate frequency signal, filters the digital signal with a digital all-pass filter and down-samples the filtered digital signal with a digital mixer.

The document US 5,557,641 appears to disclose a receiver and transmitter where signal up-conversion and down-conversion is performed in part by a charge-coupled device.

The document WO 96/02977 discloses an alias-driven frequency down-converter using a sample and hold or track and hold circuit.

The document WO 96/39750 discloses a radio-frequency reception circuit using a sample and hold circuit to sub-sample an analog RF channel.

### Summary of the Invention

According to one aspect of the present invention, there is provided a method according to claim 1. According to another aspect of the present invention, there is provided a method according to claim 12.

According to embodiments of the present invention, a filtering operation and down-conversion operation are performed in an integrated, unified manner.

In embodiments of the invention, a relatively high Q factor can be realized regardless of center frequency.

In embodiments of the invention, the input signal is an RF signal. Thus, the frequency selectivity operation performed by the present invention represents relatively high Q RF filtering.

In other words, embodiments of the invention provide precise frequency selectivity at high frequencies. Also, the invention provides for frequency down-conversion.

It is noted that the invention is not limited to the embodiments summarized in this section. The embodiments summarized in this section, as well as other embodiments, are described below.

Further features and advantages of the invention, as well as the structure and operation of various embodiments of the invention, are described in detail below with reference to the accompanying drawings.

### Brief Description of the Figures

The present invention will be described with reference to the accompanying drawings, wherein:

FIG. 1 is a block diagram of a conventional receiver;
FIG. 2 is a flowchart representing the operation of the conventional receiver of FIG. 1;
FIG. 3 illustrates an operational map of the conventional receiver of FIG. 1;
FIGS. 4A-4G are waveforms used to illustrate the operation of the conventional receiver of FIG. 1;
FIG. 5 is used to illustrate the manner in which a filters quality factor is calculated;
FIGS. 6A, 6B, 7, and 8 illustrate characteristics of different types of filters;
FIGS.9-11 illustrate different types of modulation schemes;
FIG. 12 is a block diagram of a receiver and functions that are performed by the receiver;

FIG. 13 is a block diagram of the UDF module ofFIG. 11, wherein it is illustrated that operations related to the frequency translation operation are performed prior to operations relating to the frequency selectivity operation, according to an embodiment of the invention;

FIG. 14 is a flowchart depicting the operation of the unified downconverting and filtering (UDF) module according to an embodiment of the invention;

FIG. 15 is a table illustrating example values at nodes within an example UDF module (shown in FIG. 24) at consecutive time increments;

FIG. 16 is a more detailed operational flowchart of the unified downconverting and filtering (UDF) operations performed by embodiments of the invention;

FIG. 17 is a more detailed block diagram of an example UDF module according to an embodiment of the invention;

FIG. 18 is an operational flowchart ofthe unified downconverting and filtering (UDF) operations performed by embodiments of the invention, wherein the filtering operation comprises a band-pass filtering operation;

FIG. 19 is an example implementation of the operational steps of FIG. 18;

FIG. 20 is a table representing example values in nodes of the UDF module of FIG. 19 at consecutive time increments;

FIG. 21 is an example block diagram of an example filter;

FIG. 22 is an operational flowchart of the unified downconverting and filtering (UDF) operations performed by embodiments of the invention, wherein the filtering operation comprises a low-pass filtering operation;

FIG. 23 is an example UDF module useful for implementing the steps of the flowchart in FIG. 22;

FIG. 24 is an example implementation of the UDF module according to an embodiment of the invention;

FIGS. 25 and 26 are used to illustrate the filter characteristics of the UDF module of FIG. 24;

FIGS. 27A-27F and 28A-28F are waveforms used to illustrate the operation of the UDF module of FIG. 24;

FIG. 29 is a block diagram of an example receiver according to an embodiment of the invention;

FIG. 30 is a flowchart representing the operation of the receiver of FIG. 29 according to an embodiment of the invention;

FIG. 31 illustrates an example switched capacitor used to implement the delay modules in an example UDF module according to an embodiment of the invention;

FIGS. 32 and 33 illustrate a clock signal having two phases, $\phi_1$ and $\phi_2$;

FIG. 34 illustrates an example analog delay line used to implement the delay modules of an example UDF module according to an embodiment of the invention;

FIG. 35 illustrates a resistor attenuator used to implement the scaling modules in an example UDF module according to an embodiment of the invention;

FIG. 36 illustrates an example resistor attenuator;

FIG. 37 illustrates an example amplifier capable of implementing the scaling module in an example UDF module according to an embodiment of the invention;

FIG. 38 illustrates an example resistive summer capable of implementing the summer/adder in an example UDF module according to an embodiment of the invention;

FIG. 39 illustrates an example resistive summer;

FIG. 40 illustrates an example OPAMP (operational amplifier) summer capable of implementing the summer/adder in an example UDF module according to an embodiment of the invention;

FIG. 41 illustrates an example OPAMP summer;

FIG. 42 illustrates an example control signal generator according to an embodiment of the invention;

FIGS. 43A-43D illustrate signals present at nodes in the control signal generator of FIG. 42;

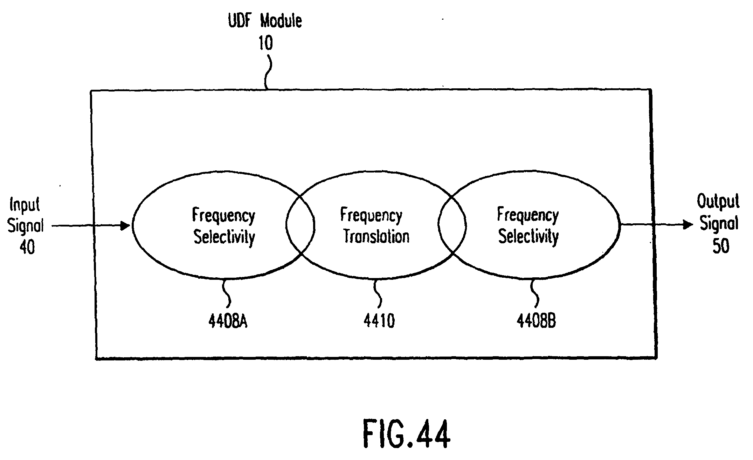

FIG. 44 illustrates an operational map of an example UDF module according to an alternate embodiment of the invention;

FIG. 45 is used to illustrate the operation of a sample and hold circuit according to an embodiment of the invention;

FIG. 46 is a flowchart representing an example operation of the sample and hold circuits shown in FIG. 45;

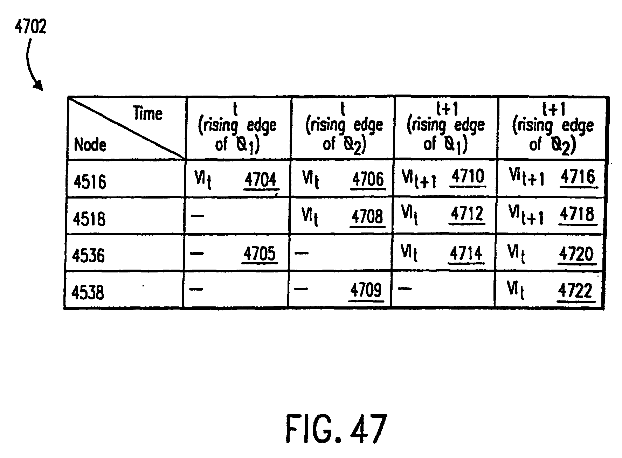

FIG. 47 is a table indicating example values present at nodes in the sample and hold circuits of FIG. 45;

FIG. 48 illustrates an example bi-phase clock signal used to control switches in the sample and hold circuits of FIG. 45;

FIG. 49 is a flowchart depicting the manner in which a UDF module is designed according to an embodiment of the invention;

FIG. 50 is a more detailed flowchart depicting the manner in which a UDF module is designed according to an embodiment of the invention;

FIG. 51 illustrates an example table of transform expressions that can be used when designing a UDF module according to embodiments of the invention;

FIG.52A illustrates an example embodiment of the invention;

FIG.52B illustrates equations for determining charge transfer, in accordance with the present invention;

FIG.52C illustrates relationships between capacitor charging and aperture, in accordance with the present invention;

FIG.52D illustrates relationships between capacitor charging and aperture, in accordance with the present invention;

FIG.52E illustrates power-charge relationship equations, in accordance with the present invention; and

FIG.52F illustrates insertion loss equations, in accordance with the present invention.

FIGS. 53A and 53A-1 illustrate example aliasing modules according to an embodiment of the invention;

FIGS. 53B-53F illustrate example waveforms used to describe the operation of the aliasing modules of FIGS. 53A and 53A-1;

FIG. 54 presents filter-related equations that are relevant to embodiments of the invention;

FIG. 55 is a block diagram of a unified downconverting and filtering (UDF) module that performs running average filtering according to an embodiment of the invention;

FIG. 56 illustrates example control signals used to illustrate the operation of the UDF module of FIG. 55;

FIG. 57 illustrates an example filter passband used to illustrate the operation of the UDF module of FIG. 55;

FIG. 58 is a block diagram of a UDF module according to another embodiment of the invention;

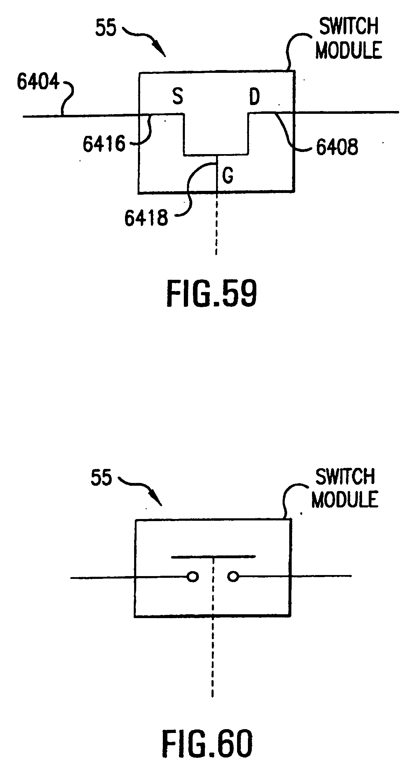

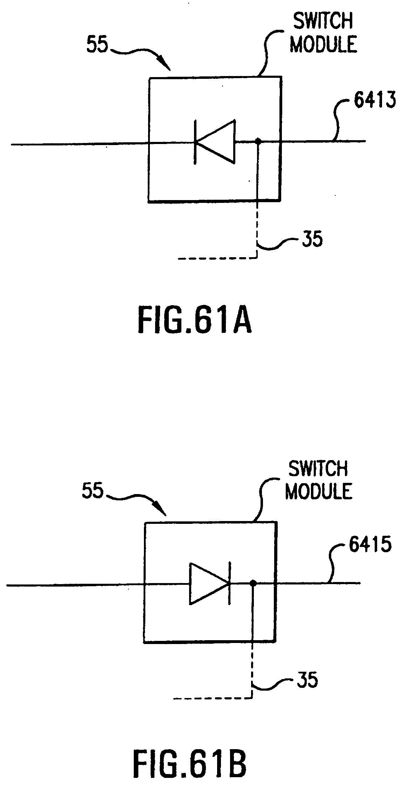

FIGS. 59, 60, 61A, and 61B illustrate example implementations of a switch module according to embodiments of the invention;

FIGS. 62A, 62B, 63 and 64 illustrate example aperture generators;

FIG. 65 illustrates an oscillator according to an embodiment of the present invention; and

FIG. 66 illustrates an energy transfer system with an optional energy transfer signal module according to an embodiment of the invention.

### *Detailed Description of the Preferred Embodiments*

<table>
<tr><td colspan="4" align="center">***Table of Contents***</td></tr>
<tr><td>1</td><td colspan="3">Terminology</td></tr>
<tr><td></td><td>1.1</td><td colspan="2">Filters</td></tr>
<tr><td></td><td>1.2</td><td colspan="2">Other Terms</td></tr>
<tr><td>2</td><td colspan="3">Overview of the Invention</td></tr>
<tr><td>3</td><td colspan="3">Unified Downconverting and Filtering</td></tr>
<tr><td></td><td>3.1</td><td colspan="2">Conceptual Description</td></tr>
<tr><td></td><td>3.2</td><td colspan="2">High Level Description</td></tr>
<tr><td></td><td></td><td>3.2.1</td><td>Operational Description</td></tr>
<tr><td></td><td></td><td>3.2.2</td><td>Structural Description</td></tr>
<tr><td></td><td>3.3</td><td colspan="2">Example Embodiments</td></tr>
<tr><td></td><td></td><td>3.3.1</td><td>First Embodiment: Band Pass Filtering and Frequency Translation</td></tr>
<tr><td></td><td></td><td>3.3.1.1</td><td>Operational Description</td></tr>
<tr><td></td><td></td><td>3.3.1.2</td><td>Structural Description</td></tr>
<tr><td></td><td></td><td>3.3.2</td><td>Second Embodiment: Low Pass Filtering and Frequency Translation</td></tr>
<tr><td></td><td></td><td>3.3.2.1</td><td>Operational Description</td></tr>
<tr><td></td><td></td><td>3.3.2.2</td><td>Structural Description</td></tr>
<tr><td></td><td></td><td>3.3.3</td><td>Fifth Embodiment: Running Average Filter</td></tr>
<tr><td></td><td></td><td>3.3.4</td><td>Other Embodiments</td></tr>
<tr><td></td><td>3.4</td><td colspan="2">Implementation Examples</td></tr>
<tr><td></td><td></td><td>3.4.1</td><td>Implementation Example of a Unified Downconverting and Filtering (UDF) Module</td></tr>
<tr><td></td><td></td><td>3.4.2</td><td>Implementation Examples of Components of the UDF Module</td></tr>
</table>

(continued)

| | | | | Table of Contents | | |
|---|---|---|---|---|---|---|
| | | | 3.4.2.1 | Downconvert and Delay Module | | |
| | | | | 3.4.2.1.1 | Universal frequency down-conversion (UFD) Module | |
| | | | | | 3.4.2.1.1.1 | Optional Energy Transfer Signal Module |
| | | | | | 3.4.2.1.1.2 | Charge and Power Transfer Concepts |
| | | | 3.4.2.2 | Delay Modules | | |
| | | | 3.4.2.3 | Scaling Modules | | |
| | | | 3.4.2.4 | Adder | | |
| | | | 3.4.2.5 | Control Signal Generator | | |
| | | | 3.4.2.6 | Output Sample and Hold Module | | |
| | | | 3.4.2.7 | Output Smoothing Module | | |
| | | 3.4.3 | Implementing the UDF Module as an Integrated Circuit (IC) | | | |
| | | 3.4.4 | Other Implementations | | | |
| 4 | Designing a Unified Downconverting and Filtering (UDF) Module | | | | | |
| 5 | Adjustable UDF Module | | | | | |
| 6 | Amplification | | | | | |
| 7 | Example Applications | | | | | |
| 7.1 | Receiver | | | | | |
| 8 | Conclusion | | | | | |

## 1 Terminology

Various terms and concepts used in this application are generally described in this section. The description in this section is provided for illustrative and convenience purposes only, and is not limiting. The meaning of these terms and concepts will be apparent to persons skilled in the relevant art(s) based on the entirety of the teachings provided herein.

### 1.1 Filters

A filter is a device that allows electromagnetic signals of specific frequencies to pass with little attenuation. More particularly, a filter passes signals inside a frequency range (called a passband) with little attenuation. The filter does not pass signals outside of the passband (i.e., the filter attenuates signals outside of the passband).

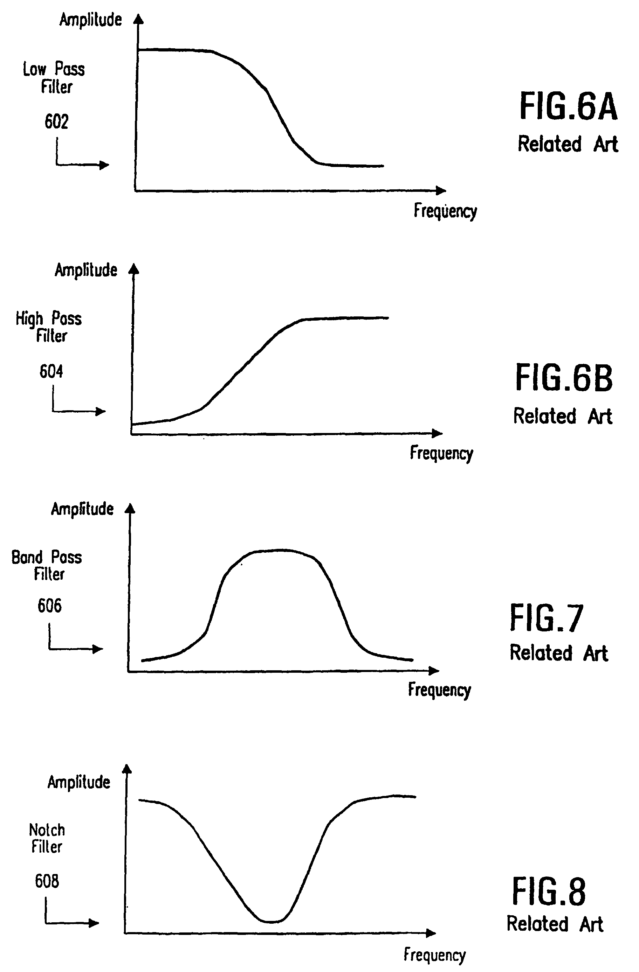

There are a number of different types of filters. These include, for example, low-pass niters, high-pass filters, band-pass filters, notch filters, etc. The characteristics of these filters are generally illustrated in FIGS. 6A, 6B, 7, and 8.

There are many transfer functions for characterizing the operation of filters. For example, and without limitation, the following biquadratic equation represents the transfer function of a second order filter.

$$\frac{VO}{VI} = \frac{\alpha_2 \, z^2 + \alpha_1 \, z + \alpha_0}{\beta_2 \, z^2 + \beta_1 \, z + \beta_0} \qquad \text{EQ. 1}$$

Often, the $\beta_2$ coefficient is factored out in order to solve for $z^2$. As will be appreciated, doing so merely results in changing the values of other coefficients. Without any loss of generality, EQ. 1 is re-written below with $\beta_2$ factored out (for ease of illustration, the effect of filtering out $\beta_2$ on the other coefficients of EQ. 1 is not explicitly indicated in the following):

$$\frac{VO}{VI} = \frac{\alpha_2 z^2 + \alpha_1 z + \alpha_0}{z^2 + \beta_1 z + \beta_0}$$

It is noted that the invention is not limited to second order filters (the invention is applicable to filters of other orders), or to EQ. 1 for second order filters.

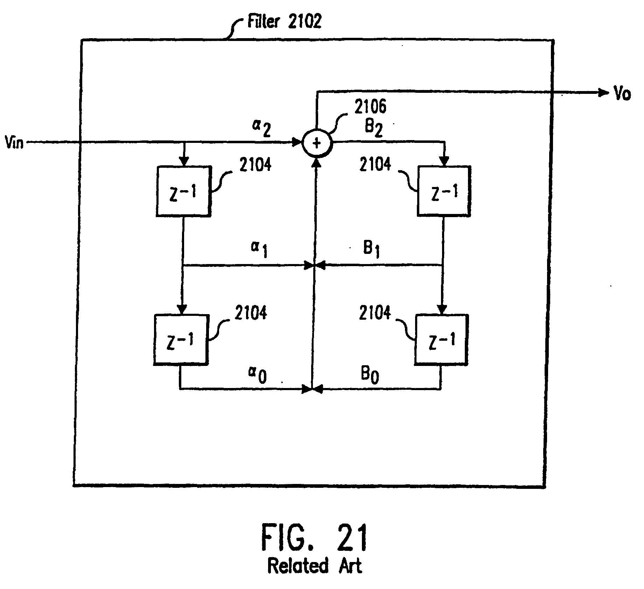

A well known conceptual block diagram implementation of this biquadratic equation is shown in FIG. 21. The $z^{-1}$ designation in FIG. 21 designates a unit delay operation (that is, a $z^{-1}$ module delays an input signal by one time unit).

The biquadratic equation of EQ. 1 applies to second order filter types. The transfer function for a particular type of second order filter (low-pass, high-pass, band-pass, notch, etc.) can be obtained from the biquadratic equation ofEQ. by appropriately setting the values of the coefficients. For example, a transfer function of a band-pass filter can be obtained from the biquadratic equation of EQ. 1 by setting $\alpha_2$ and $\alpha_0$ to zero. The resulting transfer function, representing the operation of a band-pass filter, is as follows:

$$\frac{VO}{VI} = \frac{\alpha_1 z}{z^2 + \beta_1 z + \beta_0} \qquad\qquad \text{EQ. 2}$$

Solving for VO yields the following:

$$VO = \alpha_1 z^{-1}VI - \beta_1 z^{-1}VO - \beta_0 z^{-2}VO \qquad\qquad \text{EQ. 3}$$

In the above, the value z equals the following:

$$z = \sin\left(\frac{f}{F_s}\right) + j \ \cos\left(\frac{f}{F_s}\right) \qquad\qquad \textbf{EQ. 4}$$

In EQ. 4, f is the frequency, and $F_s$ is the sample frequency of the system.

An example transfer function of a low-pass filter can be obtained from the biquadratic equation of EQ. 1 by setting $\alpha_2$ and $\alpha_1$ equal to zero. The resulting transfer function, corresponding to a low-pass filter, is as follows:

$$\frac{VO}{VI} = \frac{\alpha_0}{z^2 + \beta_1 z + \beta_0} \qquad\qquad \text{EQ. 5}$$

Solving for VO yields the following:

$$VO = \alpha_0 z^{-2}VI - \beta_1 z^{-1}VO - \beta_0 z^{-2}VO \qquad\qquad \text{EQ. 6}$$

Transfer functions for other types of filters, such as (and without limitation) high-pass filters and notch filters, can be obtained in a similar manner from the biquadratic equation of EQ. 1.

It should be noted that the transfer functions provided above are not the only representations of a band-pass filter and a low-pass filter. Multiple transfer functions for filter types can be obtained via different combinations ofcoefficient values in the biquadratic ofEQ. 1, or via use of base equations other than the biquadratic of EQ. 1.

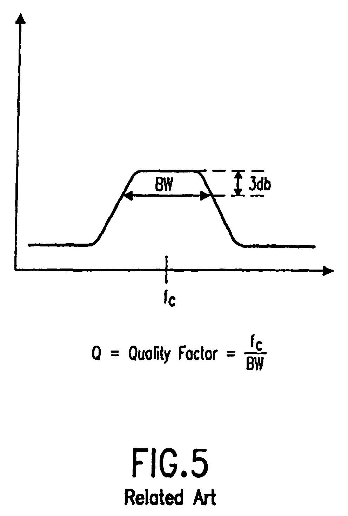

There are a number of measures for characterizing the performance of a filter. For example, and without limitation, the performance of a second order band-pass filter is often measured by its quality factor, or Q. FIG. 5 illustrates the manner in which Q is calculated for a second order filter. Q is equal to the center frequency $f_c$ of the filter divided by the bandwidth BW of the filter. The bandwidth BW is measured at a point 3 DB below the maximum amplitude of the filter. Therefore, if a filter operates at a center frequency $f_c$ of 1 MHz, and has a bandwidth BW of 50 KHz, the Q of the filter is

$$\frac{1,000,000}{50,000} = 20$$

*1.2 Other Terms*

Various terms used in this application are generally described in this section. The description in this section is provided for illustrative and convenience purposes only, and is not limiting. The meaning of these terms will be apparent to persons skilled in the relevant art(s) based on the entirety of the teachings provided herein. These terms may be discussed throughout the specification with additional detail.

Amplitude Modulation (AM): A modulation technique wherein the amplitude of the carrier signal is shifted (i. e., varied) as a function of the information signal. A subset of AM is referred to as "amplitude shift keying" which is used primarily for digital communications where the amplitude of the carrier signal shifts between discrete states rather than varying continuously as it does for analog information.

Analog signal: A signal that is constant or continuously variable as contrasted to changes between discrete states.

Baseband: A frequency band occupied by any generic information signal desired for transmission and/or reception.

Baseband signal: Any generic information signal desired for transmission and/or reception.

Carrier frequency: The frequency of a carrier signal. Typically, it is the center frequency of a transmission signal that is generally modulated.

Carrier signal: An EM wave having at least one characteristic that may be varied by modulation, that is capable of carrying information via modulation.

Control a switch: Causing a switch to open and close. The switch may be, without limitation, mechanical, electrical, electronic, optical, etc., or any combination thereof.

Demodulation: The process of removing or extracting information from a carrier signal.

Digital signal: A signal in which the information contained therein is discrete as contrasted to continuous.

Direct down conversion: A down conversion technique wherein a transmitted signal is directly down converted from the transmitted frequency (i.e., a carrier frequency) to the baseband signal without having an intermediate frequency.

Down conversion: A process for performing frequency translation in which the final frequency is lower than the initial frequency.

Electromagnetic spectrum: A spectrum comprising waves characterized by variations in electric and magnetic fields. Such waves may be propagated in any communication medium, both natural and manmade, including but not limited to air, space, wire, cable, liquid, waveguide, microstrip, stripline, optical fiber, etc. The EM spectrum includes all frequencies greater than zero hertz.

EM signal: A signal in the EM spectrum. Also generally called an EM wave. Unless stated otherwise, all signals discussed herein are EM signals, even when not explicitly designated as such.

Frequency Modulation (FM): A modulation technique wherein the frequency of the carrier signal is shifted (i. e., varied) as a function of the information signal. A subset of FM is referred to as "frequency shift keying" which is used primarily for digital communications where the frequency of the carrier signal shifts between discrete states rather than varying continuously as it does for analog information.

Harmonic: A harmonic is a sinusoidal component of a periodic wave. It has a frequency that is an integer multiple of the fundamental frequency of the periodic wave. In other words, if the periodic waveform has a fundamental frequency of "f" (also called the first harmonic), then it has harmonics at frequencies of "n•f," where "n" is 2, 3, 4, etc. The harmonic corresponding to n=2 is referred to as the second harmonic, the harmonic corresponding to n=3 is referred to as the third harmonic, and so on.

Information signal: The signal that contains the information that is to be transmitted. As used herein, it refers to the original baseband signal at the source. When it is intended that the information signal modulate a carrier signal, it is also referred to as the "modulating baseband signal." It may be voice or data, analog or digital, or any other signal or combination thereof.

Intermediate frequency (IF) signal: A signal that is at a frequency between the frequency of the baseband signal and the frequency of the transmitted signal.

Modulation: The process of varying one or more physical characteristics of a signal to represent the information to be transmitted. Three commonly used modulation techniques are frequency modulation, phase modulation, and amplitude modulation. There are also variations, subsets, and combinations of these three techniques.

Phase Modulation (PM): A modulation technique wherein the phase of the carrier signal is shifted (i.e., varied) as a function of the information signal. A subset of PM is referred to as "phase shift keying" which is used primarily for digital communications where the phase of the carrier signal shifts between discrete states rather than varying continuously as it does for analog information.

Subharmonic: A subharmonic of a periodic waveform is a sinusoidal wave having a frequency that is an integer submultiple of the fundamental frequency of that periodic waveform. That is, a subharmonic frequency is the quotient obtained by dividing the fundamental frequency by an integer. For example, if the periodic waveform has a frequency of "f" (also called the fundamental), then its subharmonics have frequencies of "f/n," where n is 2, 3, 4, etc. The subharmonic corresponding to n=2 is referred to as the second subharmonic, the subharmonic corresponding to n=3 is referred to as the third subharmonic, and so on. A subharmonic itself has harmonics, and the $i^{th}$ harmonic of the $i^{th}$ subharmonic will be at the fundamental frequency of the original periodic waveform. For example, the third subharmonic (which has a frequency of "f/3"), has harmonics at integer multiples ofitself (i.e., a second harmonic at "2•f/3," a third harmonic at "3•f/3," and so on). The third harmonic of the third subharmonic of the original signal (i.e., "3•f/3") is at the frequency of the original signal.

Up conversion: A process for performing frequency translation in which the final frequency is higher than the initial frequency.

## 2 Overview of the Invention

The present invention is directed to methods and apparatuses for frequency selectivity and frequency translation. The invention is also directed to applications for such methods and apparatuses.

The invention achieves high frequency selectivity at any input frequency (the input frequencyrefers to the frequency of the input spectrum being filtered and translated), including but not limited to RF (radio frequency) and greater frequencies. It should be understood that the invention is not limited to this example of RF and greater frequencies. The invention is intended, adapted, and capable of working with lower than radio frequencies.

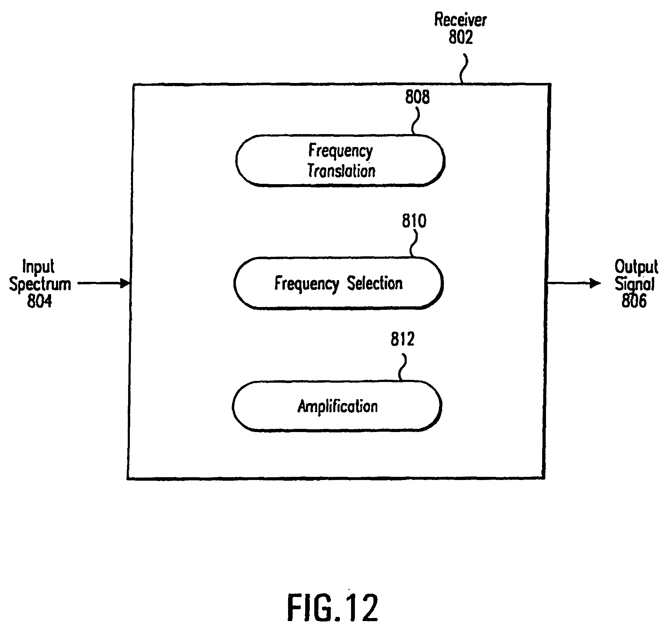

Understanding of the invention may be facilitated by considering the operation of a receiver. Generally, a receiver 802 performs three primary functions: frequency translation 808, frequency selection 810, and amplification 812. See FIG. 12. In the conventional receiver 112 of FIG. 1, for example, the mixer 106 performs the frequency translation operation; the band select filter 102 and the channel select filter 108 collectively perform the frequency selection operation; and the LNA 104 and the amplifier 110 collectively perform the amplification operation.

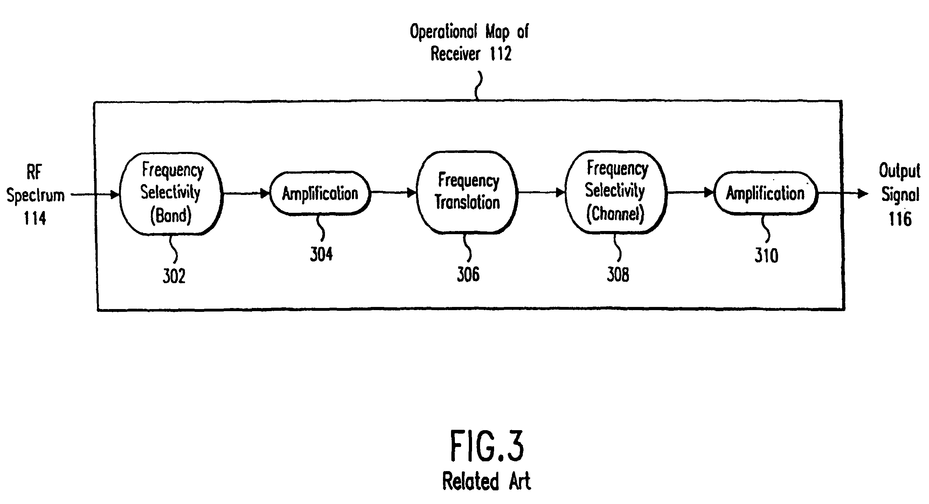

In the conventional receiver 112, note that the band select filter 102 is positioned prior to the mixer 106, and the channel select filter 108 is positioned after the mixer 106. Thus, in the conventional receiver 112, only a portion of the frequency selection operation 810 is performed prior to the frequency translation operation 808. Specifically, only band select filtering (i.e., wideband or image reject filtering) is performed prior to the frequency translation operation 810; channel select filtering (i.e., narrowband filtering) is performed after the frequency translation operation 808. This operational map of the conventional receiver 112 is illustrated in FIG. 3.

As described above, in the conventional receiver 112, signal components at frequencies near the desired frequency are not filtered out by the band select filter 102. This is because the bandwidth of the band select filter 102 is wide (specifically, the bandwidth of the band select filter 102 is greater than the bandwidth of the channel select filter 108). These signal components can exceed the dynamic range of the system and cause the LNA 104 and/or the mixer 106 to generate spurious signal components that may interfere with other signal components at desired frequencies (see FIGS. 4A-4G). Thus, the conventional receiver 112 suffers from potentially degraded performance because only band select or wideband filtering is performed prior to the frequency translation operation 808 or other operations (such as the amplification operation 812) that involve components having a limited linear range (such as the mixer 106 and the LNA 104).

Embodiments of the present invention are directed to methods and apparatuses for unified down-converting and filtering (UDF). The embodiments preferably perform the frequency selectivity operation and the frequency translation operation. According to embodiments of the present invention, the frequency selectivity operation performed by the present invention comprises filtering at any frequency, such as RF or greater.

In some embodiments, the filter bandwidth is consistent with narrow band filtering. Thus, the present invention can be accurately characterized as performing a narrow band filtering operation. In other embodiments, depending on the application, the filter bandwidth is consistent with wide band filtering. Thus, embodiments of the present invention can be accurately characterized as performing a wide band filtering operation. However, it should be understood that such characterizations of the invention are provided herein for illustrative purposes only. The filtering capabilities of the invention are not limited to those filter bandwidths typically associated with "narrow band filtering" and "wide band filtering." Instead, the unified down-converting and filtering (UDF) functionality of embodiments of the present invention can be designed with substantially any filter bandwidth. The present invention is intended, adapted, and capable of filtering using substantially any filter bandwidth.

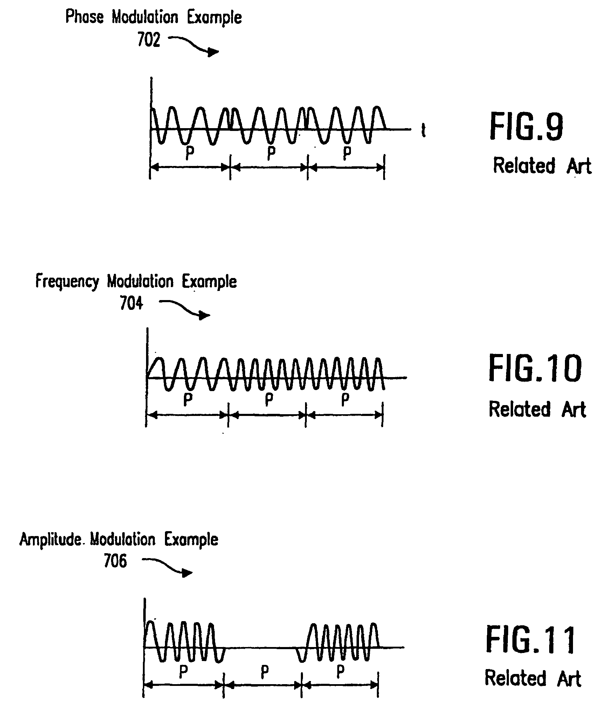

Signals referred to herein may be modulated or unmodulated. Modulated signals may have been generated using any modulation scheme, such as AM, FM, PM, etc., or combinations thereof. See, for example and without limitation, various modulation examples shown in FIGS. 9-11.

The invention is described in detail below.

### 3 Unified Down converting and Filtering

The following sections describe operational methods for unified down-converting and filtering (UDF) according to embodiments of the invention. Structural exemplary embodiments for achieving these methods are also described. It should be understood that the invention is not limited to the particular embodiments described below. Equivalents, extensions, variations, deviations, etc., of the following will be apparent to persons skilled in the relevant art(s) based on the teachings contained herein.

### 3.1 Conceptual Description

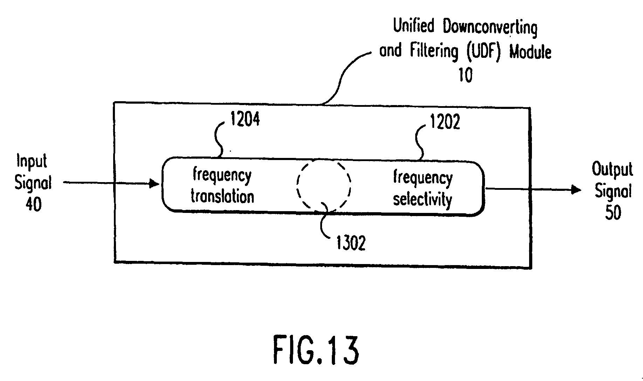

Referring to FIG. 13, as described above, the UDF module 10 preferably performs frequency translation 1204 prior to frequency selectivity 1202. The overlapping area 1302 depicted in FIG. 13 indicates that the operations relating to frequency translation 1204 also contribute to the performance of frequency selectivity 1202, and/or vice versa.

### 3.2 High Level Description

This section (including its subsections) provides a high-level description of unified down-converting and filtering (UDF). In particular, an operational process of down-converting and filtering is described at a high-level. Also, a structural implementation for achieving this process is described at a high-level. This structural implementation is described herein for illustrative purposes, and is not limiting. In particular, the process described in this section can be achieved using any number of structural implementations, one of which is described in this section. The details of such structural implementations will be apparent to persons skilled in the relevant art(s) based on the teachings contained herein.

### 3.2.1 Operational Description

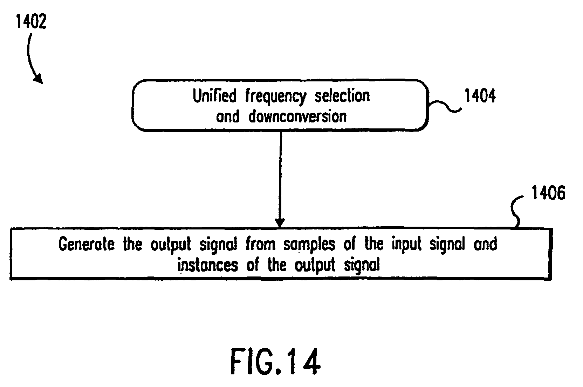

According to embodiments of the present invention, the UDF module generates an output signal from an input signal using samples/instances of the input signal and samples/instances of the output signal. This operation is represented by step 1406 in a flowchart 1402 (FIG. 14). By operating in this manner, the UDF module preferably performs input filtering and frequency down-conversion in a unified manner.

For illustrative purposes, the operation of the invention is often represented by flowcharts, such as flowchart 1402 in FIG. 14. It should be understood, however, that the use of flowcharts is for illustrative purposes only, and is not limiting. For example, the invention is not limited to the operational embodiment(s) represented by the flowcharts. Instead, alternative operational embodiments will be apparent to persons skilled in the relevant art(s) based on the discussion contained herein. Also, the use of flowcharts should not be interpreted as limiting the invention to discrete or digital operation. In practice, as will be appreciated by persons skilled in the relevant art(s) based on the herein discussion, the invention can be achieved via discrete or continuous operation, or a combination thereof. Further, the flow of control represented by the flowcharts is provided for illustrative purposes only. As will be appreciated by persons skilled in the relevant art(s), other operational control flows are within the scope of the present invention. Also, the ordering of steps may differ in various embodiments.

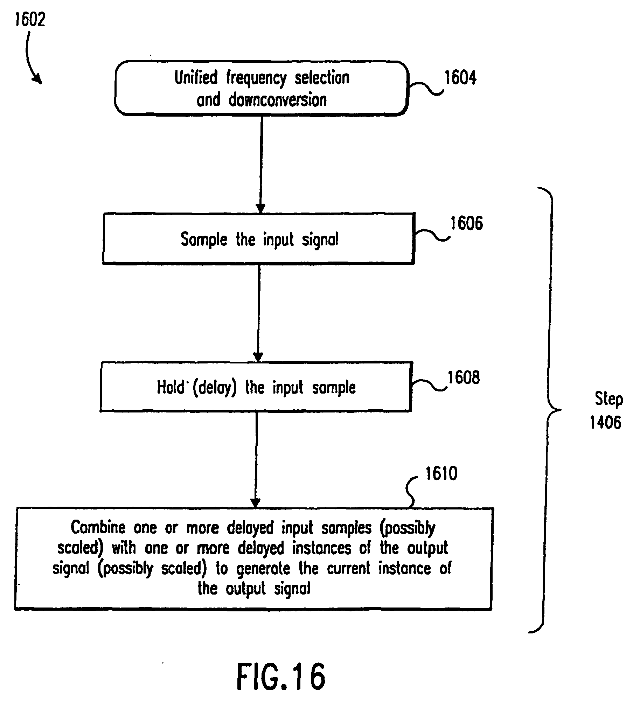

The operation of embodiments of the invention shall now be described in greater detail with reference to a flowchart 1602 shown in FIG. 16. The steps of flowchart 1602 generally represent step 1406 in FIG. 14.

In step 1606, the input signal is sampled. This input sample includes information (such as amplitude, phase, etc.) representative of the input signal existing at the time the sample was taken.

As described further below, the effect of repetitively performing step 1606 is to translate the frequency (that is, down-convert) ofthe input signal to a desired lower frequency, such as an intermediate frequency (IF) or baseband.

In step 1608, the input sample is held (that is, delayed).

In step 1610, one or more delayed input samples (some of which may have been scaled), such as the delayed input sample of step 1608, are combined with one or more delayed instances of the output signal (some of which may have been scaled) to generate a current instance of the output signal.

Thus, according to a preferred embodiment of the invention, the output signal is generated from prior samples/instances of the input signal and/or the output signal. (It is noted that, in some embodiments of the invention, current samples/instances of the input signal and/or the output signal may be used to generate current instances of the output signal.)

As noted above, this operation of embodiments of the present invention supports multiple filtering types, including but not limited to bandpass, low pass, high pass, notch, all pass, etc., and combinations thereof.

### 3.22 Structural Description

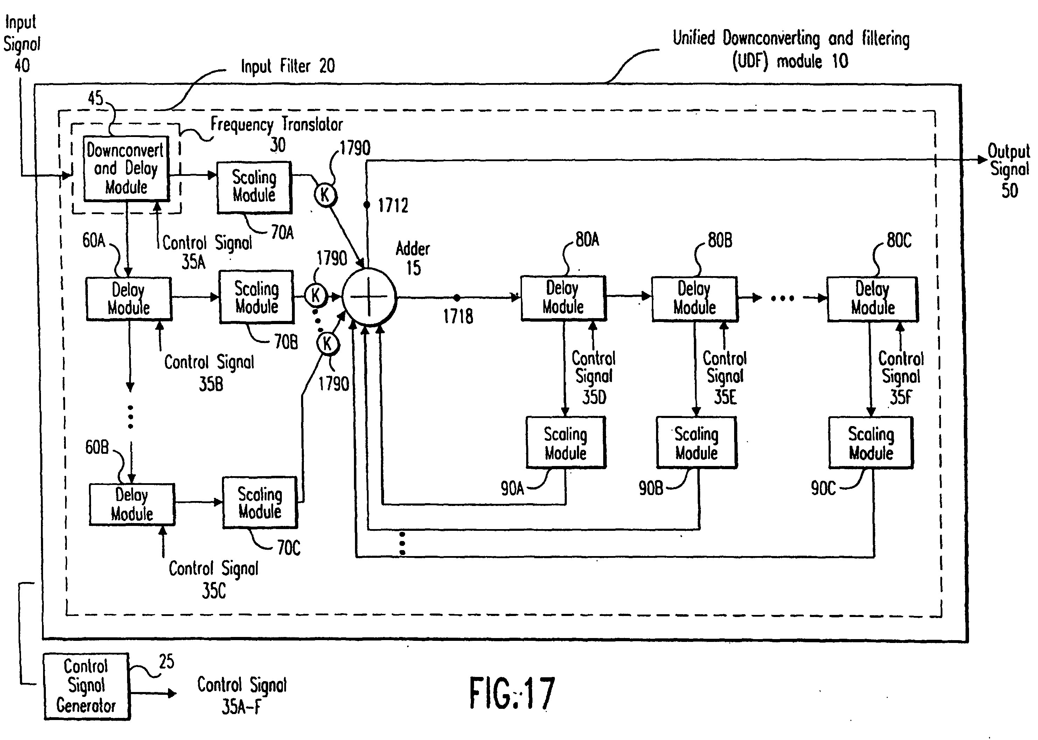

FIG. 17 illustrates a UDF module 10 according to an embodiment of the invention. The UDF module 10 includes a portion that generally corresponds to the frequency translator 30 (FIG. 11). The UDF module 10 includes another portion that generally corresponds to the input filter 20. Note that the portion of the UDF module 10 that corresponds to the frequency translator 30 also forms a part of the input filter 20.

Note that the UDF module 10 includes scaling elements 1790. These elements are optional, and are used for amplification. The scaling elements 1790 are discussed in a section below. In the present discussion, the scaling elements 1790 are not considered.

The operation of the UDF module 10 shall now be described with reference to flowchart 1602 in FIG. 16.

In step 1606, a down-convert and delay module 45 samples the input signal 40. This sampling operation is performed in accordance with a control signal 35A. The down-convert and delay module 45, when repetitively performing step 1606, results in translating the frequency of the input signal 40 to a desired lower frequency, such as IF or baseband. Accordingly, the down-convert and delay module 45 down-converts the input signal 40 to a desired lower frequency.

In step 1608, the down-convert and delay module 45 holds (delays) the input sample.

In step 1610, components of the UDF module 10 operate to combine one or more delayed input samples (some of which may have been scaled) with one or more delayed instances of the output signal 50 (some of which may have been scaled) to generate a current instance of the output signal 50. More particularly, delay modules 60A, 60B, etc., operate to delay samples of the input signal 40 taken by the down-convert and delay module 45 (although two delay modules 60A, 60B are shown in the example of FIG. 17, the invention is not limited to this embodiment). Scaling modules 70A, 70B, 70C, etc., operate to scale these delayed input samples from the down-convert and delay module 45 and the delay modules 60A, 60B, etc.

Delay modules 80A, 80B, 80C, etc., operate to delay instances of the output signal 50 (note that the output signal 50 is present at both nodes 1712 and 1718). (Although three delay modules 80A-80C are shown in the example of FIG. 17, the invention is not limited to this embodiment.) Scaling modules 90A, 90B, 90C, etc., operate to scale these delayed instances of the output signal 50 from the delay modules 80A, 80B, 80C, etc.

An adder 15 operates to combine the delayed and scaled input samples and the delayed and scaled instances of the output signal 50 to generate instances of the output signal 50.

As noted above, different embodiments of the UDF module utilize different numbers and/or configurations of delay modules 60, 80, and different numbers and/or configurations of scaling modules 70 and 90. Also, the operation of the delay modules 60, 80 and the scaling modules 70, 90 will vary among embodiments of the UDF module. For example, the amount of delay introduced by each delay module 60, 80 will vary among embodiments of the UDF module. Also, the scale factors of scaling modules 70, 90 will vary among embodiments of the UDF module (generally, the scale factor of each scaling module 70, 90 may be any real number). For example, and without limitation, the scale factor of one or more scaling modules in some embodiments may be zero. Accordingly, it should be understood that the embodiments of the UDF module shown and discussed herein are provided for illustrative purposes only. The present invention is not limited to the embodiments of the UDF module shown and discussed herein. Alternate embodiments of the UDF module, differing slightly or greatly from those shown and discussed herein, will be apparent to persons skilled in the relevant art(s) based on the discussion contained herein.

### 3.3 Example Embodiments

Various embodiments related to the method(s) and structure(s) described above are presented in this section (and its subsections). These embodiments are described herein for purposes of illustration, and not limitation. The invention is not limited to these embodiments. Alternate embodiments (including equivalents, extensions, variations, deviations, etc., of the embodiments described herein) will be apparent to persons skilled in the relevant art(s) based on the teachings contained herein. The invention is intended and adapted to include such alternate embodiments.

### 3.3.1 First Embodiment: Band Pass Filtering and Frequency Translation

An example embodiment of the invention, wherein band-pass filtering and frequency translation are performed, is described in the following sections.

### 3.3.1.1 Operational Description

A representation of a transfer function for a band-pass filter is shown in EQ. 3, which was discussed above and presented below for convenience. As indicated above, EQ. 3 is described herein for illustrative purposes only, and

is not limiting.

$$VO = \alpha_1 z^{-1}VI - \beta_1 z^{-1}VO - \beta_0 z^{-2}VO \qquad \text{EQ. 3}$$

As evidenced by EQ. 3, the output signal VO is formed from a summation of scaled delayed values of the input signal VI and scaled delayed values of the output signal VO. More particularly, at any given time t, the value of the output signal VO is equal to a scaled value of the input signal VI from time t-1, minus a scaled value of the output signal VO from time t-1, minus a scaled value of the output signal VO from a time t-2.

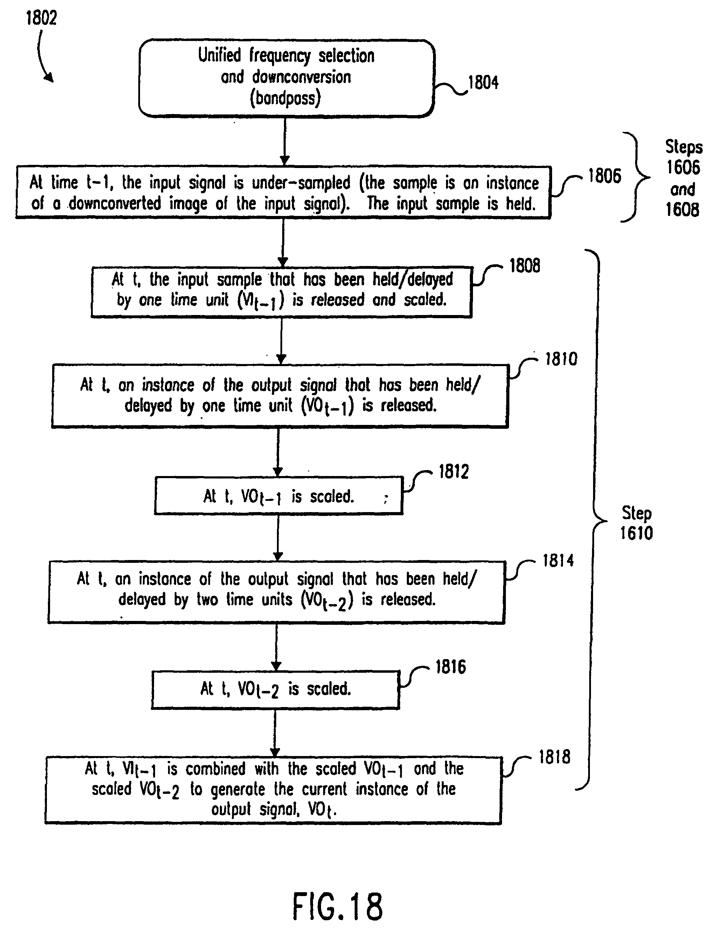

It is noted that EQ. 3 is a transfer function for band-pass filtering the input signal VI. EQ. 3 is not in any way related to translating the frequency of the input signal VI. That is, EQ. 3 is not in any way related to down-converting the input signal VI. However, the embodiments preferably operate such that frequency translation is performed at substantially the same time that band-pass filtering is performed in accordance with EQ. 3. Such operation of the embodiments shall now be described with reference to a flowchart 1802 presented in FIG. 18.

In step 1806, at a time t-1, the input signal VI is under-sampled. As further described below, this under-sampling of the input signal results in translating the frequency of the input signal VI to a desired lower frequency (such as IF or baseband), such that the input sample is an instance of a down-converted image of the input signal VI. As described below, this input sample is used in the frequency selectivity operation. This further indicates the integrated operation of embodiments of the present invention.

In step 1808, at a time t, the input sample that was held from step 1806 is released and scaled. The scaling value can be any real number, including but not limited to zero.

In steps 1810 and 1812, at time t, an instance of the output signal VO that was previously captured at time t-1, and that was held until this time, is released and scaled. The scaling value can be any real number, including but not limited to zero.

In steps 1814 and 1816, at time t, an instance of the output signal that was previously captured at time t-2, and that was held until this time, is released and scaled. The scaling value can be any real number, including but not limited to zero.

In step 1818, at time t, a current instance of the output signal, $VO_t$, is generated by combining the scaled and delayed sample of the input signal $VI_{t-1}$ with the scaled and delayed instances of the output signal $VO_{t-1}$ and $VO_{t-2}$.

### 3.3.1.2 Structural Description

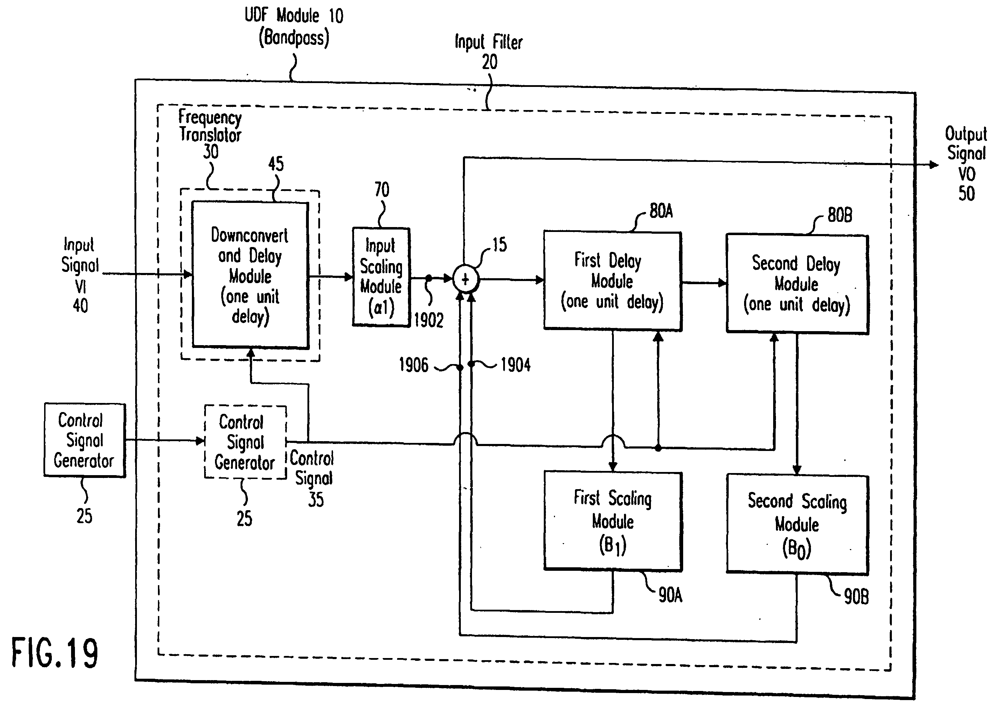

FIG. 19 is a block diagram of a UDF module 10 according to an embodiment of the invention. The UDF module 10 includes a portion that corresponds to the frequency translator 30 (FIG. 11), and a portion that corresponds to the input filter 20. Note that the portion corresponding to the frequency translator 30, that is, the down-convert and delay module 45, also forms a part of the input filter 20.

The UDF module 10 of FIG. 19 is a structural embodiment for performing the operational steps of flowchart 1802 (FIG. 18). However, it should be understood that the scope of the present invention includes other structural embodiments for performing the steps of flowchart 1802. The specifics of these other structural embodiments will be apparent to persons skilled in the relevant art(s) based on the discussion contained herein.

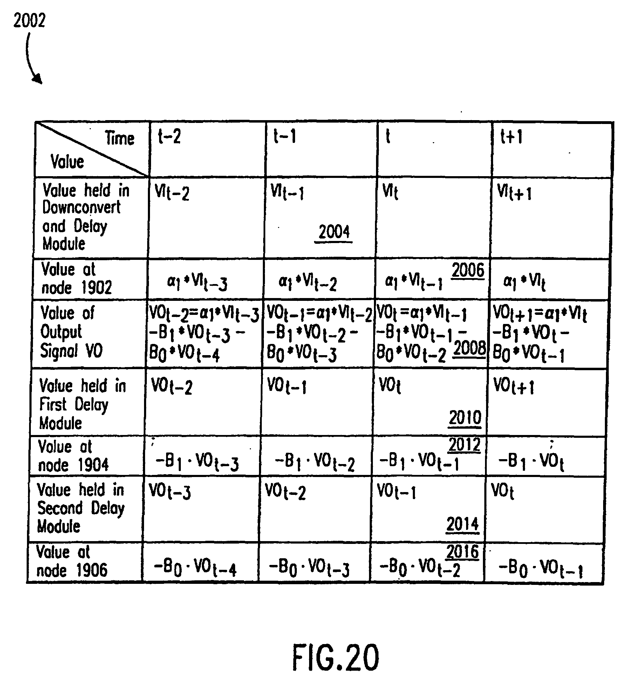

The operation of the UDF module 10 is now described in detail with reference to the flowchart 1802 of FIG. 18. Reference also will be made to a table 2002 in FIG. 20 that indicates example values at nodes in the UDF module 10 at a number of consecutive time increments.

In step 1806, at time t-1, the down-convert and delay module 45 under-samples the input signal VI. This input sample is denoted as $VI_{t-1}$. As noted above, in performing step 1806, the down-convert and delay module 45 operates to translate the frequency of the input signal VI to a desired lower frequency, such as IF or baseband. Accordingly, the input sample $VI_{t-1}$ represents an instance of a down-converted image of the input signal VI. This operation of the down-convert and delay module 45 is further described below.

Also in step 1806, the down-convert and delay module 45 holds the input sample $VI_{t-1}$ for preferably one time unit. See cell 2004 in Table 2002. As apparent from EQ. 3, above, the band-pass filtering transfer function requires that the input sample be held for one time unit. Accordingly, when performing this portion of step 1806, the down-convert and delay module 45 is performing a portion of the frequency selectivity operation 1202. Accordingly, as should be apparent by this description, the down-convert and delay module 45 contributes to both the frequency translation operation 1204 and the frequency selectivity operation 1202.

In step 1808, at time t, the input sample that was held for one time unit (that is, $VI_{t-1}$) is released by the down-convert and delay module 45, and scaled by the input scaling module 70. Accordingly, the signal present at node 1902 is (see cell 2006 in Table 2002): $\alpha_1 \cdot VI_{t-1}$.

Previously, at time t-1, the first delay module 80A captured an instance of the output signal VO. This instance of the output signal VO is denoted as $VO_{t-1}$. In step 1810, at time t, the first delay module 80A releases this instance of the output signal $VO_{t-1}$. In step 1812, this instance of the output signal $VO_{t-1}$ is scaled by the first scaling module 90A. The value present at node 1904 after operation of the first scaling module 90A is (see cell 2012 in Table 2002): $-\beta_1 \cdot VO_{t-1}$.

Previously, at time t-1, the second delay module 80B captured an instance of the output signal VO stored in the first delay module 80A (note that the first delay module 80A sampled the output signal VO to obtain this instance at time t-2). This instance of the output signal VO is denoted as $VO_{t-2}$. At time t, this instance of the output signal $VO_{t-2}$ is released by the second delay module 80B.

In step 1816, the second scaling module scales this instance of the output signal $VO_{t-2}$. After operation of the second scaling module 90B, the following value is present at node 1906 (see cell 2016 in Table 2002): $-\beta_0 \cdot VO_{t-2}$.

In step 1818, at time t, a summer 15 adds the values present at nodes 1902, 1904, and 1906. The sum represents the current instance of the output signal VO. This output signal instance is denoted as $VO_t$, and is equal to the following (see field 2008 in Table 2002): $\alpha_1 \cdot VI_{t-1} - \beta_1 \cdot VO_{t-1} - \beta_0 \cdot VO_{t-2}$.

### 3.3.2 Second Embodiment: Low Pass Filtering and Frequency Translation

An example embodiment of the invention, wherein low-pass filtering and frequency translation are performed, is described in the following sections.

### 3.3.2.1 Operational Description

EQ. 6 is a representation of a transfer function for a low-pass filter. EQ. 6, first introduced above, is presented below for convenience. As indicated above, EQ. 6 is described herein for illustrative purposes only, and is not limiting.

$$VO = \alpha_0 \, z^{-2}VI - \beta_1 \, z^{-1}VO - \beta_0 \, z^{-2}VO \qquad\qquad \text{EQ. 6}$$

As evidenced by EQ. 6, a low-pass filtering operation can be achieved by adding a scaled instance of the input signal VI that has been delayed by two time units to two scaled instances of the output signal VO that had been delayed by one and two time units, respectively.

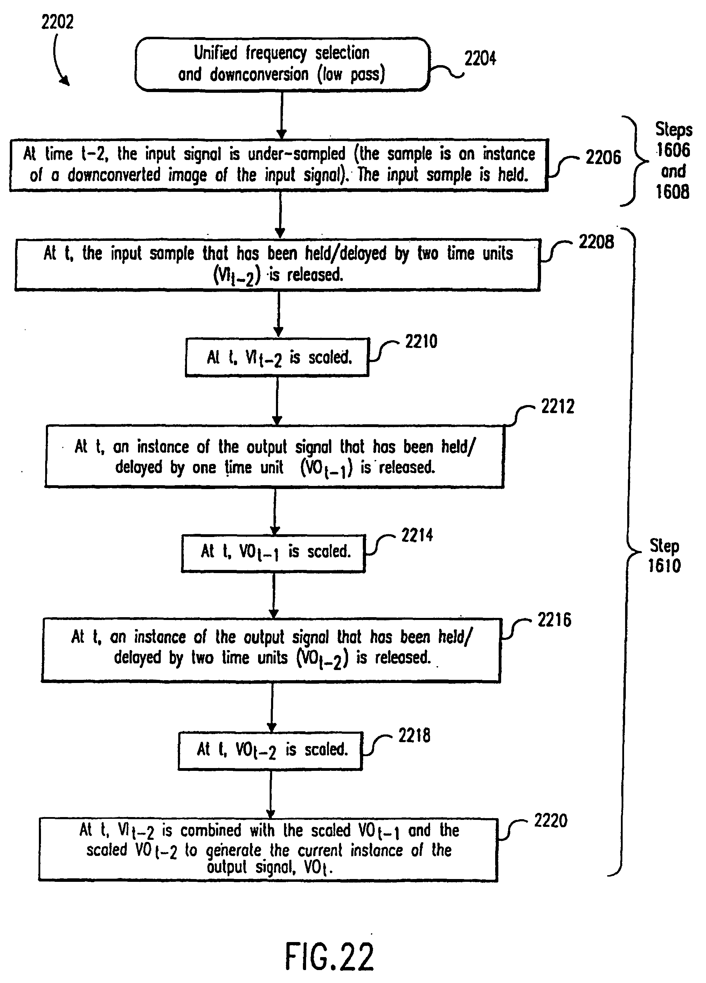

Note that the low-pass transfer function of EQ. 6 is not in any way related to the frequency translation operation 1204. However, the invention preferably operates such that frequency translation is performed at substantially the same time that low-pass filtering is performed in accordance with EQ. 6. Such operation shall now be described with reference to a flowchart 2202 presented in FIG. 22.

In step 2206, at a time t- 2, the input signal VI is under-sampled. The input sample is denoted as $VI_{t-2}$. As further described below, this under-sampling of the input signal results in translating the frequency of the input signal VI to a desired lower frequency (such as IF or baseband), such that the input sample is an instance of a down-converted image of the input signal VI. The input sample is preferably held for two time periods.

Also in step 2206, the input sample $VI_{t-2}$ is held for two time units. As evident from EQ. 6, in order to achieve a low-pass filtering operation, it is necessary to hold an instance of the input signal VI by two time units. Accordingly, this aspect of step 2206 constitutes a portion of the frequency selectivity operation 1202. Thus, in performing step 2206, the present invention is performing aspects of the frequency selectivity operation 1202. Thus, the down-convert and delay module 45 contributes to both the frequency translation operation and the frequency selectivity operation.

In step 2208, at time t, the input sample $VI_{t-2}$ that had been held by two time units is released. This input sample $VI_{t-2}$ is scaled in step 2210.

In steps 2212 and 2214, at time t, an instance of the output signal $VO_{t-1}$ that has been held by one time unit is released and scaled.

In steps 2216 and 2218, at time t, an instance of the output signal $VO_{t-2}$ that has been held by two time units is released and scaled.

In step 2220, at time t, the current instance of the output signal, $VO_t$, is generated by combining the scaled input sample $VI_{t-2}$ with the scaled instances of the output signal $VO_{t-1}$ and $VO_{t-2}$.

### 3.3.2.2 Structural Description

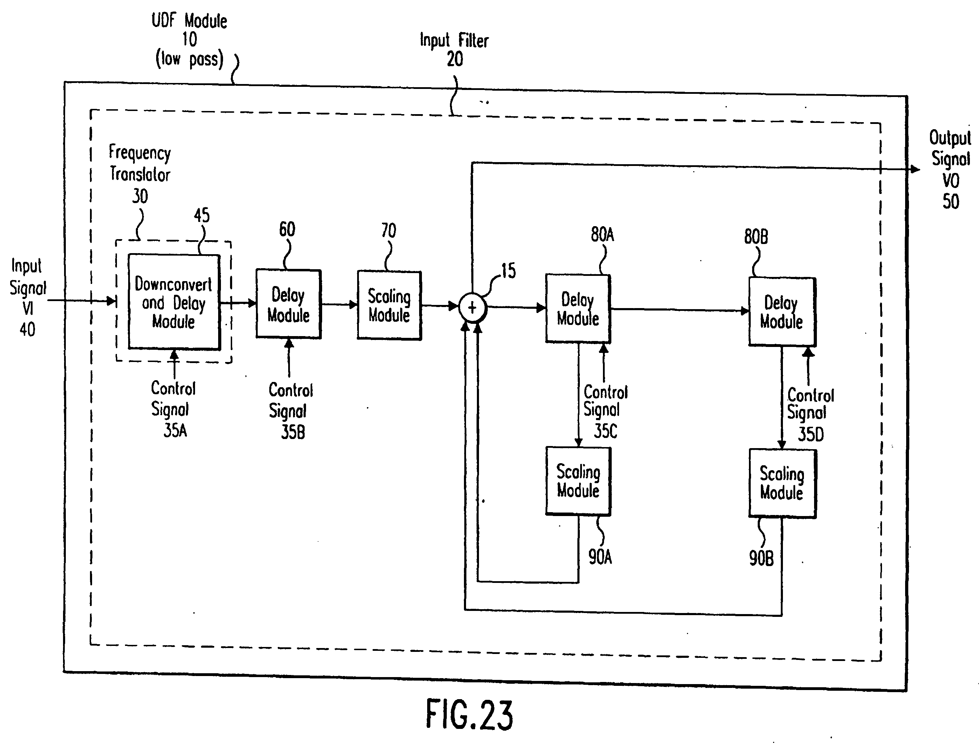

FIG. 23 is a block diagram of a UDF module 10 according to an embodiment of the invention. The UDF module 10 includes a portion that corresponds to the frequency translator 30, and a portion that corresponds to the input filter 20. Note that the portion of the UDF module 10 that corresponds to the frequency translator 30 also forms a part of the input filter 20.

The UDF module 10 is a structural embodiment for performing the operational steps of flowchart 2202. However, it should be understood that the scope of the present invention includes other structural embodiments for performing the steps of flowchart 2202. The specifics of these other structural embodiments will be apparent to persons skilled in the relevant art(s) based on the discussion contained herein.

The operation of the UDF module 10 shall now be described in detail with reference to the flowchart 2202 of FIG. 22.

At a time t- 2, the down-convert and delay module 45 under-samples the input signal VI. This input sample is denoted as $VI_{t-2}$. The down-convert and delay module 45 under-samples the input signal VI to obtain input sample $VI_{t-2}$ in accordance with a control signal 35A. As further described below, the down-convert and delay module 45 performs such sampling in a manner that operates to translate the frequency of the input signal VI to a desired lower frequency, such as IF or baseband. Accordingly, the input sample $VI_{t-2}$ represents an instance of a down-converted image of the input signal VI.

Also in step 2206, the down-convert and delay module 45 holds the input sample $VI_{t-2}$ for one time unit. At time t-1, the input sample $VI_{t-2}$ is captured by a delay module 60, and held for an additional time unit. As evident from the low-pass filtering transfer function of EQ. 6, in order to perform the low-pass filtering operation, it is necessary to hold or delay the input signal VI by two time units. As just described, this delaying operation is performed collectively by the down-convert and delay module 45 and the delay module 60. Therefore, in performing this aspect of step 2206, the down-convert and delay module 45 contributes to the performance of the frequency selectivity operation 1202, as well as the frequency translation operation 1204.

In step 2208, at time t, the input sample $VI_{t-2}$ that has been held/delayed by two time units is released by the delay module 60.

In step 2210, at time t, the input sample $VI_{t-2}$ is scaled by the scaling module 70.

Previously, at time t-1, the delay module 80A captured an instance of the output signal VO. This instance of the output signal VO is denoted as $VO_{t-1}$. In step 2212, at time t, this instance of the output signal $VO_{t-1}$ is released by the delay module 80A.

In step 2214, at time t, this instance of the output signal $VO_{t-1}$ is scaled by the scaling module 90A.

Previously, at time t-1, the delay module 80B captured an instance of the output signal VO stored in the delay module 80A. This instance of the output signal VO is denoted as $VO_{t-2}$. At time t, in step 2216, this instance of the output signal $VO_{t-2}$ is released by the delay module 80B.

In step 2218, at time t, this instance of the output signal $VO_{t-2}$ is scaled by the scaling module 90B.

In step 2220, at time t, the current instance of the output signal, $VO_t$, is generated by combining the scaled input sample $VI_{t-2}$ with the scaled instances of the output signal, $VO_{t-1}$ and $VO_{t-2}$.

The filtering embodiments described above can be generally characterized as infinite impulse response (IIR) filters. Generally speaking, in IIR filters, the output is a function of the input and the output.

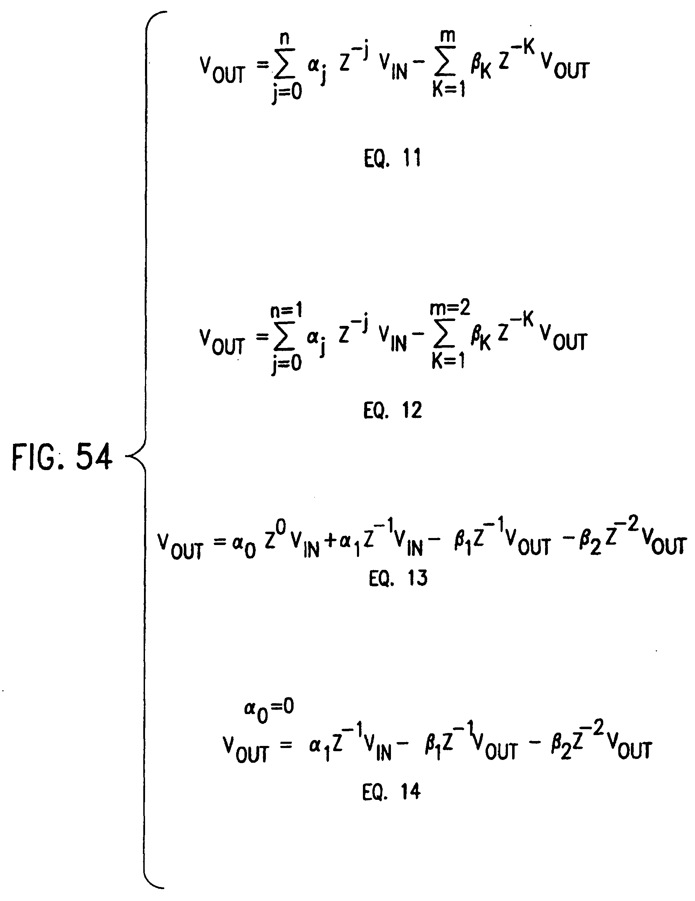

Consider first EQ. 1 shown in FIG. 54. EQ. 11 is a general filter transfer function. A variety of filters, including linear phase filters, can be represented using instances and/or variations of EQ. 11.

For example, the example bandpass filter transfer function of EQ. 3 can be derived from EQ. 11. This is shown in EQS. 12-14 of FIG. 54, where EQ. 14 is equivalent to EQ. 3.

### 3.3.3 Fifth Embodiment: Running Average Filter

In the embodiments discussed above, the control signals were the same frequency, although their phases sometimes differed. In these embodiments, the requirement that all the control signals be at the same frequency placed demands on circuit design and implementation (although such demands could be satisfied).

The invention is directed to embodiments where the control signals do not have to be at the same frequency. By lifting this requirement, generally, circuit design and implementation is simplified, and hardware requirements are reduced.

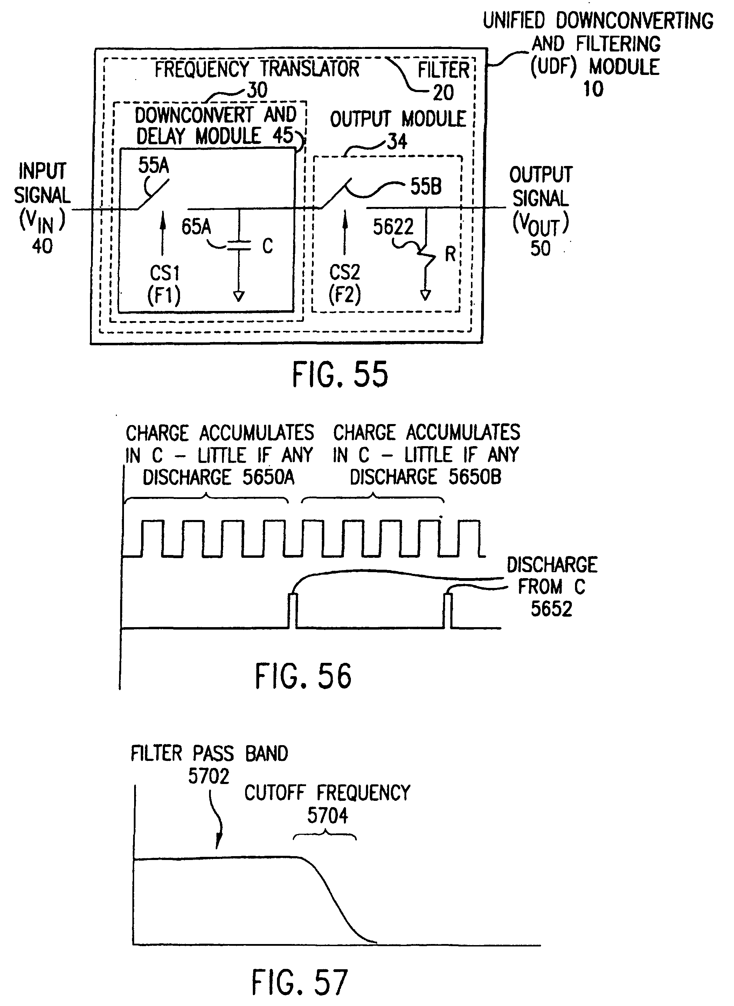

FIG. 55 illustrates an example unified down-converting and filtering (UDF) module 10 where the control signals CS1 and CS2 are not at the same frequency.

The UDF module 10 includes a frequency translator 30, which is preferably implemented using a down-convert and delay module 45. The down-convert and delay module 45 samples the input signal 40. As further described below, the down-convert and delay module 45 performs such sampling in a manner that operates to translate the frequency of the input signal 40 to a lower frequency, such as IF or baseband (this sampling operation is performed in accordance with the control signal CS1). The input sample represents an instance of a down-converted image of the input signal 40. Accordingly, the down-convert and delay module 45 down-converts the input signal 40 to a desired lower frequency. In some embodiments, the operation of the down-convert and delay module 45 is sometimes referred to as "integrate and transfer," because the invention provides for a number of advantages, such as enhanced energy transfer during the frequency translation operation. Additional details regarding the manner in which the embodiments perform frequency down-conversion are provided below, and are further provided in WO 00/24117.

The down-convert and delay module 45 also holds (delays) the input sample for a period of time. In the example of FIG. 55, the down-convert and delay module 45 delays the input sample for one time unit (such as one sample period), although other embodiments achieve different amounts of delay.

As evident from the filtering transfer functions discussed herein, in order to perform filtering, it is necessary to hold or delay the input signal 40 by various time units. As just described, the down-convert and delay module 45 participates in this delaying operation. Therefore, the down-convert and delay module 45 contributes to both the performance of the frequency selectivity operation 1202, as well as the frequency translation operation 1204. In fact, as apparent from the teachings contained herein, when performing the frequency translation operation 1204, the down-convert and delay module 45 is also performing at least a portion of the frequency selectivity operation 1202, and vice versa. Thus, according to the invention, performance of the frequency selectivity operation 1202 is integrated with performance of the frequency translation operation 1204. This is further evident in FIG. 55, which shows the frequency translator 45 (comprising the down-convert and delay module 45) being a part of the filter 20.

In the example of FIG. 55, the down-convert and delay module 45 is implemented using a switch 55A and a capacitor 65A. The invention is directed to other embodiments of the down-convert and delay module 45. Such other embodiments are described herein, and are further described in WO 00/24117.

As noted above, in the example UDF module 10, the control signals CS1 and CS2 are not at the same frequency. Preferably, frequency f1 of control signal CS1 is greater than frequency f2 of control signal CS2. For example, and without limitation, in the example of FIG. 56 the ratio of f1 to f2 is four, such that there are four pulses in CS 1 for every one pulse in CS2. It is noted that this example is provided for illustrative purposes only, and is not limiting. The invention encompasses other ratios of f1 to f2, as will be apparent to persons skilled in the relevant art(s) based on the teachings presented herein.

During each pulse of CS1, the switch 55A closes and the capacitor 65A charges as a function of the input signal 40. In other words, the capacitor 65A accumulates charge during the pulses of CS1. The capacitor 65A is sufficiently large to accommodate the charge. Teachings regarding example sizes of the capacitor to achieve this functionality are provided in the applications referenced above.

The capacitor 65A only begins to discharge when switch 55B closes in the output module 84 upon a pulse in CS2. Since, in the example of FIG. 56, there are four pulses of CS 1 to every one pulse of CS2, charge accumulates in the capacitor 65A over four pulses of CS 1 (or, equivalently, over four samples taken by switch 55A) before discharging through the switch 55B in the output module 84. Thus, since f1 > f2, the capacitor 65A accumulates charge from a number of samples before discharge begins.

This accumulation of charge operates to average the samples taken of the input signal 40. Such averaging has a number of advantages. For example, and without limitation, averaging operates to increase signal-to-noise ratio as noise is averaged out. This advantage is enhanced as the pulse aperture of CS1 is optimized.

The averaging achieved by the invention also contributes to the filtering effect. In other words, the UDF module 10 operates to filter the input signal 40. Accordingly, such embodiments of the invention (as represented by way of example by FIG. 55) are sometimes called "running average filters."

The output module 84 operates to establish the cutoff frequency 5704 of the filter (see FIG. 57, for example).

In embodiments, the ratio of f1 to f2 is sufficient to allow the capacitor 65A (or other energy storage device) to sufficiently charge before being discharged upon the closing of switch 55B in the output module 84. When selecting the frequencies ofCS 1 and CS2, as well as other characteristics of CS1 and CS2 (such as their respective pulse widths or apertures), and characteristics of other elements such as the capacitor 65A and the resistor 5622, consideration is given to the amount of charging that is desired of the capacitor 65A, and the amount of discharge of capacitor 65A that is desired when switch 55B is closed, and the timing of same.

### 3.3.4 Other Embodiments

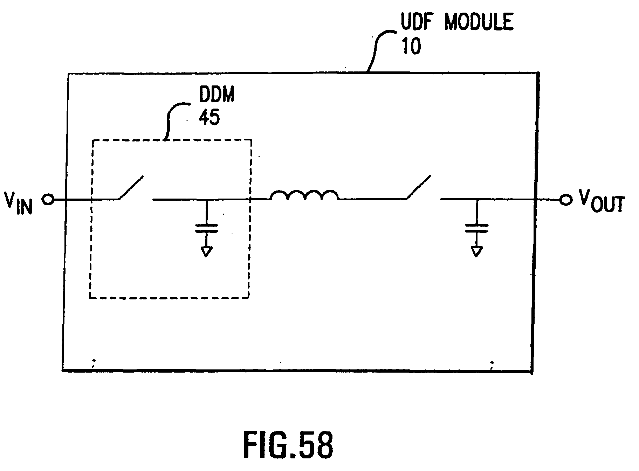

The embodiments described above are provided for purposes of illustration. These embodiments are not intended to limit the invention. Alternate embodiments, differing slightly or substantially from those described herein, will be apparent to persons skilled in the relevant art(s) based on the teachings contained herein. One such embodiment is shown, for example, in FIG. 58. Such alternate embodiments include, but are not limited to, embodiments of the UDF module where the filtering function is performed according to transfer functions differing from those utilized above. Such alternate embodiments also include, but are not limited to, embodiments of the UDF module where the frequency selectivity operation comprises filtering types not discussed above, such as, but not limited to, high pass filtering, notch filtering, etc. Such alternate embodiments fall within the scope of the present invention.

*3.4 Implementation Examples*

Exemplary operational and/or structural implementations related to the method(s), structure(s). and/or embodiments described above are presented in this section (and its subsections). These implementations are presented herein for purposes of illustration, and not limitation. The invention is not limited to the particular implementation examples described herein. Alternate implementations (including equivalents, extensions, variations, deviations, etc., of those described herein) will be apparent to persons skilled in the relevant art(s) based on the teachings contained herein.

*3.4.1 Implementation Example of a Unified Downconverting and Filtering (UDF) Module*

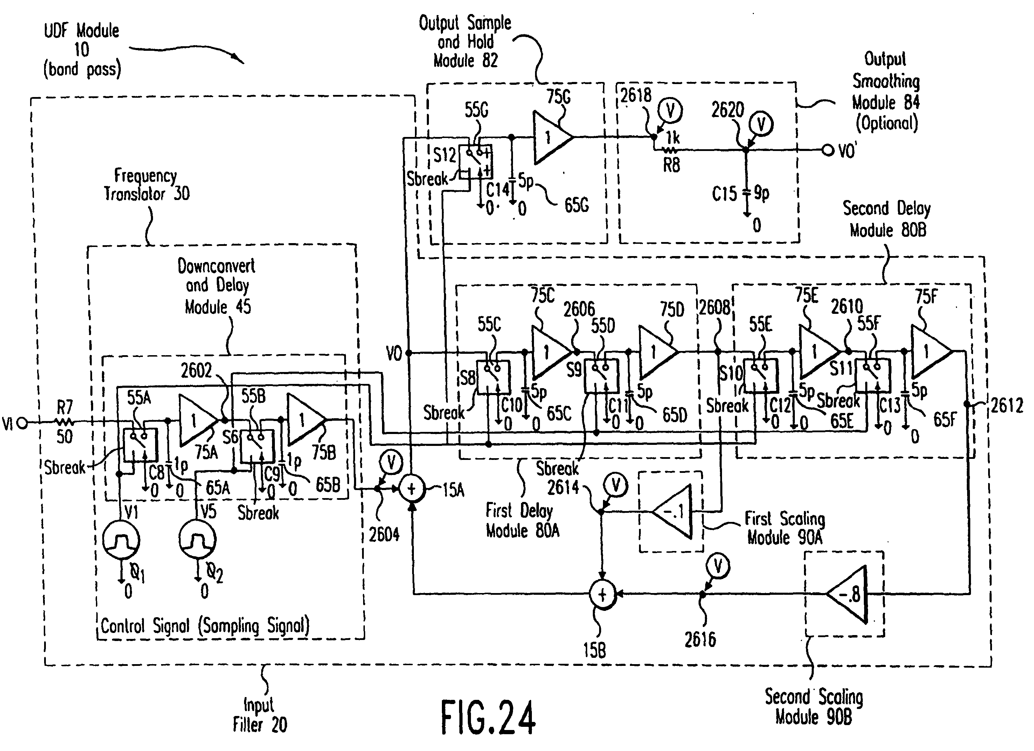

FIG. 24 illustrates an example implementation of the unified down-converting and filtering (UDF) module 10. The UDF module 10 performs the frequency translation operation 1204 and the frequency selectivity operation 1202 in an integrated, unified manner as described above, and as further described below.

In the example of FIG. 24, the frequency selectivity operation 1202 performed by the UDF module 10 comprises a band-pass filtering operation. As noted above, EQ. 3 is an example representation of a band-pass filtering transfer function. EQ. 3 is presented below for convenience. As indicated above, EQ. 3 is described herein for illustrative purposes only, and is not limiting.

$$VO = \alpha_1 \, z^{-1}VI - \beta_1 \, z^{-1}VO - \beta_0 \, z^{-2}VO \qquad \text{EQ. 3}$$

In the example of FIG. 24, the UDF module 10 performs band-pass filtering in accordance with the example band-pass filtering transfer function of EQ. 3.

The UDF module 10 includes a down-convert and delay module 45, first and second delay modules 80A and 80B, first and second scaling modules 90A and 90B, an output sample and hold module 82, and an (optional) output smoothing module 84. Other embodiments of the UDF module will have these components in different configurations, and/or a subset of these components, and/or additional components. For example, and without limitation, in the configuration shown in FIG. 24, the output smoothing module 84 is optional. Alternate embodiments of the UDF module will be apparent to persons skilled in the relevant art(s) based on the discussion contained herein.

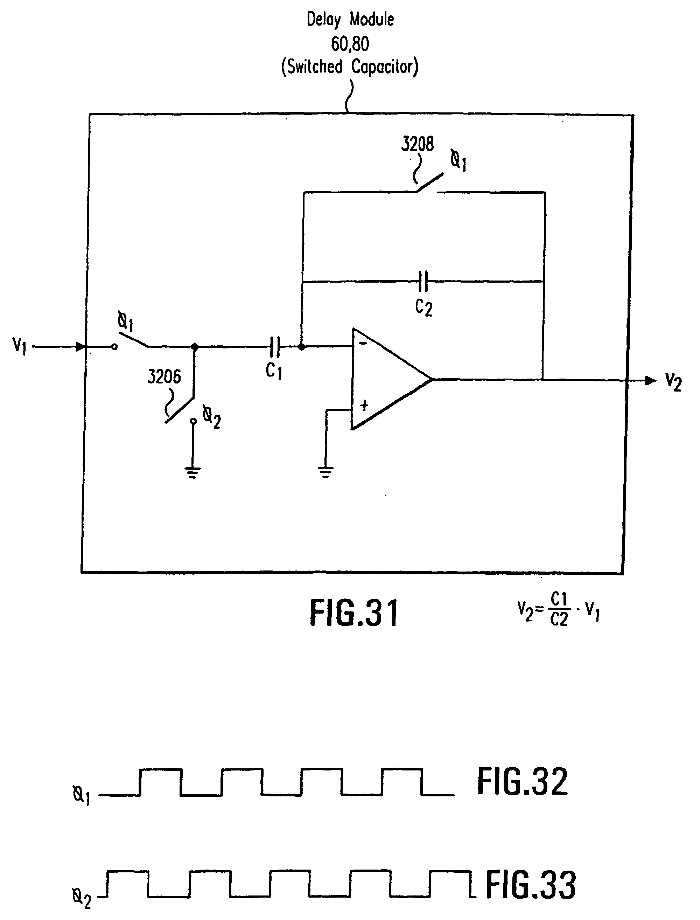

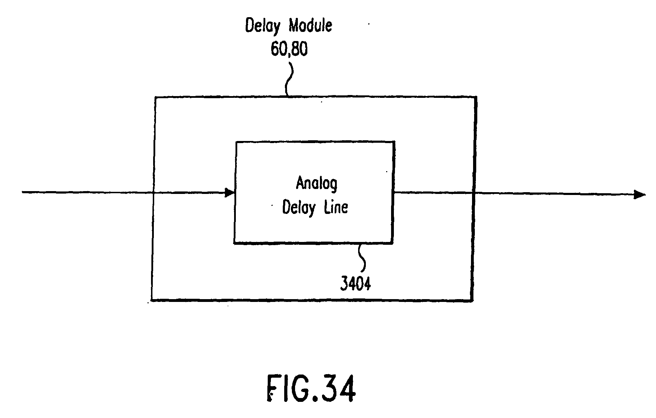

As further described below, in the example of FIG. 24, the down-convert and delay module 45 and the first and second delay modules 80A and 80B include switches that are controlled by a clock having two phases, $\phi_1$, and $\phi_2$. $\phi_1$, and $\phi_2$ preferably have the same frequency, and are non-overlapping (alternatively, a plurality such as two clock signals having these characteristics could be used). As used herein, the term "non-overlapping" is defined as two or more signals where only one of the signals is active at any given time. In some embodiments, signals are "active" when they are high. In other embodiments, signals are active when they are low. See, for example, FIGS. 32 and 33.

Preferably, each of these switches closes on a rising edge of $\phi_1$ or $\phi_2$, and opens on the next corresponding falling edge of $\phi_1$ or $\phi_2$. However, the invention is not limited to this example. As will be apparent to persons skilled in the relevant art(s), other clock conventions can be used to control the switches.

In the example of FIG. 24, it is assumed that $\alpha_1$ is equal to one. Thus, the output of the down-convert and delay module 45 is not scaled. As evident from the embodiments described above, however, the invention is not limited to this example.

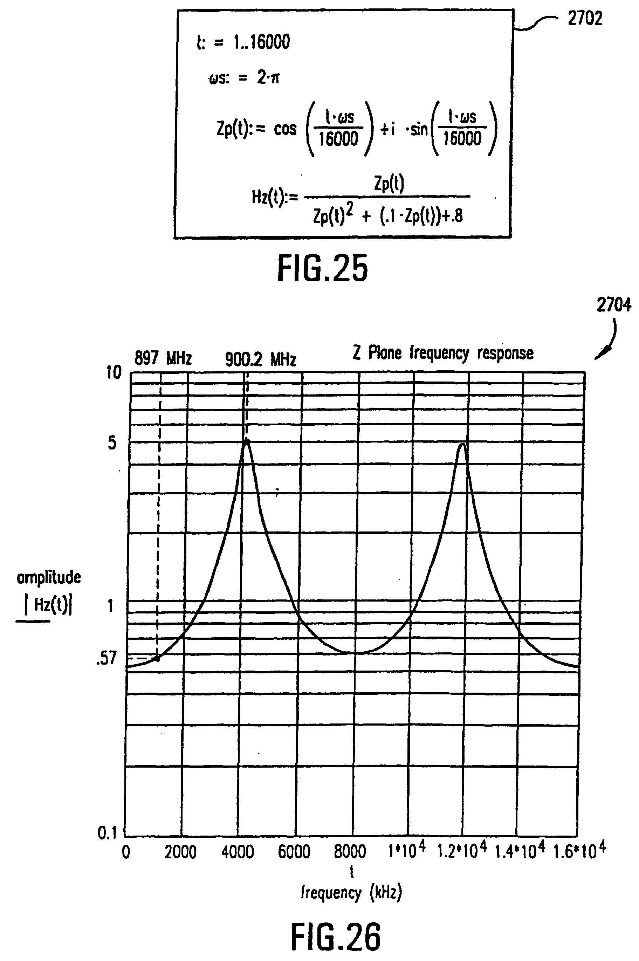

The filter characteristics of the example UDF module 10 are presented in FIGS. 25 and 26. The example UDF module 10 has a filter center frequency of 900.2 MHZ and a filter bandwidth of 570 KHz. The pass band of the UDF module 10 is on the order of 899.915 MHz to 900.485 MHz. The Q factor of the UDF module 10 is approximately 1579 (i.e., 900.2 MHZ divided by 570 KHz).

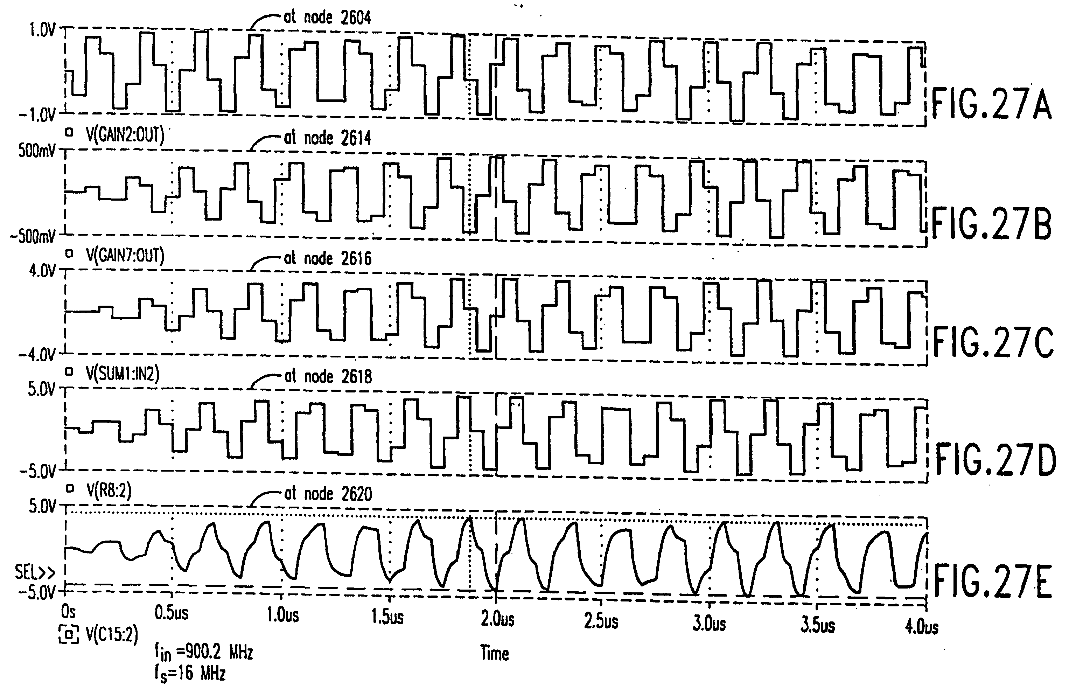

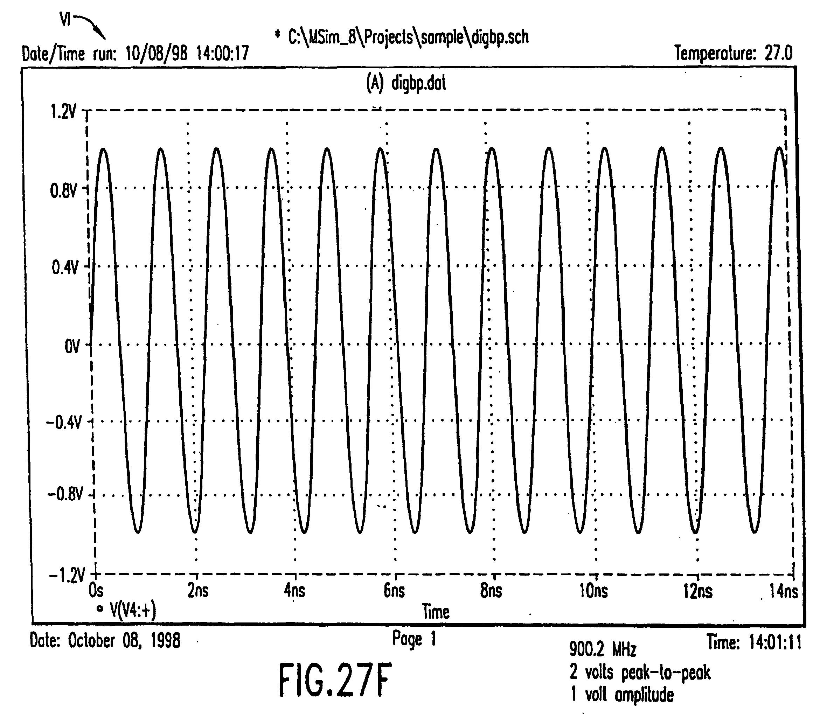

Example waveforms present at nodes in the UDF module 10 according to an example where the frequency of the input signal VI is 900.2 MHz and the frequency of the control or sample signal is 16 MHz, are presented in FIGS. 27A-27E. FIG. 27F illustrates VI corresponding to the example of FIGS. 27A-27E. FIGS. 27A-27F represent an in-band example, since the frequency of the input signal VI (i.e., 900.2 MHZ) is within the passband of the example UDF module 10. As such, the UDF module 10 amplifies the input signal by a factor of approximately 5, as predicted by the frequency response of FIG. 26.

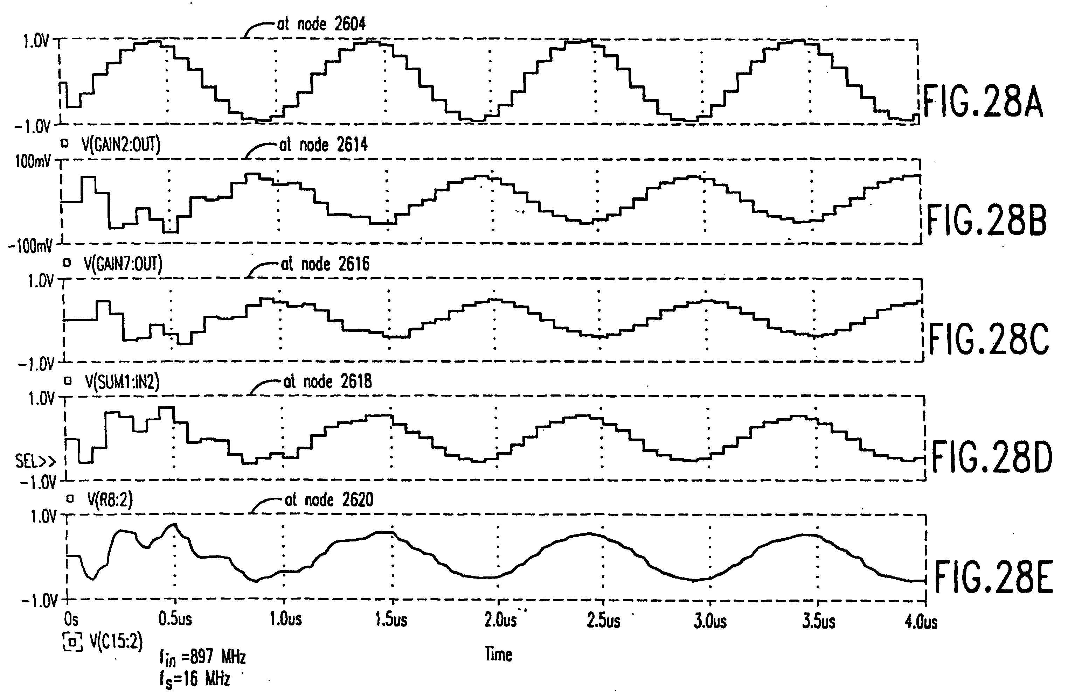

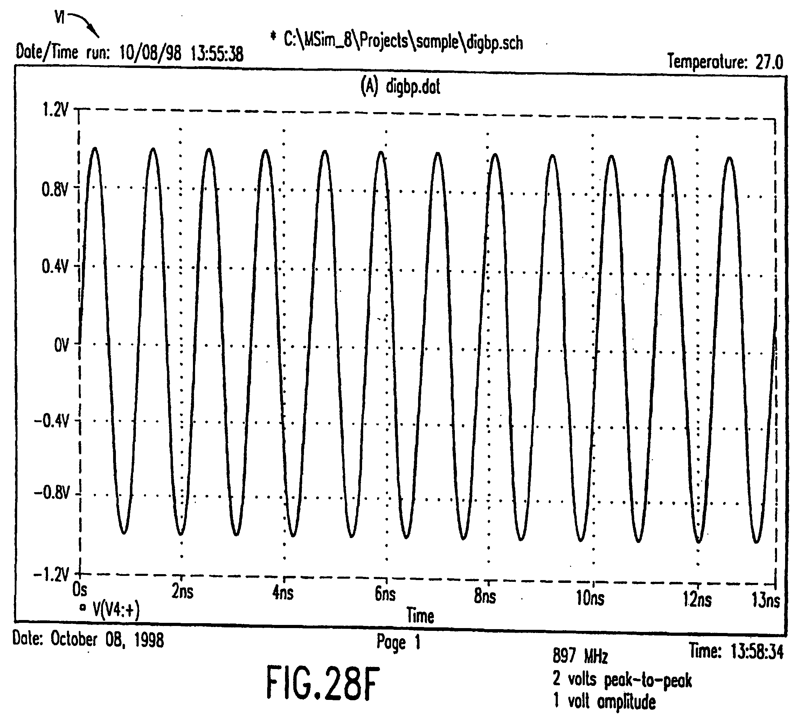

Another series of example waveforms present in the UDF module 10 where the frequency of the input signal VI is 897 MHz and the frequency of the control or sampling signal is 16 MHz, are presented in FIGS. 28A-28E. FIG. 28F illustrates VI corresponding to the example of FIGS. 28A-28E. FIGS. 28A-28F represent an out-of-band example, since the frequency of the input signal VI (i.e., 897 MHZ) is not within the passband of the example UDF module 10. As such, the UDF module 10 attenuates the input signal by a factor of approximately 0.57, as predicted by the frequency response of FIG. 26.

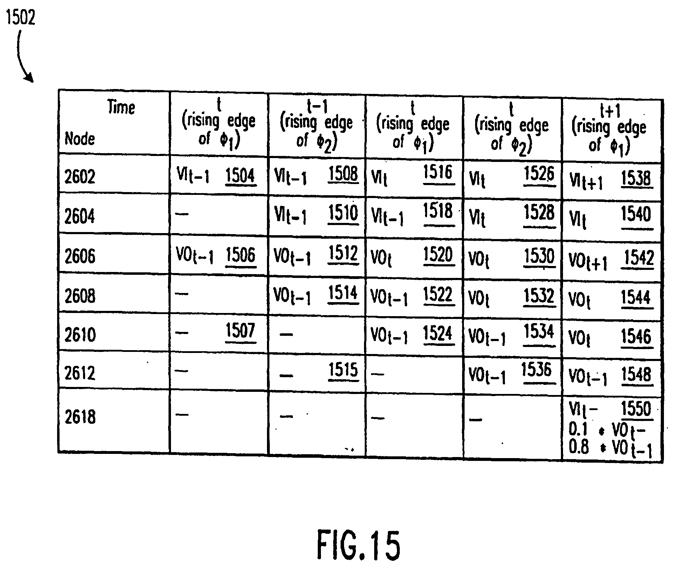

The operation of the UDF module 10 shall now be described with reference to a Table 1502 (FIG. 15) that indicates example values at nodes in the UDF module 10 at a number of consecutive time increments. It is assumed in Table 1502 that the UDF module 10 begins operating at time t-1. As indicated below, the UDF module 10 reaches steady state a few time units after operation begins. The number of time units necessary for a given UDF module to reach steady state depends on the configuration of the UDF module, and will be apparent to persons skilled in the relevant art(s) based on the teachings contained herein.

At the rising edge of $\phi_1$ at time t-1, a switch 55A in the down-convert and delay module 45 closes. This allows a capacitor 65A to charge to the current value of an input signal, $VI_{t-1}$, such that node 2602 is at $VI_{t-1}$. This is indicated by cell 1504 in FIG. 15. In effect, the combination of the switch 55A and the capacitor 65A in the down-convert and delay module 45 operates to translate the frequency of the input signal VI to a desired lower frequency, such as IF or baseband. Thus, the value stored in the capacitor 65A represents an instance of a down-converted image of the input signal VI. This operation of the down-convert and delay module 45 is further described below.

Also at the rising edge of $\phi_1$ at time t-1, a switch 55C in the first delay module 80A closes, allowing a capacitor 65C to charge to $VO_{t-1}$, such that node 2606 is at $VO_{t-1}$. This is indicated by cell 1506 in Table 1502. (In practice, $VO_{t-1}$ is undefined at this point. However, for ease of understanding, $VO_{t-1}$ shall continue to be used for purposes of explanation.)

Also at the rising edge of $\phi_1$ at time t-1, a switch 55E in the second delay module 80B closes, allowing a capacitor 65E to charge to a value stored in a capacitor 65D. At this time, however, the value in capacitor 65D is undefined, so the value in capacitor 65E is undefined. This is indicated by cell 1507 in table 1502.

At the rising edge of $\phi_2$ at time t-1, a switch 55B in the down-convert and delay module 45 closes, allowing a capacitor 65B to charge to the level of the capacitor 65A. Accordingly, the capacitor 65B charges to $VI_{t-1}$, such that node 2604 is at $VI_{t-1}$. This is indicated by cell 1510 in Table 1502.

The UDF module 10 may optionally include a unity gain module 75A between capacitors 65A and 65B. The unity gain module 75A operates as a current source to enable capacitor 65B to charge without draining the charge from capacitor 65A. For a similar reason, the UDF module 10 may include other unity gain modules 75B-75G. It should be understood that, for many embodiments and applications of the invention, these unity gain modules 75A-75G are optional. The structure and operation of the unity gain modules 75 will be apparent to persons skilled in the relevant art(s).

Also at the rising edge of $\phi_2$ at time t-1, a switch 55D in the first delay module 80A closes, allowing a capacitor 65D to charge to the level of the capacitor 65C. Accordingly, the capacitor 65D charges to $VO_{t-1}$, such that node 2608 is at $VO_{t-1}$. This is indicated by cell 1514 in Table 1502.

Also at the rising edge of $\phi_2$ at time t-1, a switch 55F in the second delay module 80B closes, allowing a capacitor 65F to charge to a value stored in a capacitor 65E. At this time, however, the value in capacitor 65E is undefined, so the value in capacitor 65F is undefined. This is indicated by cell 1515 in table 1502.

At time t, at the rising edge of $\phi_1$, the switch 55A in the down-convert and delay module 45 closes. This allows the capacitor 65A to charge to $VI_t$, such that node 2602 is at $VI_t$. This is indicated in cell 1516 of Table 1502.

Also at the rising edge of $\phi_1$ at time t, the switch 55C in the first delay module 80A closes, thereby allowing the capacitor 65C to charge to $VO_t$. Accordingly, node 2606 is at $VO_t$. This is indicated in cell 1520 in Table 1502.

Further at the rising edge of $\phi_1$ at time t, the switch 55E in the second delay module 80B closes, allowing a capacitor 65E to charge to the level of the capacitor 65D. Therefore, the capacitor 65E charges to $VO_{t-1}$, such that node 2610 is at $VO_{t-1}$. This is indicated by cell 1524 in Table 1502.

At the rising edge of $\phi_2$ at time t, the switch 55B in the down-convert and delay module 45 closes, allowing the capacitor 65B to charge to the level of the capacitor 65A. Accordingly, the capacitor 65B charges to $VI_t$, such that node 2604 is at $VI_t$. This is indicated by cell 1528 in Table 1502.

Also at the rising edge of $\phi_2$ at time t, the switch 55D in the first delay module 80A closes, allowing the capacitor 65D to charge to the level in the capacitor 65C. Therefore, the capacitor 65D charges to $VO_t$, such that node 2608 is at $VO_t$. This is indicated by cell 1532 in Table 1502.

Further at the rising edge of $\phi_2$ at time t, the switch 55F in the second delay module 80B closes, allowing the capacitor 65F in the second delay module 80B to charge to the level of the capacitor 65E in the second delay module 80B. Therefore, the capacitor 65F charges to $VO_{t-1}$, such that node 2612 is at $VO_{t-1}$. This is indicated in cell 1536 of FIG. 15.

At time t+1, at the rising edge of $\phi_1$, the switch 55A in the down-convert and delay module 45 closes, allowing the capacitor 65A to charge to $VI_{t-1}$. Therefore, node 2602 is at $VI_{t+1}$, as indicated by cell 1538 of Table 1502.

Also at the rising edge of $\phi_1$ at time t+1, the switch 55C in the first delay module 80A closes, allowing the capacitor 65C to charge to $VO_{t+1}$. Accordingly, node 2606 is at $VO_{t+1}$, as indicated by cell 1542 in Table 1502.

Further at the rising edge of $\phi_1$ at time t+1, the switch 55E in the second delay module 80B closes, allowing the capacitor 65E to charge to the level of the capacitor 65D. Accordingly, the capacitor 65E charges to $VO_t$, as indicated

by cell 1546 of Table 1502.

In the example of FIG. 24, the first scaling module 90A scales the value at node 2608 (i.e., the output of the first delay module 80A) by a scaling factor of -0.1. Accordingly, the value present at node 2614 at time t+1 is $-0.1 *$ $VO_t$. Similarly, the second scaling module 90B scales the value present at node 2612 (i.e., the output of the second scaling module 80B) by a scaling factor of -0.8. Accordingly, the value present at node 2616 is $-0.8 * VO_{t-1}$ at time t+1.

At time t+1, the values at the inputs of the summer 15A are: $VI_t$ at node 2604, $-0.1 * VO_t$ at node 2614, and $-0.8 * VO_{t-1}$ at node 2616 (in the example of FIG. 24, the values at nodes 2614 and 2616 are summed by a second summer 15B, and this sum is presented to the summer 15A). Accordingly, at time t+1, the summer generates a signal equal to $VI_t - 0.1 * VO_t - 0.8 * VO_{t-1}$.

At the rising edge of $\phi_1$ at time t+1, a switch 55G in the output sample and hold module 82 closes, thereby allowing a capacitor 65G to charge to $VO_{t+1}$. Accordingly, the capacitor 65G charges to $VO_{t+1}$, which is equal to the sum generated by the adder 15A. As just noted, this value is equal to: $VI_t - 0.1 * VO_t - 0.8 * VO_{t-1}$. This is indicated in cell 1550 of Table 1502. This value is presented to the output smoothing module 84, which smooths the signal to thereby generate the instance of the output signal $VO_{t+1}$. It is apparent from inspection that this value of $VO_{t+1}$ is consistent with the band pass filter transfer function of EQ. 3.

### 3.4.2 Implementation Examples of Components of the UDF Module

Implementation examples of the components of the UDF module according to embodiments of the present invention are described in the following sections. These example implementations are provided for purposes of illustration only, and are not limiting.

### 3.4.2.1 Downconvert and Delay Module

Referring to FIG. 17 only for illustrative purposes, the down-convert and delay module 45 performs the frequency translation operation. In an embodiment, the down-convert and delay module 45 under-samples the input signal VI such that the input under-samples form a down-converted signal. In an example implementation, the down-converted signal is an intermediate frequency (IF) representation of the input signal VI. In another example implementation, the down-converted signal is a demodulated baseband signal. The invention is not limited to these implementation examples.

In addition to performing the frequency translation operation, the down-convert and delay module 45 also delays the input samples for the frequency selectivity (filtering) operation. Thus, the down-convert and delay module 45 contributes to both the frequency translation operation and the frequency selectivity operation. The down-convert and delay module is further described below.

### 3.4.2.1.1 Universal frequency down-conversion (UFD) Module

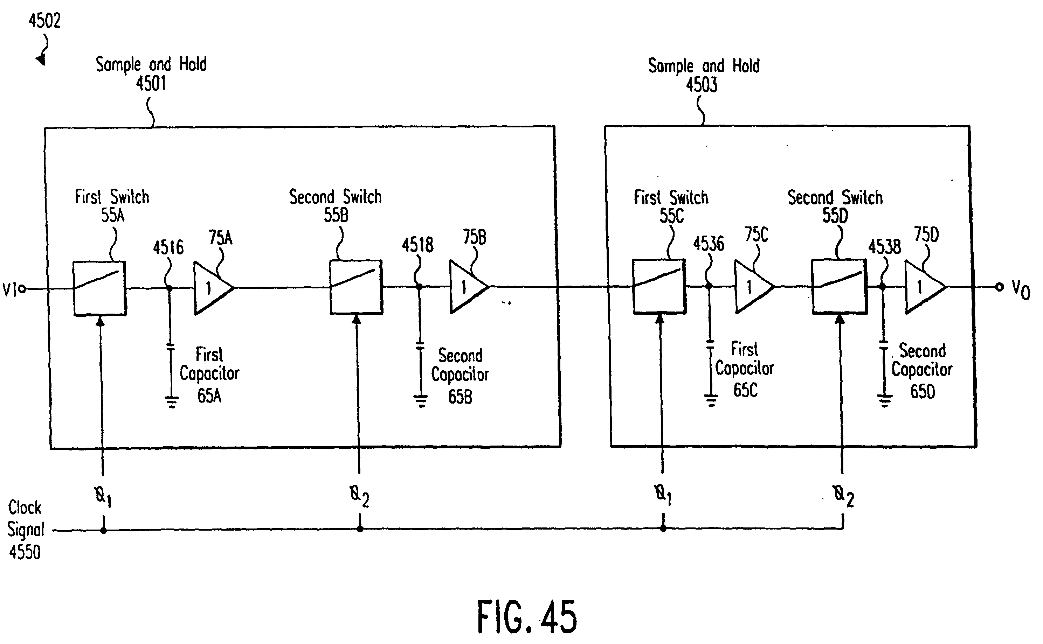

In FIG. 24, the downconvert and delay module 45 represents an example implementation of the down-convert and delay modules described herein, such as 45 in FIG. 17, 45 in FIG. 19,45 in FIG. 23, and 45 in FIG. 25. The downconvert and delay module 45 preferably includes the switch 55A and the capacitor 65A. The switch 55A and the capacitor 65A operate to down-convert the input signal VI. This aspect of the invention is described in this section. In particular, the following discussion describes down-converting using a Universal Frequency Translation (UFT) Module.

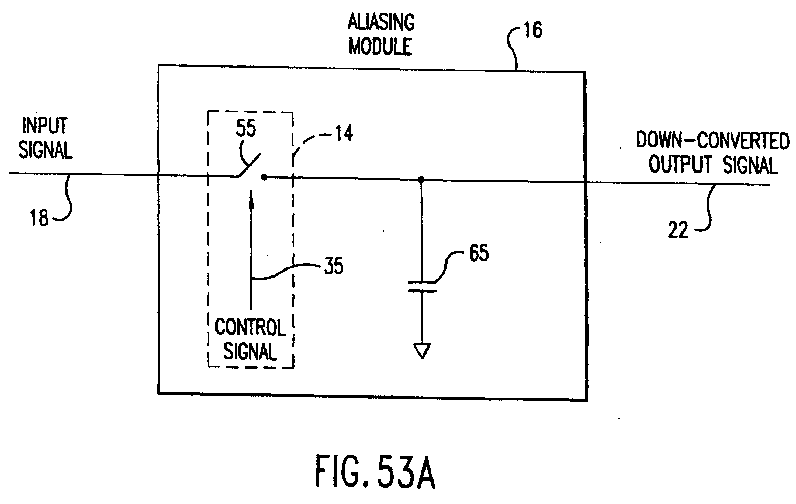

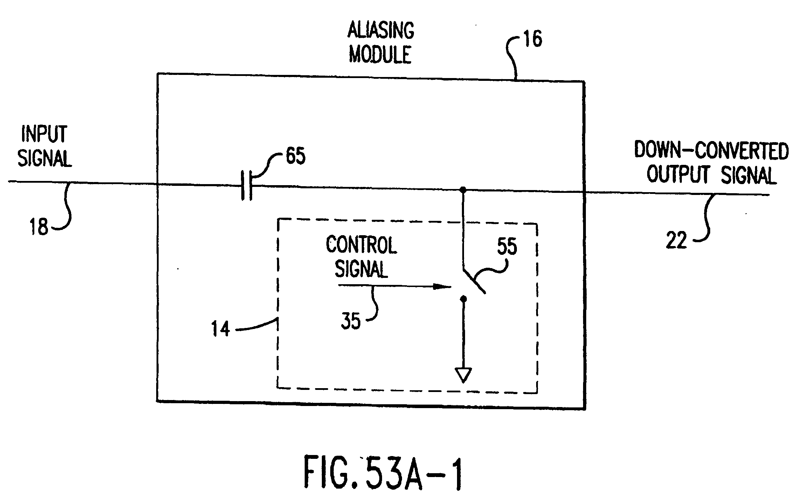

FIG.53A illustrates an aliasing module 16 (also called in this context a universal frequency down-conversion module) for down-conversion using a universal frequency translation (UFT) module 14 which down-converts an EM input signal 18. In particular embodiments, aliasing module 16 includes a switch 55 and a capacitor 65. The electronic alignment of the circuit components is flexible. That is, in one implementation, the switch 55 is in series with input signal 18 and capacitor 65 is shunted to ground (although it may be other than ground in configurations such as differential mode). In a second implementation (see FIG. 53A-1), the capacitor 65 is in series with the input signal 18 and the switch 55 is shunted to ground (although it may be other than ground in configurations such as differential mode). Aliasing module 16 with UFT module 14 can be easily tailored to down-convert a wide variety of electromagnetic signals using aliasing frequencies that are well below the frequencies of the EM input signal 18.

In one implementation, aliasing module 16 down-converts the input signal 18 to an intermediate frequency (IF) signal. In another implementation, the aliasing module 16 down-converts the input signal 18 to a demodulated baseband signal. In yet another implementation, the input signal 18 is a frequency modulated (FM) signal, and the aliasing module 16 down-converts it to a non-FM signal, such as a phase modulated (PM) signal or an amplitude modulated (AM) signal. Each of the above implementations is described below.

In an embodiment, the control signal 35 (which is an example of control signal $\phi_1$ that controls switch 55A in FIG. 24) includes a train of pulses that repeat at an aliasing rate that is equal to, or less than, twice the frequency of the input signal 18 In this embodiment, the control signal 35 is referred to herein as an aliasing signal because it is below the Nyquist rate for the frequency of the input signal 18. Preferably, the frequency of control signal 35 is much less than the input signal 18.

The train of pulses 5318 of FIG. 53D controls the switch 55 to alias the input signal 18 with the control signal 35 to generate a down-converted output signal 22. More specifically in an embodiment, switch 55 closes on a first edge of each pulse 12 of FIG. 53D and opens on a second edge of each pulse. When the switch 55 is closed, the input signal 18 is coupled to the capacitor 65, and charge is transferred from the input signal to the capacitor 65. The charge stored during successive pulses forms down-converted output signal 22.

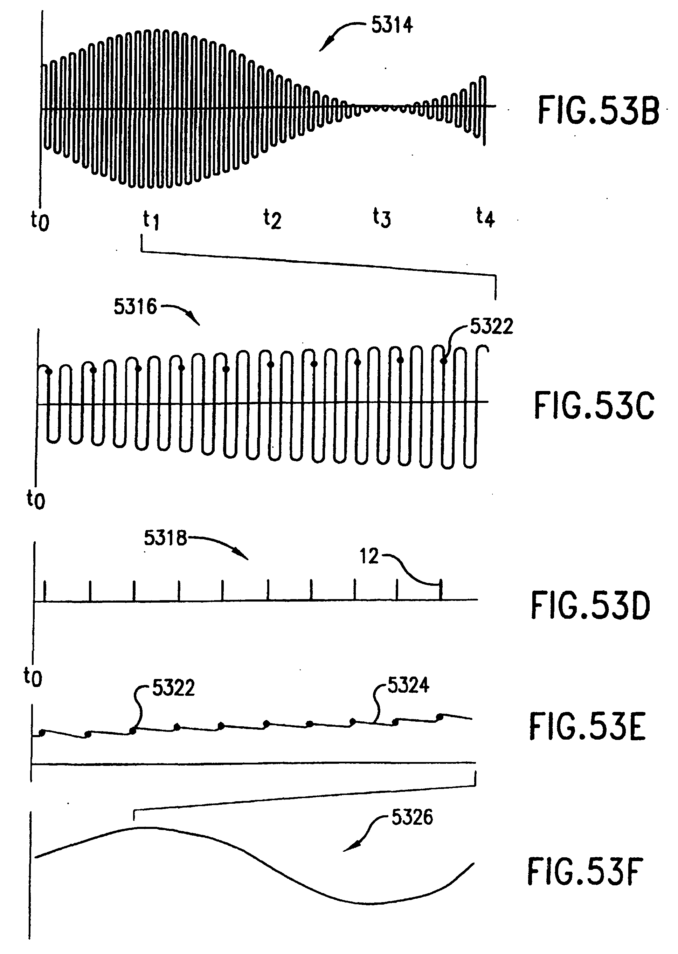

Exemplary waveforms are shown in FIGS. 53B-53F.

FIG. 53B illustrates an analog amplitude modulated (AM) carrier signal 5314 that is an example of input signal 18. For illustrative purposes, in FIG. 53C, an analog AM carrier signal portion 5316 illustrates a portion of the analog AM carrier signal 5314 on an expanded time scale. The analog AM carrier signal portion 5316 illustrates the analog AM carrier signal 5314 from time $t_0$ to time $t_1$.

FIG. 53D illustrates an exemplary aliasing signal 5318 that is an example of control signal 35. Aliasing signal 5318 is on approximately the same time scale as the analog AM carrier signal portion 5316. In the example shown in FIG. 53D, which is not in accordance with the present invention, the aliasing signal 5318 includes a train of pulses 5320 having negligible apertures that tend towards zero. The pulse aperture may also be referred to as the pulse width as will be understood by those skilled in the art(s). The pulses 12 repeat at an aliasing rate, or pulse repetition rate of aliasing signal 5318. The aliasing rate is determined as described below.

As noted above, the train of pulses 12 (i.e., control signal 35) control the switch 55 to alias the analog AM carrier signal 5316 (i.e., input signal 18) at the aliasing rate of the aliasing signal 5318. Specifically, in this embodiment, the switch 55 closes on a first edge of each pulse and opens on a second edge of each pulse. When the switch 55 is closed, input signal 18 is coupled to the capacitor 65, and charge is transferred from the input signal 18 to the capacitor 65. The charge transferred during a pulse is referred to herein as an under-sample. Exemplary under-samples 5322 form down-converted signal portion 5324 (FIG. 53E) that corresponds to the analog AM carrier signal portion 5316 (FIG. 53C) and the train of pulses 12 (FIG. 53D). The charge stored during successive under-samples of AM carrier signal 5314 forms a down-converted signal 5324 (FIG. 53E) that is an example of down-converted output signal 22 (FIG. 53A). In FIG. 53F a demodulated baseband signal 5326 represents the demodulated baseband signal 5324 after filtering on a compressed time scale. As illustrated, down-converted signal 5326 has substantially the same "amplitude envelope" as AM carrier signal 5314. Therefore, FIGS. 53B-53F illustrate down-conversion of AM carrier signal 5314.

The waveforms shown in FIGS. 53B-53F are discussed herein for illustrative purposes only, and are not limiting.

As indicated above, the aliasing rate ofcontrol signal 35 determines whether the input signal 18 is down-converted to an IF signal, down-converted to a demodulated baseband signal, or down-converted from an FM signal to a PM or an AM signal. Generally, relationships between the input signal 18, the aliasing rate of the control signal 35, and the down-converted output signal 22 are illustrated below:

$$\text{(Freq. of input signal 18)} = n \cdot \text{(Freq. of control signal 35)} \pm$$

$$\text{(Freq. of down-converted output signal 22)}$$

For the examples contained herein, only the "+" condition will be discussed. The value of $n$ represents a harmonic or sub-harmonic of input signal 18 (e.g., $n = 0.5, 1, 2, 3, ...$).

When the aliasing rate ofcontrol signal 35 is off set from the frequency of input signal 18, or off-set from a harmonic or sub-harmonic thereof, input signal 18 is down-converted to an IF signal. This is because the under-sampling pulses occur at different phases of subsequent cycles of input signal 18. As a result, the under-samples form a lower frequency oscillating pattern. Ifthe input signal 18 includes lower frequency changes, such as amplitude, frequency, phase, etc., or any combination thereof, the charge stored during associated under-samples reflects the lower frequency changes, resulting in similar changes on the down-converted IF signal. For example, to down-convert a 901 MHz input signal to a 1 MHz IF signal, the frequency of the control signal 35 would be calculated as follows:

$$(\text{Freq}_{input} - \text{Freq}_{IF})/n = \text{Freq}_{control}$$

$$(901 \text{ MHz} - 1 \text{ MHz})/n = 900/n$$

For $n$ = 0.5, 1, 2, 3, 4, etc., the frequency of the control signal 35 would be substantially equal to 1.8 GHz, 900 MHz, 450 MHz, 300 MHz, 225 MHz, etc.

Alternatively, when the aliasing rate of the control signal 35 is substantially equal to the frequency of the input signal 18, or substantially equal to a harmonic or sub-harmonic thereof, input signal 18 is directly down-converted to a demodulated baseband signal. This is because, without modulation, the under-sampling pulses occur at substantially the same point of subsequent cycles of the input signal 18. As a result, the under-samples form a constant output baseband signal. Ifthe input signal 18 includes lower frequency changes, such as amplitude, frequency, phase, etc., or any combination thereof, the charge stored during associated under-samples reflects the lower frequency changes, resulting in similar changes on the demodulated baseband signal. For example, to directly down-convert a 900 MHz input signal to a demodulated baseband signal (i.e., zero IF), the frequency of the control signal 35 would be calculated as follows:

$$(Freq_{input} - Freq_{IF})/n = Freq_{control}$$

$$(900 \text{ MHz} - 0 \text{ MHz})/n = 900 \text{ MHz}/n$$

For n = 0.5, 1, 2, 3, 4, etc., the frequency of the control signal 35 should be substantially equal to 1.8 GHz, 900 MHz, 450 MHz, 300 MHz, 225 MHz, etc.

Alternatively, to down-convert an input FM signal to a non-FM signal, a frequency within the FM bandwidth must be down-converted to baseband (i.e., zero IF). As an example, to down-convert a frequency shift keying (FSK) signal (a sub-set of FM) to a phase shift keying (PSK) signal (a subset of PM), the mid-point between a lower frequency $F_1$ and an upper frequency $F_2$ (that is, $(F_1 + F_2) \div 2$) of the FSK signal is down-converted to zero IF. For example, to down-convert an FSK signal having $F_1$ equal to 899 MHz and $F_2$ equal to 901 MHz, to a PSK signal, the aliasing rate ofthe control signal 35 would be calculated as follows:

$$\text{Frequency of the input} = (F_1 + F_2) \div 2$$

$$= (899 \text{ MHz} + 901 \text{ MHz}) \div 2$$

$$= 900 \text{ MHz}$$

Frequency of the down-converted signal = 0 (i.e., baseband)

$$(Freq_{input} - Freq_{IF})/n = Freq_{control}$$

$$(900 \text{ MHz} - 0 \text{ MHz})/n = 900 \text{ MHz}/n$$

For $n$ = 0.5, 1, 2, 3, etc., the frequency of the control signal 35 should be substantially equal to 1.8 GHz, 900 MHz, 450 MHz, 300 MHz, 225 MHz, etc. The frequency of the down-converted PSK signal is substantially equal to one half the difference between the lower frequency $F_1$ and the upper frequency $F_2$.

As another example, to down-convert a FSK signal to an amplitude shift keying (ASK) signal (a subset of AM), either the lower frequency $F_1$ or the upper frequency $F_2$ of the FSK signal is down-converted to zero IF. For example, to down-convert an FSK signal having $F_1$ equal to 900 MHz and $F_2$ equal to 901 MHz, to an ASK signal, the aliasing rate of the control signal 35 should be substantially equal to:

$$(900 \text{ MHz} - 0 \text{ MHz})/n = 900 \text{ MHz}/n,$$

or

$$(901 \text{ MHz} - 0 \text{ MHz})/n = 901 \text{ MHz}/n.$$

For the former case of 900 MHz/$n$, and for $n$ = 0.5, 1, 2, 3, 4, etc., the frequency of the control signal 35 should be substantially equal to 1.8 GHz, 900 MHz, 450 MHz, 300 MHz, 225 MHz, etc. For the latter case of 901 MHz/$n$, and for $n$ = 0.5, 1, 2, 3, 4, etc., the frequency of the control signal 35 should be substantially equal to 1.802 GHz, 901 MHz, 450.5 MHz, 300.333 MHz, 225.25 MHz, etc. The frequency of the down-converted AM signal is substantially equal to the difference between the lower frequency $F_1$ and the upper frequency $F_2$ (i.e., 1 MHz).

In an embodiment, the pulses of the control signal 35 have non-negligible apertures that tend away from zero. This makes the UFT module 14 a lower input impedance device. This allows the lower input impedance of the UFT module 14 to be substantially matched with a source impedance of the input signal 18. This also improves the energy transfer from the input signal 18 to the down-converted output signal 22, and hence the efficiency and signal to noise (s/n) ratio of UFT module 14.

When the pulses of the control signal 35 have non-negligible apertures, the aliasing module 16 is referred to interchangeably herein as an energy transfer module or a gated transfer module, and the control signal 35 is referred to as an energy transfer signal. Exemplary systems and methods for generating and optimizing the control signal 35 and for otherwise improving energy transfer and/or signal to noise ratio in an energy transfer module are described below.

### 3.4.2.1.1.1 Optional Energy Transfer Signal Module

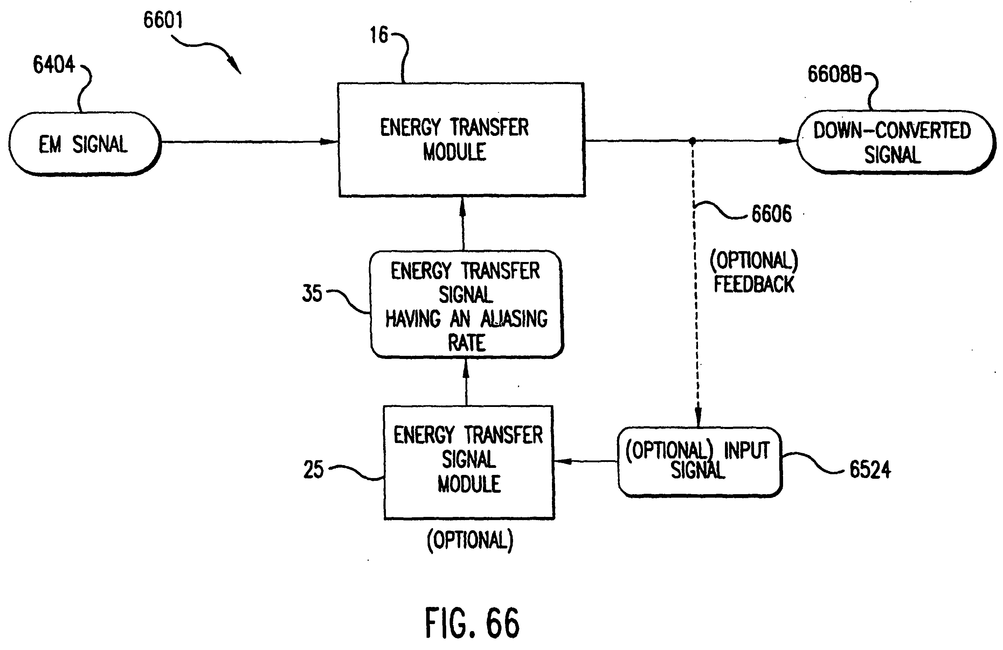

FIG. 66 illustrates an energy transfer system 6601 that includes an optional energy transfer signal module 6602, which can perform any of a variety of functions or combinations of functions including, but not limited to, generating the energy transfer signal 35.

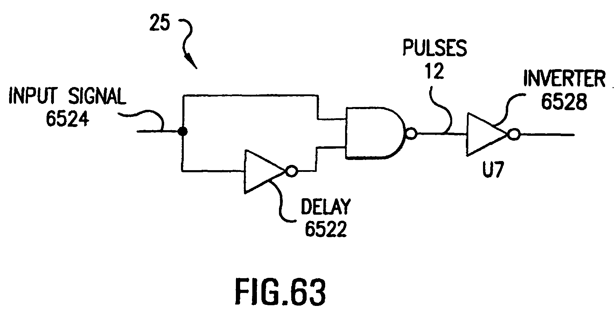

In an embodiment, the optional energy transfer signal module 6602 includes an aperture generator, an example of which is illustrated in FIG. 63 as an aperture generator 25. The aperture generator 25 generates non-negligible aperture pulses 12 from an input signal 6524. The input signal 6524 can be any type of periodic signal, including, but not limited to, a sinusoid, a square wave, a saw-tooth wave, etc. Systems for generating the input signal 6524 are described below.

The width or aperture of the pulses 12 is determined by delay through the branch 6522 of the aperture generator 25. Generally, as the desired pulse width increases, the difficulty in meeting the requirements of the aperture generator 25 decrease. In other words, to generate non-negligible aperture pulses for a given EM input frequency, the components utilized in the example aperture generator 25 do not require as fast reaction times as those that are required in an under-sampling system operating with the same EM input frequency.

The example logic and implementation shown in the aperture generator 25 are provided for illustrative purposes only, and are not limiting. The actual logic employed can take many forms. The example aperture generator 25 includes an optional inverter 6528, which is shown for polarity consistency with other examples provided herein.

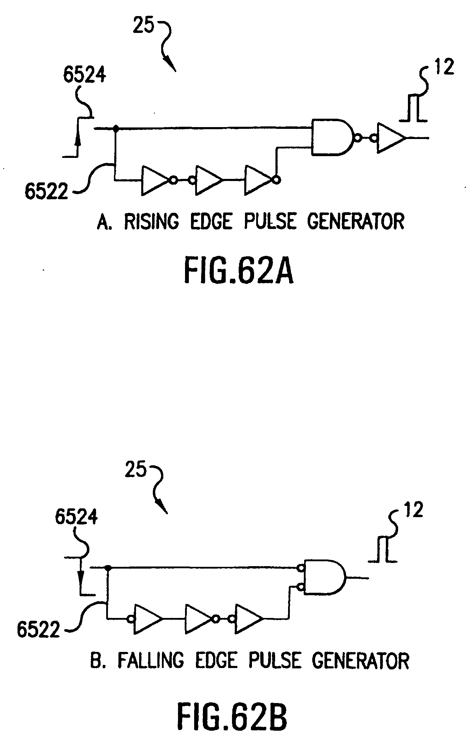

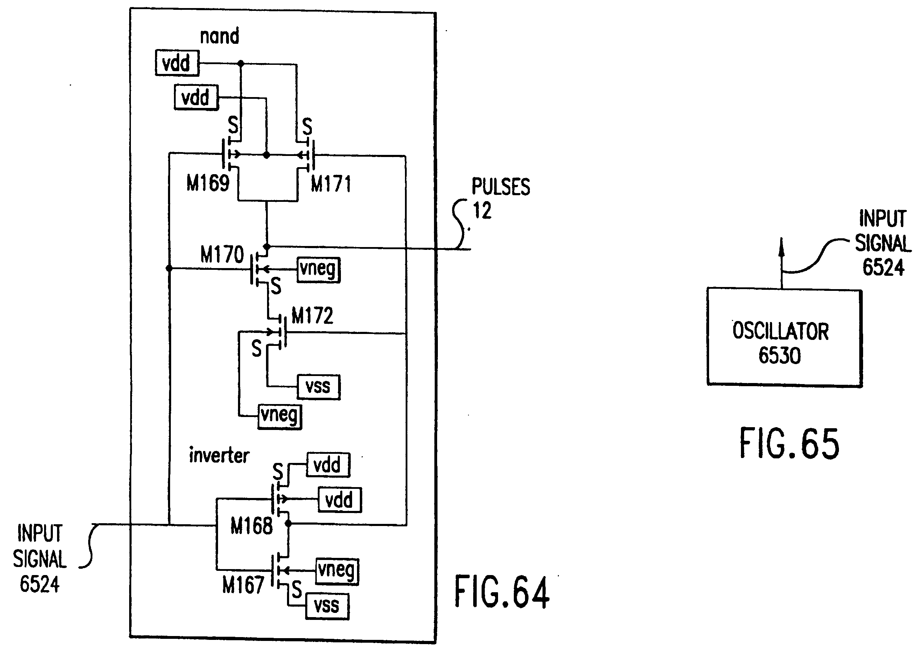

An example implementation of the aperture generator 25 is illustrated in FIG. 64. Additional examples of aperture generation logic are provided in FIGS. 62A and 62B. FIG. 62A illustrates a rising edge pulse generator 25, which generates pulses 12 on rising edges of the input signal 6524. FIG. 62B illustrates a falling edge pulse generator 25, which generates pulses 12 on falling edges of the input signal 6524.

In an embodiment, the input signal 6524 is generated externally of the energy transfer signal module 6602, as illustrated in FIG. 66. Alternatively, the input signal 6624 is generated internally by the energy transfer signal module 6602. The input signal 6524 can be generated by an oscillator, as illustrated in FIG. 65 by an oscillator 6530. The oscillator 6530 can be internal to the energy transfer signal module 6602 or external to the energy transfer signal module 6602. The oscillator 6530 can be external to the energy transfer system 6601. The output of the oscillator 6530 may be any periodic waveform.

The type of down-conversion performed by the energy transfer system 6601 depends upon the aliasing rate of the energy transfer signal 35, which is determined by the frequency of the pulses 12. The frequency of the pulses 12 is determined by the frequency of the input signal 6524. For example, when the frequency of the input signal 6524 is substantially equal to a harmonic or a sub-harmonic of the EM signal 6404, the EM signal 6404 is directly down-converted to baseband (e.g. when the EM signal is an AM signal or a PM signal), or converted from FM to a non-FM signal. When the frequency of the input signal 6524 is substantially equal to a harmonic or a sub-harmonic of a difference frequency, the EM signal 6404 is down-converted to an intermediate signal.

The optional energy transfer signal module 6602 can be implemented in hardware, software, firmware, or any combination thereof.

### 3.4 2.1.1.2 Charge and Power Transfer Concepts

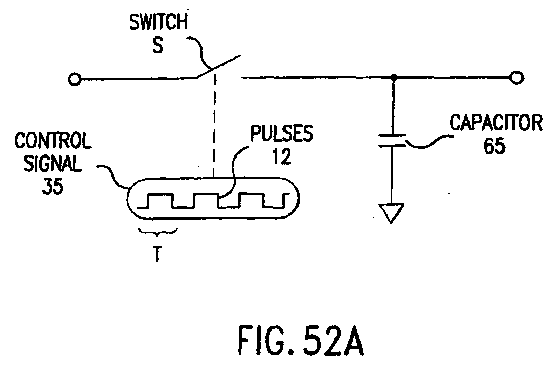

Concepts of charge transfer are now described with reference to FIGS. 52A-F. FIG. 52A illustrates a circuit 5202, including a switch S and a capacitor 65 having a capacitance C. The switch S is controlled by a control signal 35, which includes pulses 12 having apertures T.

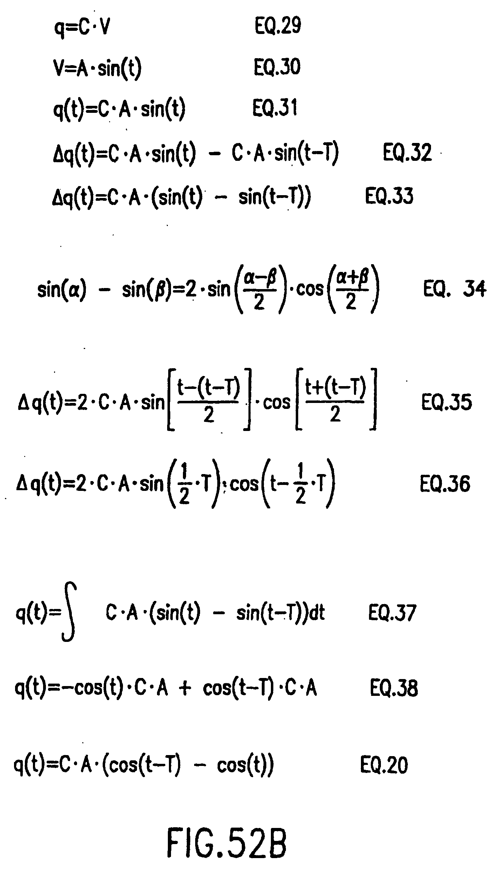

In FIG. 52B, Equation 29 illustrates that the charge q on a capacitor having a capacitance C, such as the capacitor 65, is proportional to the voltage V across the capacitor, where:

q = Charge in Coulombs
C = Capacitance in Farads
V = Voltage in Volts
A = Input Signal Amplitude

Where the voltage V is represented by Equation 30, Equation 29 can be rewritten as Equation 31. The change in charge $\Delta q$ over time t is illustrated as in Equation 32 as $\Delta q(t)$, which can be rewritten as Equation 33. Using the sum-to-product trigonometric identity of Equation 34, Equation 33 can be rewritten as Equation 35, which can be rewritten as equation 36.

Note that the sin term in Equation 30 is a function of the aperture T only. Thus, $\Delta q(t)$ is at a maximum when T is equal to an odd multiple of $\pi$ (i.e., $\pi$, $3\pi$, $5\pi$,...). Therefore, the capacitor 65 experiences the greatest change in charge when the aperture T has a value of $\pi$ or a time interval representative of 180 degrees of the input sinusoid. Conversely, when T is equal to $2\pi$, $4\pi$, $6\pi$, ..., minimal charge is transferred.

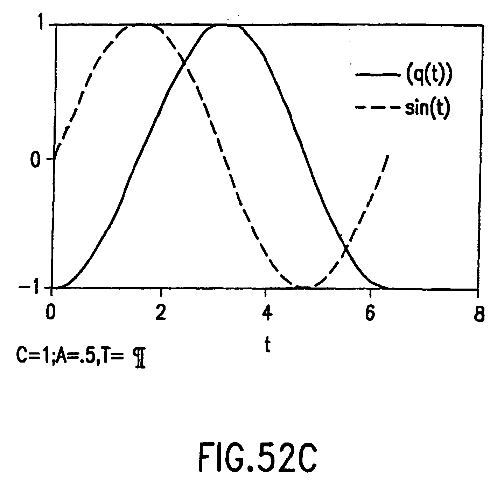

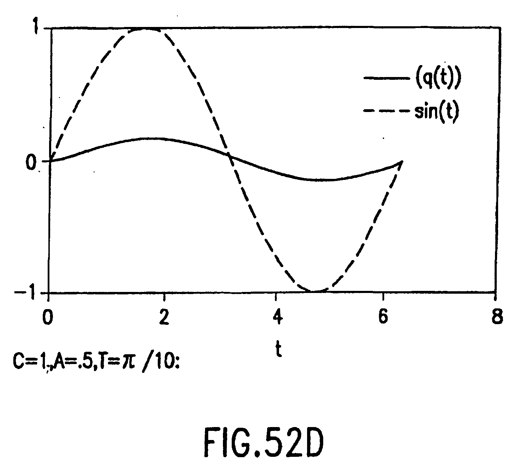

Equations 37, 38, and 20 solve for q(t) by integrating Equation 29, allowing the charge on the capacitor 65 with respect to time to be graphed on the same axis as the input sinusoid sin(t), as illustrated in the graph of FIG. 52C. As the aperture T decreases in value or tends toward an impulse, the phase between the charge on the capacitor C or q(t) and sin(t) tend toward zero. This is illustrated in the graph of FIG. 52D, which indicates that the maximum impulse charge transfer occurs near the input voltage maxima. As this graph indicates, considerably less charge is transferred as the value of T decreases.

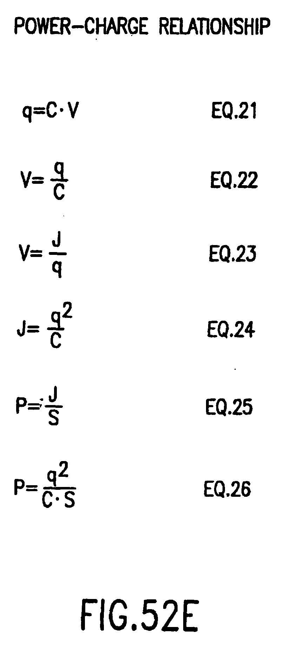

Power/charge relationships are illustrated in Equations 21-26 of FIG. 52E, where it is shown that power is proportional to charge, and transferred charge is inversely proportional to insertion loss.

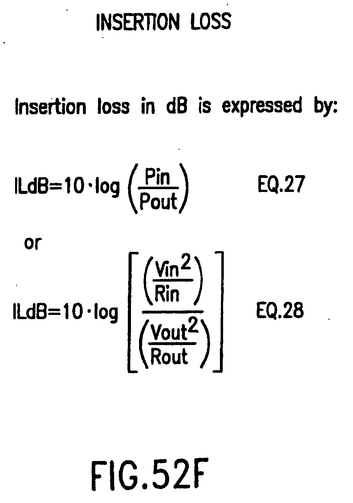

Concepts of insertion loss are illustrated in FIG. 52F. Generally, the noise figure of a lossy passive device is numerically equal to the device insertion loss. Alternatively, the noise figure for any device cannot be less that its insertion loss. Insertion loss can be expressed by Equation 27 or 28. From the above discussion, it is observed that as the aperture T increases, more charge is transferred from the input to the capacitor 65, which increases power transfer from the input to the output. It has been observed that it is not necessary to accurately reproduce the input voltage at the output because relative modulated amplitude and phase information is retained in the transferred power.

### 3.4.2.2 Delay Modules

As indicated above, a delay module operates to delay samples/instances of a signal presented at its input by a known amount.

For example, in the embodiment of the UDF module 10 shown in FIG. 24, the first and second delay modules 80A and 80B operate to delay instances of the output signal VO. Specifically, the first delay module 80A delays instances of the output signal VO by one time unit. The second delay module 80B also delays instances of the output signal VO by one time unit. However, the second delay module 80B receives its input from the first delay module 80A. Accordingly, the effect of the second delay module 80B (in combination with the first delay module 80A) is to delay instances of the output signal VO by two time units. This is required, for example, by the second and third components of the example band-pass filtering transfer function of EQ. 3.

In the embodiment of the UDF module 10 shown in FIG. 24, the first delay module 80A and the second delay module 80B are each implemented using a sample and hold circuit. For ease of presentation and illustration, such sample and hold circuits are depicted in FIG. 45. (As apparent from the discussion contained herein, other embodiments of the UDF module include delay modules. Such delay modules can also be implemented using sample and hold circuits. Alternatively, well known delay circuits or processors/software can be utilized, as will be apparent to persons skilled in the relevant art(s) based on the teachings contained herein.)

More particularly, FIG. 45 shows two sample and hold circuits 4501 and 4503. The sample and holds 4501 and 4503 are similar in structure and operation. Generally, the first delay module 80A and the second delay module 80B can each be implemented using either the sample and hold 4501 or the sample and hold 4503. Preferably, the first delay module 80A and the second delay module 80B are generally implemented in the example configuration shown in FIG. 45.

Each sample and hold 4501,4503 includes a first switch 55A, 55C and a second switch 55B, 55D, respectively. The first switches 55A, 55C, and the second switches 55B, 55D are controlled by a clock signal 4550. Preferably, the clock signal 4550 has two phases, $\phi_1$ and $\phi_2$. Preferably, $\phi_1$ and $\phi_2$ have the same frequency, but are non-overlapping. The first switches 55A, 55C are controlled by $\phi_1$. Preferably, the first switches 55A and 55C close on rising edges of

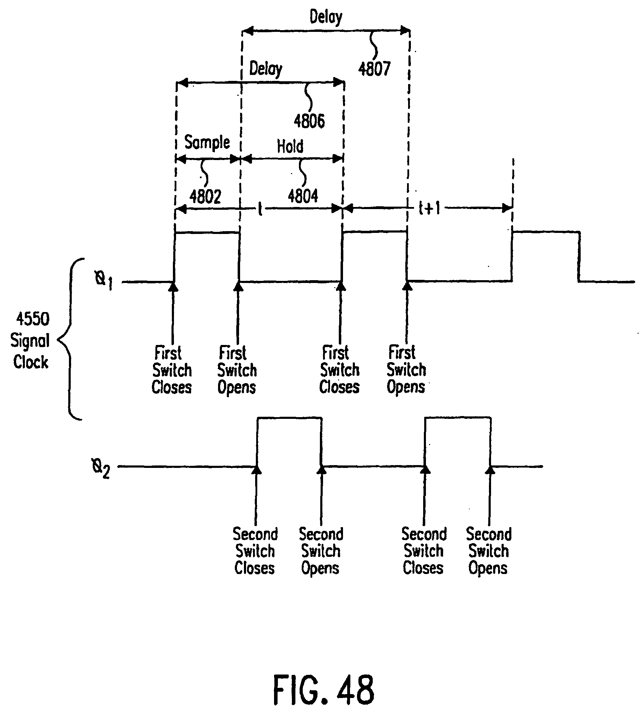

$\phi_1$, and open on the following falling edges of $\phi_1$. The second switches 55B,55D are controlled by $\phi_2$. Preferably, the second switches 55B and 55D close on rising edges of $\phi_2$, and open on the following falling edges Of $\phi_2$. Example representations of $\phi_1$, and $\phi_2$ are shown in FIG. 48. It is noted that the invention is not limited to this switching convention. In other embodiments, other switching conventions are used. Further, other circuit configurations could be used.

The sample and holds 4501, 4503 also each include a first capacitor 65A, 65C and a second capacitor 65B, 65D, respectively. The sample and holds 4501,4503 optionally include unity gain modules 75A, 75B, 75C, 75D which operate in the manner described above.

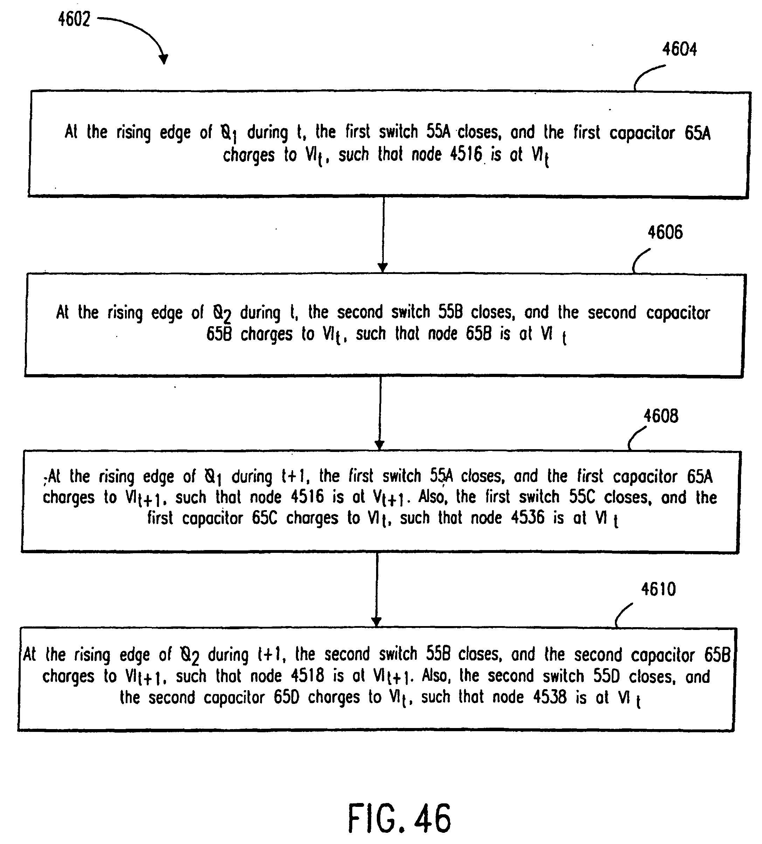

The operation of the sample and holds 4501, 4503 is now described with reference to a flowchart 4602 shown in FIG. 46. Reference shall also be made to a Table 4702 that indicates example values at particular nodes in the sample and holds 4501 and 4503 at a number of consecutive time increments. In the example of Table 4702, it is assumed that operation of the sample and holds 4501, 4503 begins at time t. One or more cycles are required for the sample and holds 4501, 4503 to reach steady state. The number of cycles required to reach steady state will be apparent to persons skilled in the relevant art(s) based on the teachings contained herein.

In step 4604, at the rising edge of $\phi_1$ during a time t, the switch 55A closes. Upon the closing of the first switch 55A, the first capacitor 65A charges to $VI_t$ such that node 4516 is at $VI_t$. This is indicated in cell 4704 of Table 4702.

Note that the first switch 55C in the sample and hold 4503 also closes upon the rising edge of $\phi_1$ during t. This causes the first capacitor 65C in the sample and hold 4503 to charge to the level stored in the second capacitor 65B in the sample and hold 4501. However, in the example, currently being discussed, the value of the second capacitor 65B at the rising edge of $\phi_1$ during time t is undefined. Accordingly, the charge in the first capacitor 65C at this time t is undefined, as indicated in cell 4705 in Table 4702.

In step 4606, at the rising edge of $\phi_2$ during time t, the second switch 55B in the sample and hold 4501 closes. This causes the second capacitor 65B to charge to the level of the first capacitor 65A. Accordingly, the second capacitor 65B charges to $VI_t$. This causes the value at node 4518 to become $VI_t$. This is indicated in cell 4708 of table 4702.

Also upon the rising edge of $\phi_2$ during time t, the second switch 55D in the sample and hold 4503 closes, such that the second capacitor 65D charges to the level of the first capacitor 65C in the sample and hold 4503. However, as described above, the charge in the first capacitor 65C at this time is undefined. Accordingly, the charge in the second capacitor 65D at this time is undefined, as indicated by cell 4709 in Table 4702.

In step 4608, at the rising edge of $\phi_1$ during time t+1, the first switch 55A in the sample and hold 4501 closes. This causes the first capacitor 65A to charge to $VI_{t+1}$, such that node 4516 is at $VI_{t+1}$. This is indicated in cell 4710 in Table 4702.

Also on the rising edge of $\phi_1$ during time t+1, the first switch 55C in the sample and hold 4503 closes. This causes the first capacitor 65C in the sample and hold 4503 to charge to the level of the second capacitor 65B in the sample and hold 4501. Accordingly, the first capacitor 65C charges to $VI_t$, such that node 4536 is at $VI_t$. This is indicated in cell 4714 of Table 4702.

In step 4610, at the rising edge of $\phi_2$ during time t+1, the second switch 55B in the sample and hold 4501 closes. This causes the second capacitor 65B in the sample and hold 4501 to charge to the level of the first capacitor 65A. In other words, the second capacitor 65B charges to $VI_{t+1}$, such that node 4518 is at $VI_{t+1}$. This is indicated by cell 4718 in Table 4702.

Also at the rising edge of $\phi_2$ during time t+1, the second switch 55D in the sample and hold 4503 closes. This causes the second capacitor 65D to charge to the level of the first capacitor 65C in the sample and hold 4503. In other words, the second capacitor 65D charges to $VI_t$ such that node 4538 is at $VI_t$. This is indicated in cell 4722 of Table 4702.

FIG. 48 illustrates another representation of the operation of the sample and holds 4501,4503. FIG. 48 illustrates $\phi_1$ and $\phi_2$ of the clock signal 4550. As discussed above, the first switches 55A, 55C close at rising edges of $\phi_1$, and open at falling edges of $\phi_1$. The second switches 55B, 55D close at rising edges of $\phi_2$, and open at falling edges of $\phi_2$.

Consider now the sample and hold 4501. When the first switch 55A closes, the first capacitor 65A begins to charge to the input signal VI and continues to charge until the first switch 55A opens. The first switch 55A is closed while $\phi_1$ is high. Accordingly, while $\phi_1$ is high, the sample and hold 4501 samples the input signal VI. This is indicated in FIG. 48 by a sample period 4802.

FIG. 48 also indicates a hold period 4804. During this hold period 4804, the sample of the input signal VI that is stored in the first capacitor 65A is held in the sample and hold 4501. Specifically, this input sample is held in the first capacitor 65A until the next rising edge of $\phi_1$ (during time t+1). Also, at the rising edge of $\phi_2$ during time t, the second switch 55B closes and the second capacitor 65B charges to this input sample. This value is held in the second capacitor 65B until the next rising edge of $\phi_2$ at time t+1.

Accordingly, in sample and hold 4501, VI is sampled at the beginning oft, and is held in the sample and hold 4501 until after time period t expires (i.e., for greater than a full period of the clock signal 4550). Note, however, that the next sample and hold 4503 does not sample the output of the first sample and hold 4501 until the next rising edge of $\phi_1$ (that is, the rising edge of $\phi_1$ during time t+1). Thus, the first sample and hold 4501 samples VI at time t; this sample $VI_t$ does not propagate to the next sample and hold 4503 until time t+1. Accordingly, the sample and hold 4501 effectively holds or delays the sample of the input signal VI for one time period. This delay period is denoted as 4806 in FIG. 48.

In practice, the charge in the first capacitor 65A tracks the input signal VI while the first switch 55A is closed (i.e., during the sample period 4802 of time t). The charge stored in the first capacitor 65A at the falling edge of $\phi_1$ of time t constitutes the input sample $VI_t$. In other words, the input sample $VI_t$ is defined in the sample and hold 4501 at the falling edge of $\phi_1$ of time t. The input sample in the sample and hold 4501 is not re-defined until the next falling edge of $\phi_1$ (i.e., the falling edge of $\phi_1$ of time t+1). Accordingly, the delay of the sample and hold 4501 can be considered to be delay 4807 shown in FIG. 48.

The discussion in this section has thus far focused on the delay modules 80A, 80B implemented using sample and hold circuits, as in the example UDF module 10 of FIG. 24. However, the invention is not limited to this implementation example. Instead, the delay modules in the UDF module can be implemented using any apparatus or circuit that operates to delay an incoming signal by a predetermined amount.

For example, referring for illustrative purposes only to FIG. 17, the delay modules 60, 80 can each be implemented using a switched capacitor topology, such as that shown in FIG. 31. The switch capacitor topology includes two switches 3208 and 3206 which operate according to $\phi_1$ and $\phi_2$ of a clock signal. An example representation of $\phi_1$ and $\phi_2$ is shown in FIGS. 32 and 33.

In addition to delaying an input signal VI, the particular switch capacitor shown in FIG. 31 also scales the input signal as follows:

$$V2 = \frac{C1}{C2} * V1$$

Accordingly, when using a switched capacitor such as that shown in FIG. 31, the switch capacitor performs the function of both the delay module 60, 80 and the associated scaling module 70, 90.

The delay modules 60, 80 can also each be implemented using an analog delay line, such as the analog delay line 3404 in FIG. 34, for example. As will be apparent to persons skilled in the relevant art(s), an analog delay line 3404 is constructed using a combination of capacitors, inductors, and/or resistors. The analog delay line 3404 operates to delay an input signal by a known amount. In some embodiments, the analog delay line 3404 is combined with other components to achieve this function, such as samplers.

The above implementation examples are provided for illustrative purposes only, and are not limiting. Other implementation examples will be apparent to persons skilled in the relevant art(s) based on the teachings contained herein.

### 3.4.2.3 Scaling Modules

The scaling modules in the UDF module operate to scale signals present at their respective inputs. Such scaling contributes to the filter characteristics (such as the filter center frequency and bandwidth) of the UDF module.

Referring for illustrative purposes only to the UDF module 10 in FIG. 17, the scaling modules. 70, 90 can be implemented using any apparatus or circuit that scales an input signal by a known amount. The scaling factor may be less than 1 (in the case of attenuation) or greater than 1 (in the case of amplification). More generally, the scaling factor may be any real number, including but not limited to zero.

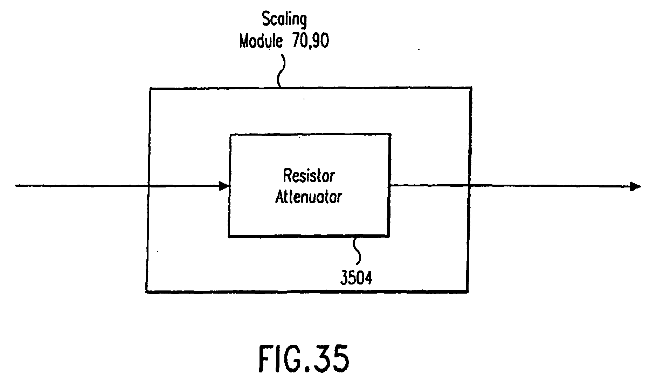

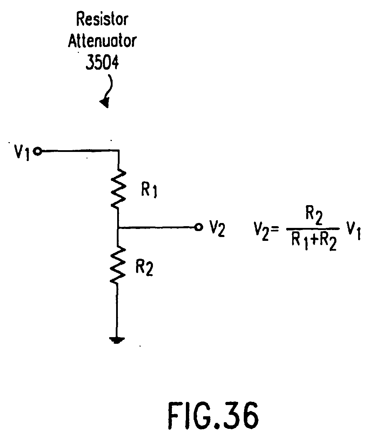

For example, each scaling module 70,90 can be implemented using a resistor attenuator 3504, as shown in FIG. 35. As will be appreciated by persons skilled in the relevant art(s), there are many types and configurations of resistor attenuators. FIG. 36 illustrates an example resistor attenuator 3504. This example resistor attenuator 3504 scales an input V1 by:

$$V2 = \frac{R_2}{R_1 + R_2} * V1$$

Other circuit diagrams for resistor attenuators suitable for use as the scaling modules 70, 90 in the UDF module 10 will be apparent to persons skilled in the relevant art(s).

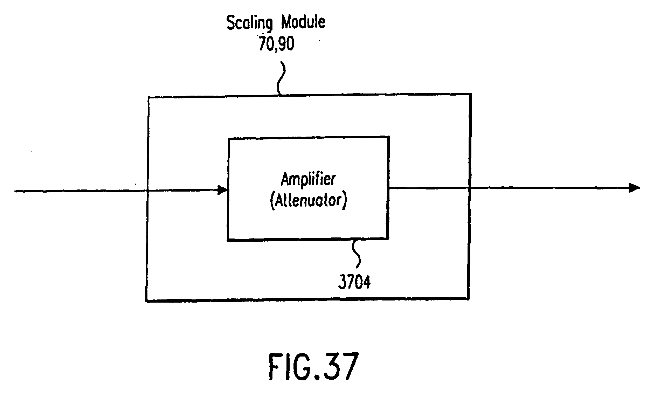

An amplifier/attenuator 3704 can also be used to implement the scaling modules 70, 90. An example amplifier 3704 is shown in FIG. 37. As will be appreciated by persons skilled in the relevant art(s), amplifiers suitable for use as scaling modules 70, 90 in the UDF module 10 can be implemented using a variety of circuit components, such as, but not limited to, operational amplifiers (OP AMPS), transistors, FETS, etc.

The above implementation examples are provided for illustrative purposes only, and are not limiting. Other implementation examples will be apparent to persons skilled in the relevant art(s) based on the teachings contained herein.

### 3.4.2.4 Adder

Referring for illustrative purposes only to FIG. 17, the adder 15 (also called the summer herein) sums the signals presented at its inputs. The adder 15 can be implemented using any apparatus or circuit that sums a plurality of input signals.

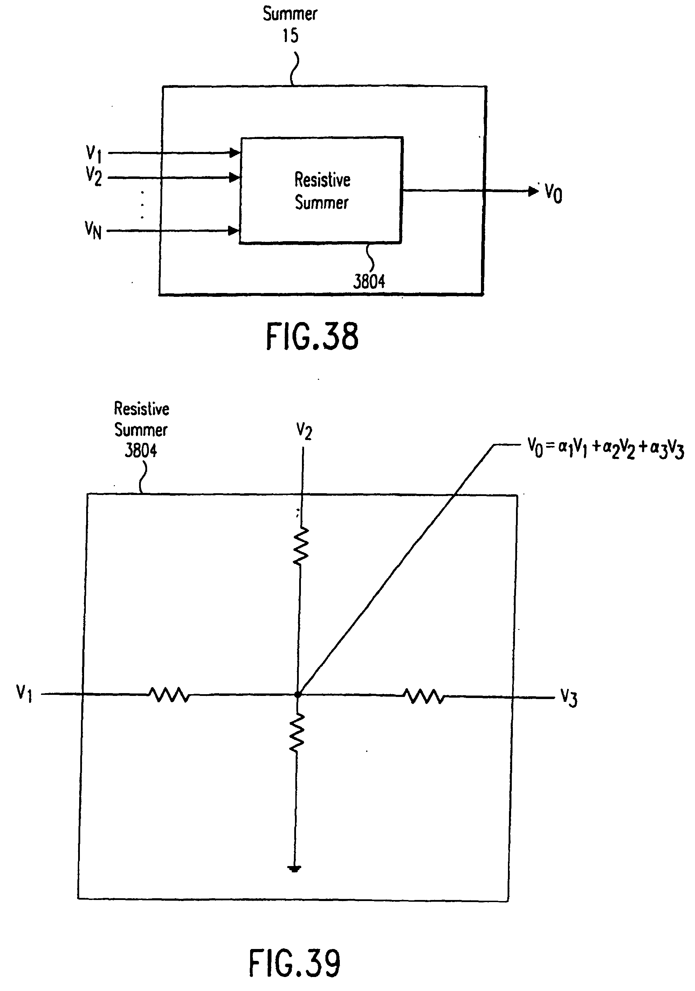

For example, the adder 15 can be implemented using a resistive summer 3804 (FIG. 38). As will be appreciated by persons skilled in the relevant art(s), there are many configurations of resistive summers. FIG. 39 illustrates an example resistive summer 3804 that can be used to implement the adder 15. However, the invention is not limited by this example.

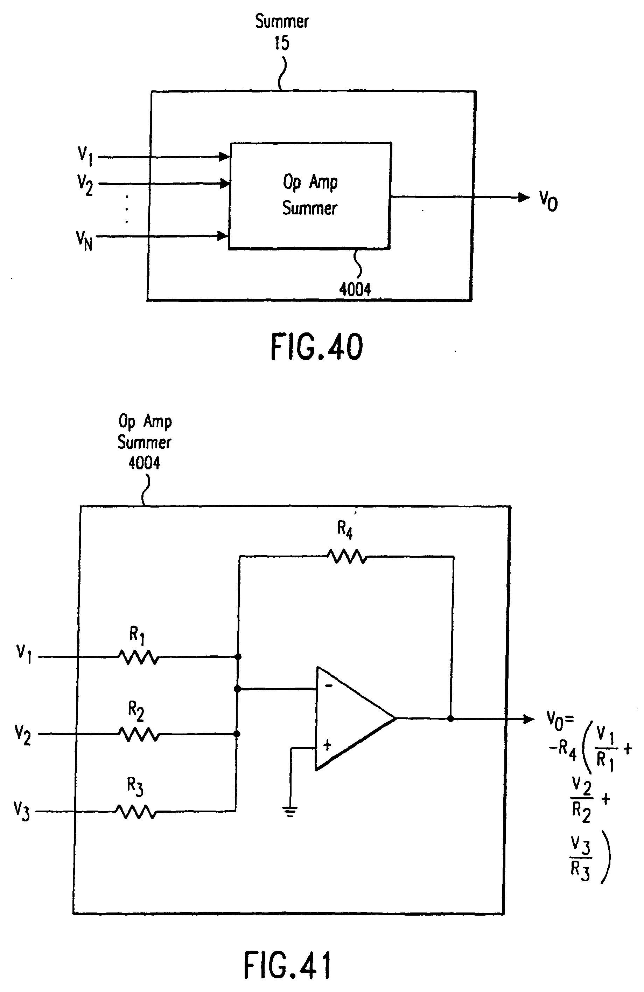

The adder 15 could also be implemented using an OP AMP summer 4004 (FIG. 40). As will be appreciated by persons skilled in the relevant art(s),.there are many types and configurations ofOP AMP summers. For illustrative purposes, an example OP AMP summer 4004 is provided in FIG. 41. The structure and operation of the OP AMP summer 4004 will be apparent to persons skilled in the relevant art(s). It should be understood that the invention is not limited by the example OP AMP summer 4004 provided in FIG. 41.

The adder 15 can also be implemented using a combination of summer components. This is shown, for example, in the embodiment of FIG. 24.

The above implementation examples are provided for illustrative purposes only, and are not limiting. Other implementation examples will be apparent to persons skilled in the relevant art(s) based on the teachings contained herein.

### 3.4.2.5 Control Signal Generator

Referring for illustrative purposes only to the UDF module 10 in FIG. 17, the down-convert and delay module 45 and the delay modules 60, 80 preferably operate according to control signals 35A-35F. Preferably, the control signals 35A-35F represent a bi-phase control signal, that is, a control signal with two phases, $\phi_1$ and $\phi_2$. Preferably, $\phi_1$ and $\phi_2$ have the same frequency and are not overlapping.

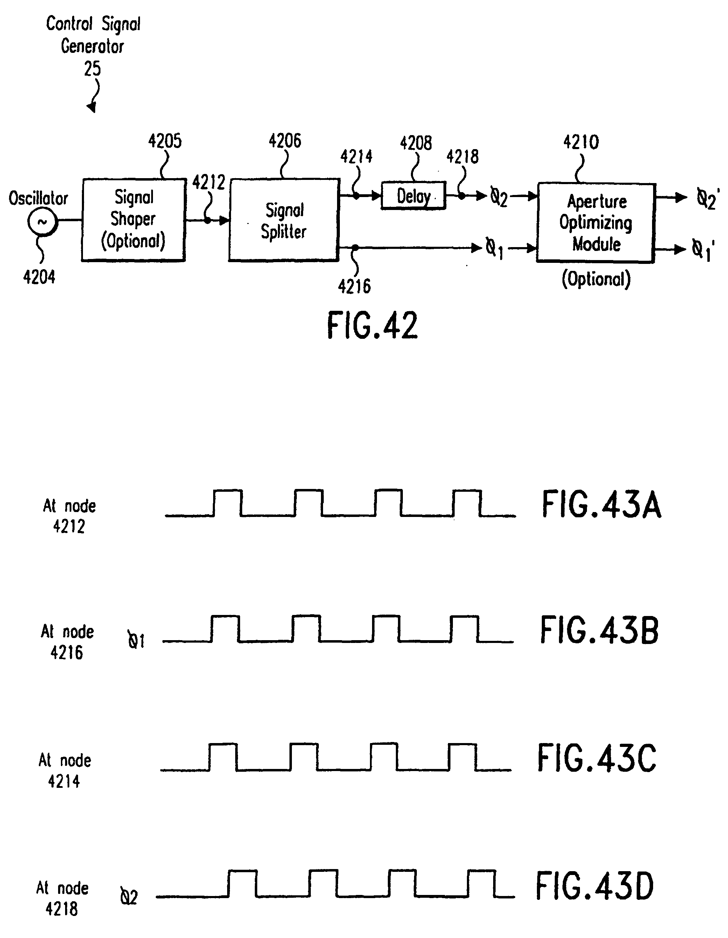

An example representation of $\phi_1$ and $\phi_2$ is shown in FIGS. 43B and 43D. Any apparatus and circuit for generating such a bi-phase control signal can be utilized with the present invention. An example implementation of a control signal generator 25 is presented in FIG. 42.

The control signal generator 25 includes an oscillator 4204 and optionally a signal shaper 4205 that generate a series of pulses at a sampling frequency is This is represented in FIG. 43A. A signal splitter 4206 splits this oscillating signal into two identical signals. An example representation of these two signals is shown in FIGS. 43B and 43C. These two signals are present at nodes 4216 and 4214, respectively, in the control signal generator 25.

The signal splitter 4206 may cause some attenuation in the signals. Consequently, some embodiments of the invention may include amplifiers.

A delay module 4208 operates to delay one of the signals so as to generate $\phi_2$ present at node 4218. This is shown in FIG. 43D.

As noted above, in some embodiments, it is useful to adjust the aperture (width) of the pulses in one or more of the control signals $\phi_1$ and/or $\phi_2$. In such embodiments, an optional aperture optimizing module 4210 performs the task of adjusting the aperture (width) of the pulses of the control signals $\phi_1$ and/or $\phi_2$. The structure and operation of an embodiment of the aperture optimizing module 4210 is described in detail in WO 00/24117.

The above implementation examples are provided for illustrative purposes only, and are not limiting. Other implementation examples will be apparent to persons skilled in the relevant art(s) based on the teachings contained herein.

### 3.4.2.6 Output Sample and Hold Module

Some embodiments of the UDF module may include an output sample and hold module. For example, the example UDF module 10 in FIG. 24 includes an output sample and hold module 82. Preferably, the output sample and hold module 82 is positioned at the output of the adder 15A.

As evident from the embodiments discussed above, the output signal VO generated by the UDF module is typically represented by the output of the adder (although there are some embodiments and applications where this is not the case). See, for example, the UDF module 10 in FIG. 17. In some implementations of the UDF module, such as that shown in FIG. 24, the value present at the output of the adder 15A may not always represent a valid instance of the output signal VO. This is due, for example, to the propagation of signals through the UDF module. The output sample and hold module 82 ensures that only valid values of the output of the adder 15A (i.e., only valid instances of the output signal VO) are presented to downstream devices external to the UDF module.

In the example of FIG. 24, the value at the output of the adder 15A is guaranteed to be valid only at rising edges of $\phi_1$. Accordingly, a switch 55G in the output sample and hold module 82 closes upon rising edges of $\phi_1$, thereby allowing the capacitor 65G in the output sample and hold module 82 to charge to the value at the output of the adder 15A. This value in the capacitor 65G is presented to an output smoothing module 84. The signal generated by the output smoothing module 84 represents the output signal VO. See, for example, cell 1550 in Table 1502, and the accompanying description provided above.

The above implementation examples are provided for illustrative purposes only, and are not limiting. Other implementation examples will be apparent to persons skilled in the relevant art(s) based on the teachings contained herein.

### 3.4. 2.7 Output Smoothing Module

Some embodiments of the UDF module may include an output smoothing module. For example, the example UDF module 10 of FIG. 24 includes an output smoothing module 82. The output smoothing module 84 operates to smooth the signal generated by the output sample and hold module 82. It is noted that the output smoothing module is an optional component.

The above implementation example is provided for illustrative purposes only, and is not limiting. Other implementation examples will be apparent to persons skilled in the relevant art(s) based on the teachings contained herein.

### 3.4.3 Implementing the UDF Module as an Integrated Circuit (IC)

The invention is direct to the UDF module implemented on an integrated circuit (IC).

Understanding of this aspect of the invention may be facilitated by considering IC fabrication technology.

The fabrication of filters typically requires very tight tolerances on component parts of the filters, such as capacitors, inductors, resistors, etc. In contrast, the UDF module does not require a high degree of accuracy on the values of elements used therein. More particularly, the UDF module does not require a high degree of accuracy on the value of any given individual circuit element used therein.

Instead, the parameters of the filters depend on the ratio of element values. This is illustrated, for example, by the above description of the switched capacitor of FIG. 31, where the scaling factor depended on the ratio of C1 to C2.

As will be appreciated by persons skilled in the relevant art(s), it is difficult with present day fabrication technology to achieve tight tolerances on individual circuit component values, especially when operating at high frequencies (such as RF and above). However, current technology allows for tight tolerances on the ratios of circuit component values. This is generally the case for all operating frequencies.. Thus, embodiments of the invention facilitate the IC fabrication process.

This aspect of the present invention is one factor that enables the UDF module to be implemented as an IC.

There are a number of additional aspects of the UDF module that enable it to be implemented as an IC.

For example, the component of the UDF module that preferably performs the frequency translation operation, i.e., the universal frequency down-conversion module, is achieved using a limited number of components. See, for example, the embodiment of FIG. 24, where the frequency down-conversion operation is being performed essentially by a switch 55A and a capacitor 65A.

Also, input filtering is preferably achieved using a limited number of components. Again, for example, see the example UDF module 10 of FIG. 24.

Further, the goals of the invention (input filtering and frequency translation) are preferably achieved without the use of large capacitors, inductors, or resistors. These aspects of the invention are discussed above.

Thus, the architecture of embodiments of the invention is friendly to integrated circuit design techniques and processes. Consequently, as will be appreciated by persons skilled in the relevant art(s) based on the teachings contained herein, any of the embodiments of the UDF module can be implemented on an integrated circuit using existing fabrication technology.

### 3.4.4 Other Implementations

The implementations described above are provided for purposes of illustration. These implementations are not intended to limit the invention. Alternate implementations, differing slightly or substantially from those described herein, will be apparent to persons skilled in the relevant art(s) based on the teachings contained herein.

*4 Designing a Unified Downconverting and Filtering (UDF) Module*

A methodology for designing a unified downconverting and filtering (UDF) module according to an embodiment of the invention shall now be described. This methodology is applicable to any of the embodiments of the UDF module discussed or contemplated herein.

It should be understood that this methodology is provided for purposes of illustration, and is not intended to limit the invention. Alternate design methodologies, differing slightly or substantially from those described herein, will be apparent to persons skilled in the relevant art(s) based on the teachings contained herein.

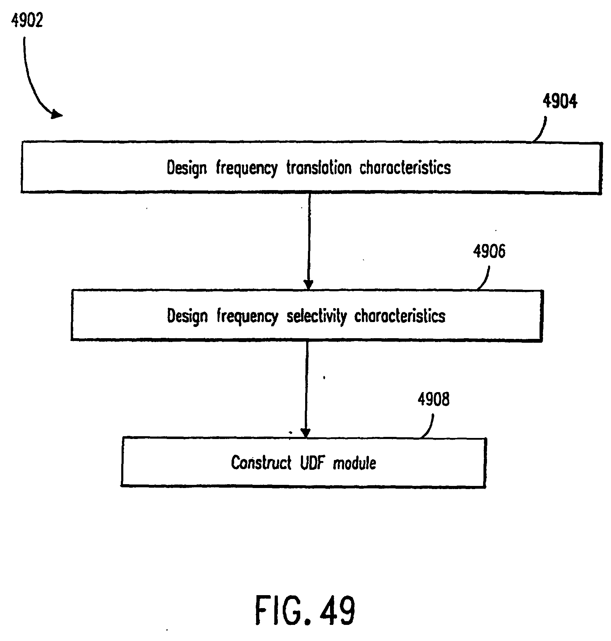

Referring now to a flowchart 4902 in FIG. 49, in step 4904, the UDF module is designed so as to exhibit desired frequency translation characteristics. Such characteristics may include, for example and without limitation, the expected frequency of the input signal and the desired frequency of the output signal. Such characteristics may also include, for example and without limitation, whether the input signal is down-converted to an IF signal, down-converted to a demodulated baseband signal, down-converted from an FM signal to a PM or an AM signal, etc.

In step 4906, the UDF module is designed so as to exhibit desired frequency selectivity characteristics. Such characteristics may include, for example and without limitation, the type of filtering to be performed by the UDF module (low pass, high pass, band pass, all pass, band stop, notch, etc.), the filtering center frequency, the filtering bandwidth, the filtering passband, etc.

It is noted that steps 4904 and 4906 may be performed in any order.

In step 4908, the UDF module is constructed in accordance with the design considerations of steps 4904 and 4906.

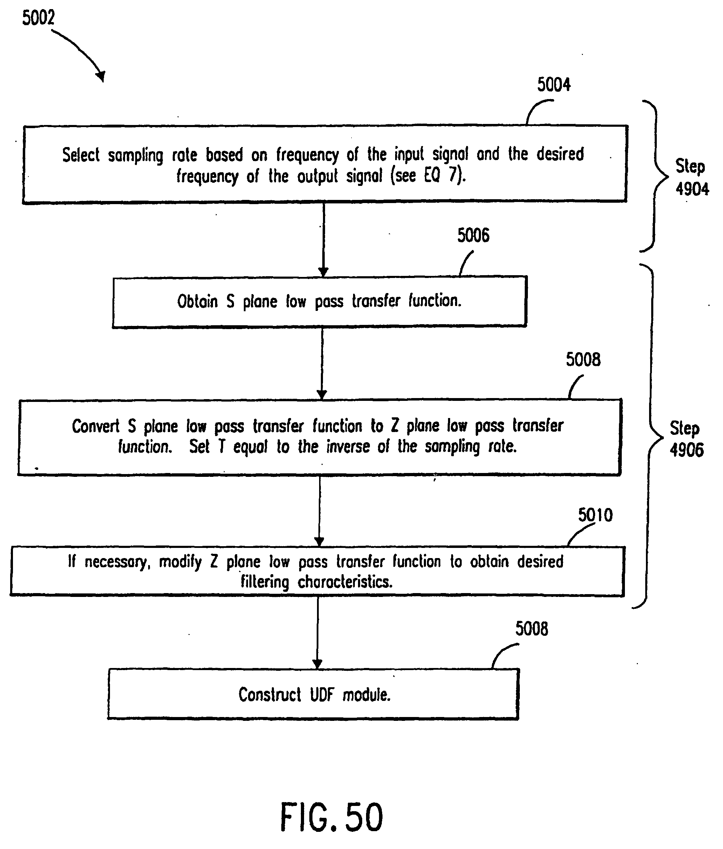

The operation of the steps of flowchart 4902 shall now be described in greater detail with reference to a flowchart 5002 in FIG. 50.

Step 4904 (designing the UDF module so as to exhibit desired frequency translation characteristics) is represented by step 5004 in FIG. 50. Preferably, the desired frequency translation characteristics of the UDF module is established by selecting the sampling rate. There may be other considerations, as described above, and further described in WO 00/24117 referenced above.

Step 4906 (designing the UDF module so as to exhibit desired frequency selectivity characteristics) is represented by steps 5006-5010 in FIG. 50, which are now described.

In step 5006, a low pass transfer function in the S plane is obtained/selected. As will be appreciated by persons skilled in the relevant art(s), it is common practice to design a filter by starting with a lowpass filter at a desired cutoff frequency. As will be further appreciated by persons skilled in the relevant art(s), there are numerous formulas and/or design tables for low pass transfer functions, including Butterworth, Chebyshev, elliptic filters, etc. Any of these may be utilized as the S plane low pass transfer function obtained/selected in step 5006.

In step 5008, the S plane low pass transfer function obtained in step 5006 is converted to a Z plane low pass transfer function. Step 5008 is preferably performed by substituting S variables in the S plane low pass transfer function with the expression provided in EQ. 8. As will be appreciated by persons skilled in the relevant art(s), other S plane to Z plane transformations exist. Any of these transformations may be used in the present invention.

$$S = \frac{2(1 - z^{-1})}{T(1 + z^{-1})} \qquad\qquad \text{EQ. 8}$$

In EQ. 8, T represents the inverse of the sampling rate (determined in step 5004). In other words, T is equal to 1/(sampling rate).

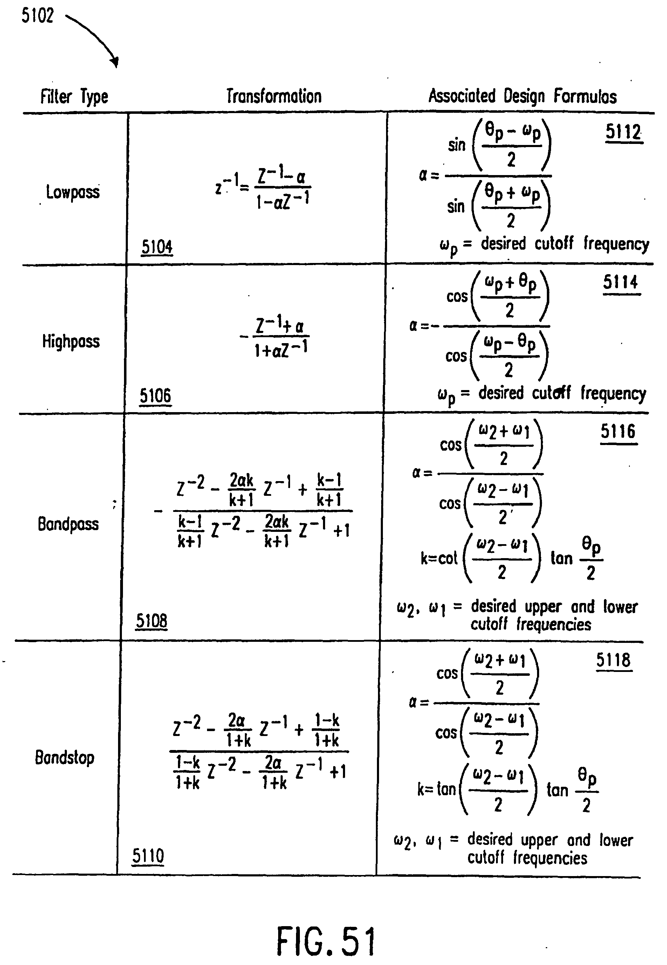

In step 5010, if necessary, the Z plane low pass transfer function is modified to obtain desired filtering characteristics. Preferably, the modifications of step 5010 are performed using any well known transformation expressions. Examples of such well known transformation expressions are provided, without limitation, in FIG. 51 (the transformation expressions of FIG. 51 are independent of the manner in which the S plane to Z plane conversion was performed in step 5008). In these expressions, $\theta_p$ represents the cutoff frequency of the S low pass transfer function obtained and modified in steps 5006 and 5008.

The table 5102 in FIG. 51 is from Oppenheim and Schafer, *Digital Signal Processing,* Prentice-Hall, New Jersey, 1975, page 230.

As will be appreciated by persons skilled in the relevant art(s), other transformation expressions exist. Any such transformations can be used by the present invention.

When using the example transformations of table 5102, it is possible to obtain a Z plane high pass transfer function from the Z plane low pass transfer function of step 5008 by using the transformation and formulas of cells 5106 and 5114. It is possible to obtain a Z plane bandpass transfer function from the Z plane low pass transfer function of step 5008 by using the transformation and formulas of cells 5108 and 5116. It is possible to obtain a Z plane bandstop transfer function from the Z plane low pass transfer function of step 5008 by using the transformation and formulas of cells 5110 and 5118. It is possible to obtain a modified Z plane lowpass transfer function from the Z plane low pass transfer function of step 5008 by using the transformation and formulas of cells 5104 and 5112.

The equations and transformations of FIG. 51 establish filtering characteristics such as the center frequency and the passband. For example, with regard to the bandpass filter, once the transformation in cell 5108 has been applied to the Z plane low pass transfer function generated in step 5008, the original low pass cutoff frequency $\theta_p$ represents the center frequency of the band pass filter. The passband of the band pass filter is defined by $\omega_1$ and $\omega_2$.

It is noted that Z plane transfer functions generated as described above with reference to steps 5006, 5008, and 5010 may differ in form and/or content from the transfer functions of EQS. 1-6. This illustrates the great flexibility, broad scope, and wide applicability of the present invention. In particular, the present invention is operable according to (i.e., the invention can be implemented in accord with) any or at least a large number of filtering transfer functions generated using any or at least a large number of procedures, as will be apparent to persons skilled in the relevant art (s) based on the teachings contained herein.

Still referring to FIG. 50, in step 4908, the UDF module is constructed in accordance with the design considerations of steps 5004-5010. Consider, for example, the UDF module 10 in FIG. 17. The number of delay elements and the arrangement of the delay elements in the UDF module 10 (such as the downconvert and delay module 45 and the delay modules 60, 80) are dictated by the delay factors in the filter transfer function produced after operation of steps 5006, 5008, and 5010. This is apparent from the discussion in prior sections. The sampling rate selected in step 5004 corresponds to the control signal 35. The constants in the filter transfer function (produced after operation of steps 5006, 5008, and 5010) are achieved by the scaling modules 70, 90 (and optionally 1790).

### 5 Adjustable UDF Module

As noted above, and referring to FIG. 17. for illustrative purposes only, the frequency translation and selectivity characteristics of the UDF module 10 are established in large part by the control signal 35 (including the sample clock) and the scaling modules 70, 90. In embodiments of the UDF module, various parameters are adjustable, including but not limited to the control signal 35 and the scaling modules 70, 90. Accordingly, frequency translation and selectivity characteristics of the UDF module that depend on the control signal 35 and the scaling modules 70, 90 are adjustable. In some embodiments, such characteristics (and perhaps others) are electronically adjustable.

Frequency translation characteristics, including but not limited to the desired frequency of the output signal, whether the input signal is down-converted to an IF signal, down-converted to a demodulated baseband signal, down-converted from an FM signal to a PM or an AM signal, etc., and whether energy transfer should be augmented during the frequency translation process, can be adjusted by adjusting, for example and without limitation, characteristics of the control signal 35 (such as rate and/or pulse aperture).

Frequency selectivity characteristics, including but not limited to the filter center frequency, the filter bandwidth, the filter passband, the filter type, etc., can be adjusted by adjusting, for example and without limitation, the scaling factors of the scaling modules 70, 80 and/or the control signal 35 (such as rate and/or pulse aperture).

The control signal can be adjusted, for example, by implementing the control signal generator 25 (FIG. 42) using a tunable oscillator, and implementing the aperture optimizing module 4210 using tunable components (such as tunable resistors, capacitors, inductors, etc.). Such tunable elements may be electrically tunable.

The scaling factors can be adjusted by implementing the scaling modules 70, 80 using adjustable components, such as tunable resistors, capacitors, inductors, etc. Such tunable elements may be electrically tunable.

The tunable devices may be manually controlled. Alternatively, embodiments of the UDF module include control modules to automatically control such tunable devices (in some embodiments, the control modules operate according to user input and/or commands). The control modules may operate in real time, such that the UDF module is dynamically tunable. The control modules maybe implemented as a software controlled processor, a state machine, etc., or combinations thereof.

### 6 Amplification

As described above, unified down-converting and filtering according to embodiments of the present invention involves both frequency down-conversion and filtering. According to embodiments of the invention, unified down-converting and filtering also includes signal amplification. This feature is discussed in this section.

Recall, for example purposes only, EQ. 2 that represents an example transfer function of a band-pass filter. (It is noted that EQ. 2 is referred to for illustrative purposes. This aspect of the invention is applicable to other transfer functions and other filter types.)

$$\frac{VO}{VI} = \frac{\alpha_1\, z}{z^2 + \beta_1 z + \beta_0} \qquad\qquad \text{EQ. 2}$$

It is possible to achieve amplification or attenuation by a factor K by scaling the numerator by K. K is a real number. Doing this for EQ. 2 yields the following:

$$\frac{VO}{VI} = \frac{K\alpha_1\, z}{z^2 + \beta_1\, z + \beta_0} \qquad\qquad \text{EQ. 9}$$

Solving for VO yields the following:

$$VO = K\alpha_1\, z^{-1}VI - \beta_1 z^{-1}VO - \beta_0\, z^{-2}VO \qquad\qquad \text{EQ. 10}$$

In embodiments of the invention, such amplification is achieved as specified by EQS. 9 and 10 by inserting a scaling module having a scale factor K in each feedforward path of the UDF module. Consider, for example, UDF module 10 in FIG. 17. A scaling module 1790 having scale factor K is inserted into each feedforward path to thereby achieve an amplification or attenuation factor of K. The scaling modules 1790 may be electrically adjustable/tunable.

Alternatively, the scale factors of scaling modules 70 are adjusted to incorporate the amplification/attenuation scale factor K. In such embodiments, the scale factors of the scaling modules 70 affect both the filtering operation and the amplification/attenuation operation.

It is noted that this feature of the invention is optional. Where amplification is not required, the scaling modules 1790 can be omitted (or their scale factors can be set to 1).

The invention supports amplification adjustment. That is, the amplification achieved by the UDF module 10 can be adjusted by adjusting the scale factors of the scaling modules 70. Such amplification adjustment can be performed statically or dynamically, and can also be performed electronically.

Such adjustment can be manually controlled, or can be automatically controlled using a processor operating according to control modules that comprise software, a hardware state machine, etc., or a combination thereof. In some embodiments, the control modules operate according to user input and/or commands.

This amplification feature of embodiments of the invention has been described in the context of the example UDF module 10 of FIG. 17 for illustrative purposes only. The amplification feature as described herein is equally applicable to other UDF modules.

### 7 Example Applications

The following sections describe applications involving the UDF module. The invention includes these applications. It should be understood that the invention is not limited to the particular applications described below. Equivalents, extensions, variations, deviations, etc., of the following will be apparent to persons skilled in the relevant art(s) based on the teachings contained herein. In particular, any application requiring the performance of at least a frequency translation operation and a frequency selectivity operation may utilize the UDF module described herein.

### 7.1 Receiver

As noted above with reference to FIG. 8, a receiver performs three primary functions: frequency translation 808, frequency selection 810, and amplification 812.

Embodiments of the unified down-converting and filtering (UDF) module perform the frequency translation operation 808 and the frequency selection module 810. In some embodiments, the frequency selection operation 810 performed by the UDF module represents input filtering at any frequency, including RF and greater frequencies. Accordingly, such embodiments of the UDF module perform the primary functions of a receiver, except for amplification.

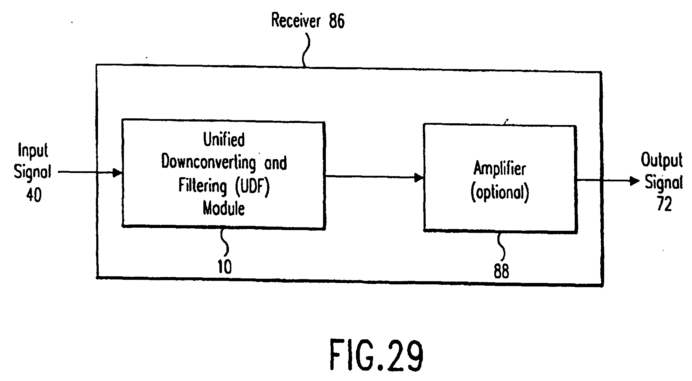

Therefore, it is possible to form a receiver in accordance with the present invention by combining the UDF module 10 with an amplifier. This is shown in FIG. 29.

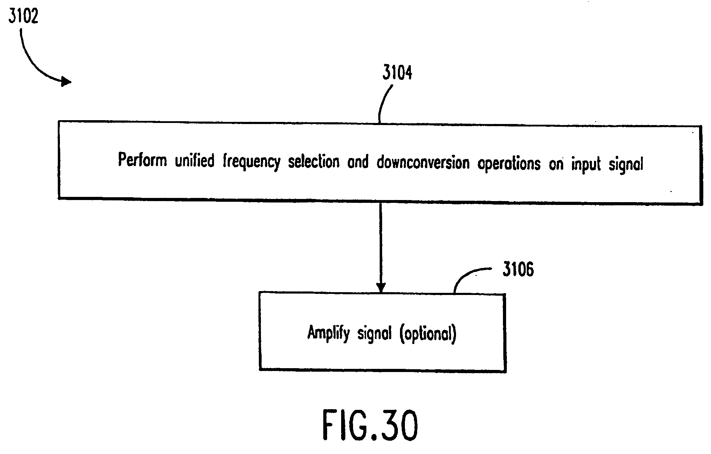

According to this receiver 86, the UDF module 10 performs unified frequency selection and conversion operations on an input signal 40 in the manner described herein. The amplifier 88 amplifies the output of the UDF module 10 to thereby generate an output signal 72. This operation of the receiver 86 is represented in a flowchart 3102 in FIG. 30.

In some applications, the level of the output signal generated by the UDF module 10 is sufficient for downstream processing. In such cases, an amplifier is not necessary. In this case, the embodiment of the UDF module 10 shown in FIG. 29 (that performs frequency selection and translation, but not amplification) is sufficient to act as a receiver.

As noted above, some UDF embodiments also perform amplification. In such embodiments, the UDF module performs the primary functions of a receiver, i.e., frequency translation 808, frequency selection 810, and amplification 812. In such embodiments, the UDF module alone is sufficient to act as a receiver.

As will be apparent to persons skilled in the relevant art(s), the receiver 86 can be implemented on an integrated circuit (IC). As discussed above, the UDF module can be implemented on an IC. Depending on the application, the UDF module performs most, if not all, of the functions required of a receiver. Accordingly, it follows that any receiver implemented using an embodiment of the UDF module can be implemented on an IC. Embodiments of the present invention are directed to such receivers implemented on an IC.

### 8 Conclusion

Example implementations of the systems and components of the invention have been described herein. As noted elsewhere, these example implementations have been described for illustrative purposes only, and are not limiting. Other implementation embodiments are possible, such as but not limited to software and software/hardware implementations of the systems and components of the invention. Such implementation embodiments will be apparent to persons skilled in the relevant art(s) based on the teachings contained herein.

While various application embodiments of the present invention have been described above, it should be understood that they have been presented by way of example only, and not limitation. Thus, the breadth and scope of the present invention should not be limited by any of the above-described exemplary embodiments, but should be defined only in accordance with the following claims.

### Claims

1. Apparatus for down-converting and filtering an input signal (40; 18) having a carrier frequency, comprising:

   a) sampling means (45) for sampling the input signal (40; 18) at a sampling frequency of less than twice the carrier frequency to produce an input sample of a down-converted image (22) of the input signal (40; 18), wherein said sampling means (45) includes a switch (55) and a capacitor (65), wherein said switch (55) undersamples said input signal (40; 18) according to a control signal (35), and wherein the control signal (35) includes pulses having non-negligible pulse widths, wherein said pulses cause said switch (55) to close and sub-sample the input signal (40; 18) over said pulses, wherein energy is transferred from the input signal (40; 18) and stored using said capacitor (65) during said pulses, and wherein the downconverted image (22) is generated from the transferred energy;
   b) delaying means (80) for generating one or more delayed instances of an output signal (50); and
   c) combining means (15) for combining at least the input sample with the one or more delayed instances of the output signal (50) to generate an instance of the output signal (50).

2. Apparatus according to claim 1, wherein the input sample is an analog signal and the delayed instances are analog signals.

3. Apparatus according to any preceding claim, wherein the delayed instances are delayed by an integral number of sampling periods of the sampling means (45).

4. Apparatus according to any preceding claim, wherein the sampling frequency is an integral sub-multiple of the carrier frequency.

5. Apparatus according to any preceding claim, wherein the delaying means (80) includes one or more sample-and-hold circuits (4501, 4503).

6. Apparatus according to any preceding claim, wherein the combining means (15) includes a summer (3804; 4004).

7. Apparatus according to any preceding claim, further including means (70, 90) for scaling at least one of the input sample and the one or more delayed instances of the output signal (50).

8. Apparatus according to any preceding claim, wherein the input signal (40; 18) is a radio frequency signal.

9. Apparatus according to any preceding claim, wherein the sampling means (45) delays the input sample.

10. Apparatus according to any preceding claim, wherein the storage of energy using said capacitor substantially prevents accurate voltage reproduction of the input signal (40; 18) during said pulses.

11. A method for down-converting and filtering an input signal (40; 18) having a carrier frequency, comprising the steps of:

a) sampling (1606; 1806) the input signal (40; 18) at a sampling frequency of less than twice the carrier frequency to produce an input sample of a down-converted image (22) of the input signal (40; 18);
b) delaying (1810, 1814) an output signal to generate one or more delayed instances of the output signal (50); and
c) combining (1818) at least the input sample with the one or more delayed instances of the output signal (50) to generate an instance of the output signal (50); wherein step a) includes the steps of:

(i) under-sampling the input signal (40; 18) according to a control signal (35), wherein the control signal (35) includes pulses having non-negligible pulse widths;
(ii) transferring energy from the input signal (40; 18) during the pulses;
(iii) storing the transferred energy during the pulses; and
(iv) generating the down-converted image (22) from the transferred energy.

12. The method according to claim 11, wherein the input sample is an analog signal, and wherein step b) includes the step of storing the one or more delayed instances as analog signals.

13. The method according to claim 11 or 12, wherein the delayed instances are delayed by an integral number of the sampling periods.

14. The method according to any one of claims 11 to 13, wherein step a) includes the step of sampling (1606; 1806) the input signal (40; 18) at the sampling frequency, wherein the sampling frequency is an integral sub-multiple of the carrier frequency.

15. The method according to any one of claims 11 to 14, wherein step c) includes the step of summing the input sample with the one or more delayed instances of the output signal (50) to generate an instance of the output signal (50).

16. The method according to any one of claims 11 to 15, further including the step of scaling (1808, 1812, 1816) at least one of the input sample and the one or more delayed instances of the output signal (50).

17. The method according to any one of claims 11 to 16, further including the step of receiving the input signal (40; 18), wherein the input signal (40; 18) is a radio frequency signal.

18. The method according to any one of claims 11 to 17, further including the step of:

d) adjusting at least one frequency selectivity characteristic.

19. The method according to claim 18, wherein step d) includes the step of:

(i) tuning one of a filter centre frequency, a filter bandwidth, and a filter passband.

20. The method according to any one of claims 11 to 19, wherein step a) includes the step of delaying (1608; 1806) the input sample.

21. The method according to any one of claims 11 to 20, wherein the storage of energy substantially prevents accurate voltage reproduction of the input signal (40; 18) during said pulses.

**Patentansprüche**

1. Vorrichtung zum Abwärtsmischen und Filtern eines Eingangssignals (40; 18) mit einer Trägerfrequenz, mit:

   a) einer Abtasteinrichtung (45) zum Abtasten des Eingangssignals (40; 18) mit einer Abtastfrequenz von weniger als der zweifachen Trägerfrequenz, um einen Eingangsabtastwert eines abwärtsgemischten Bildes (22) des Eingangssignals (40; 18) zu erzeugen, wobei die Abtasteinrichtung (45) einen Schalter (55) und einen Kondensator (65) aufweist, wobei der Schalter (55) das Eingangssignal (40; 18) entsprechend einem Steuersignal (35) unterabtastet und wobei das Steuersignal (35) Impulse mit nicht vernachlässigbaren Impulsbreiten aufweist, wobei diese Impulse bewirken, dass sich der Schalter (55) schließt und das Eingangssignal (40; 18) über diese Impulse unterabgetastet wird, wobei während dieser Impulse Energie von dem Eingangssignal (40; 18) übertragen und unter Verwendung des Kondensators (65) gespeichert wird und wobei das abwärtsgemischte Bild (22) aus der übertragenen Energie erzeugt wird;
   b) einer Verzögerungseinrichtung (80) zum Erzeugen einer oder mehrerer verzögerter Instanzen eines Ausgangssignals (50); und mit
   c) einer Kombinationseinrichtung (15) zum Kombinieren von mindestens dem Eingangsabtastwert mit der einen oder den mehreren verzögerten Instanzen des Ausgangssignals (50), um eine Instanz des Ausgangssignals (50) zu erzeugen.

2. Vorrichtung nach Anspruch 1, wobei der Eingangsabtastwert ein analoges Signal und die verzögerten Instanzen analoge Signale sind.

3. Vorrichtung nach einem der vorhergehenden Ansprüche, wobei die verzögerten Instanzen um eine ganze Anzahl von Abtastperioden der Abtasteinrichtung (45) verzögert werden.

4. Vorrichtung nach einem der vorhergehenden Ansprüche, wobei die Abtastfrequenz ein ganzzahliger Bruchteil der Trägerfrequenz ist.

5. Vorrichtung nach einem der vorhergehenden Ansprüche, wobei die Verzögerungseinrichtung (80) eine oder mehrere Abtast-Halte-Schaltungen (4501, 4503) aufweist.

6. Vorrichtung nach einem der vorhergehenden Ansprüche, wobei die Kombinationseinrichtung (15) ein Summierglied (3804; 4004) aufweist.

7. Vorrichtung nach einem der vorhergehenden Ansprüche, die ferner Einrichtungen (70, 90) zum Skalieren des Eingangsabtastwerts und/oder der einen und/oder den mehreren verzögerten Instanzen des Ausgangssignals (50) aufweist.

8. Vorrichtung nach einem der vorhergehenden Ansprüche, wobei das Eingangssignal (40; 18) ein Funkfrequenzsignal ist.

9. Vorrichtung nach einem der vorhergehenden Ansprüche, wobei die Abtastvorrichtung (45) den Eingangsabtastwert verzögert.

10. Vorrichtung nach einem der vorhergehenden Ansprüche, wobei die Energiespeicherung unter Verwendung des Kondensators während den Impulsen im wesentlichen eine genaue Spannungsreproduktion des Eingangssignals (40; 18) verhindert.

11. Verfahren zum Abwärtsmischen und Filtern eines Eingangssignals (40; 18) mit einer Trägerfrequenz, das die folgenden Schritte aufweist:

    a) Abtasten (1606; 1806) des Eingangssignals (40; 18) mit einer Abtastfrequenz von weniger als der zweifachen Trägerfrequenz, um einen Eingangsabtastwert eines abwärtsgemischten Bildes (22) des Eingangssignals (40; 18) zu erzeugen;
    b) Verzögern (1810, 1814) eines Ausgangssignals, um ein oder mehrere verzögerte Instanzen des Ausgangssignals (50) zu erzeugen; und
    c) Kombinieren (1818) von mindestens dem einen Eingangsabtastwert mit der einen oder den mehreren verzögerten Instanzen des Ausgangssignals (50), um eine Instanz des Ausgangssignals (50) zu erzeugen; wobei der Schritt a) die folgenden Schritte aufweist:

(i) Unterabtasten des Eingangssignals (40; 18) entsprechend einem Steuersignal (35), wobei das Steuersignal (35) Impulse mit nicht vernachlässigbaren Impulsbreiten aufweist;
(ii) Übertragen von Energie von dem Eingangssignal (40; 18) während der Impulse;
(iii) Speichern der übertragenen Energie während der Impulse; und
(iv) Erzeugen des abwärtsgemischten Bildes (22) aus der übertragenen Energie.

12. Verfahren nach Anspruch 11, wobei das Eingangssignal ein analoges Signal ist und wobei der Schritt b) den Schritt zum Speichern von einer oder mehreren verzögerten Instanzen als analoge Signale aufweist.

13. Verfahren nach Anspruch 11 oder 12, wobei die verzögerten Instanzen um eine ganzzahlige Anzahl von Abtastperioden verzögert werden.

14. Verfahren nach einem der Ansprüche 11 bis 13, wobei der Schritt a) den Schritt zum Abtasten (1606; 1806) des Eingangssignals (40; 18) mit der Abtastfrequenz aufweist, wobei die Abtastfrequenz ein ganzzahliger Bruchteil der Trägerfrequenz ist.

15. Verfahren nach einem der Ansprüche 11 bis 14, wobei der Schritt c) den Schritt zum Summieren des Eingangsabtastwerts mit der einen oder den mehreren verzögerten Instanzen des Ausgangssignals (50) aufweist, um eine Instanz des Ausgangssignals (50) zu erzeugen.

16. Verfahren nach einem der Ansprüche 11 bis 15, das ferner den Schritt zum Skalieren (1808, 1812, 1816) von mindestens dem Eingangsabtastwert und der einen oder den mehreren verzögerten Instanzen des Ausgangssignals (50) aufweist.

17. Verfahren nach einem der Ansprüche 11 bis 16, das ferner den Schritt zum Empfangen des Eingangssignals (40; 18) aufweist, wobei das Eingangssignal (40; 18) ein Funkfrequenzsignal ist.

18. Verfahren nach einem der Ansprüche 11 bis 17, das ferner den Schritt aufweist:

d) Einstellen mindestens einer Frequenzselektivitätseigenschaft.

19. Verfahren nach Anspruch 18, wobei der schritt d) den folgenden Schritt aufweist:

(i) Abstimmen einer Filtermittenfrequenz und/oder einer Filterbandbreite und/oder eines Filterpaßbands.

20. Verfahren nach einem der Ansprüche 11 bis 19, wobei der Schritt a) den Schritt zum Verzögern (1808; 1806) des Eingangsabtastwerts aufweist.

21. Verfahren nach einem der Ansprüche 11 bis 20, wobei die Energiespeicherung während den Impulsen im wesentlichen eine genaue Spannungsreproduktion des Eingangssignals (40; 18) verhindert.

**Revendications**

1. Appareil pour abaisser en fréquence et filtrer un signal d'entrée (40 ; 18) ayant une fréquence de porteuse, comprenant :

a) un moyen d'échantillonnage (45) pour échantillonner le signal d'entrée (40 ; 18) avec une fréquence d'échantillonnage inférieure à deux fois la fréquence de porteuse pour produire un échantillon d'entrée d'une image abaissée en fréquence (22) du signal d'entrée (40 ; 18), dans lequel ledit moyen d'échantillonnage (45) comporte un interrupteur (55) et un condensateur (65), dans lequel ledit interrupteur (55) sous-échantillonne ledit signal d'entrée (40 ; 18) selon un signal de commande (35), et dans lequel le signal de commande (35) comporte des impulsions ayant une largeur d'impulsion non négligeable, dans lequel lesdites impulsions font fermer ledit interrupteur (55) et lui font sous-échantillonner le signal d'entrée (40 ; 18) sur lesdites impulsions, dans lequel de l'énergie est transférée depuis le signal d'entrée (40 ; 18) et stockée en utilisant ledit condensateur (65) pendant lesdites impulsions, et dans lequel l'image abaissée en fréquence (22) est générée à partir de l'énergie transférée ;

b) un moyen de retard (80) pour générer un ou plusieurs cas retardés d'un signal de sortie (50) ; et

c) un moyen de combinaison (15) pour combiner au moins l'échantillon d'entrée avec le ou les cas retardé(s) du signal de sortie (50) pour générer un cas du signal de sortie (50).

2. Appareil selon la revendication 1, dans lequel l'échantillon d'entrée est un signal analogique et les cas retardés sont des signaux analogiques.

3. Appareil selon l'une quelconque des revendications précédentes, dans lequel les cas retardés sont retardés d'un nombre entier de périodes d'échantillonnage du moyen d'échantillonnage (45).

4. Appareil selon l'une quelconque des revendications précédentes, dans lequel la fréquence d'échantillonnage est un sous-multiple entier de la fréquence porteuse.

5. Appareil selon l'une quelconque des revendications précédentes, dans lequel le moyen de retard (80) comporte un ou plusieurs circuits échantillonneurs bloqueurs (4501, 4503).

6. Appareil selon l'une quelconque des revendications précédentes, dans lequel le moyen de combinaison (15) comporte un sommateur (3804 ; 4004).

7. Appareil selon l'une quelconque des revendications précédentes, comprenant en outre un moyen (70, 90) servant à mettre à l'échelle au moins un élément parmi l'échantillon d'entrée et le ou les cas retardé(s) du signal de sortie (50).

8. Appareil selon l'une quelconque des revendications précédentes, dans lequel le signal d'entrée (40 ; 18) est un signal radio.

9. Appareil selon l'une quelconque des revendications précédentes, dans lequel le moyen d'échantillonnage (45) retarde l'échantillon d'entrée.

10. Appareil selon l'une quelconque des revendications précédentes, dans lequel le stockage d'énergie utilisant ledit condensateur empêche substantiellement la reproduction précise de tension du signal d'entrée (40 ; 18) pendant lesdites impulsions.

11. Procédé permettant d'abaisser en fréquence et de filtrer un signal d'entrée (40 ; 18) ayant une fréquence de porteuse, comprenant les étapes consistant à :

a) échantillonner (1606 ; 1806) le signal d'entrée (40 ; 18) avec une fréquence d'échantillonnage inférieure à deux fois la fréquence de porteuse pour produire un échantillon d'entrée d'une image abaissée en fréquence (22) du signal d'entrée (40 ; 18) ;

b) retarder (1810, 1814) un signal de sortie pour générer un ou plusieurs cas retardés du signal de sortie (50) ; et

c) combiner (1818) au moins l'échantillon d'entrée avec le ou les cas retardé(s) du signal de sortie (50) pour générer un cas du signal de sortie (50) ; dans lequel l'étape a) comprend les étapes consistant à :

(i) sous-échantillonner le signal d'entrée (40 ; 18) selon un signal de commande (35), dans lequel le signal de commande (35) comporte des impulsions ayant une largeur d'impulsion non négligeable ;

(ii) transférer de l'énergie depuis le signal d'entrée (40 ; 18) pendant les impulsions ;

(iii) stocker l'énergie transférée pendant les impulsions ; et

(iv) générer l'image abaissée en fréquence (22) à partir de l'énergie transférée.

12. Procédé selon la revendication 11, dans lequel l'échantillon d'entrée est un signal analogique, et dans lequel l'étape b) comprend l'étape consistant à stocker le ou les cas retardé(s) sous la forme de signaux analogiques.

13. Procédé selon la revendication 11 ou 12, dans lequel les cas retardés sont retardés d'un nombre entier de périodes d'échantillonnage.

14. Procédé selon l'une quelconque des revendications 11 à 13, dans lequel l'étape a) comprend l'étape consistant à échantillonner (1606 ; 1806) le signal d'entrée (40; 18) avec la fréquence d'échantillonnage, où la fréquence d'échantillonnage est un sous-multiple entier de la fréquence porteuse.

15. Procédé selon l'une quelconque des revendications 11 à 14, dans lequel l'étape c) comprend l'étape consistant à additionner l'échantillon d'entrée avec le ou les cas retardé(s) du signal de sortie (50) pour générer un cas du signal de sortie (50).

16. Procédé selon l'une quelconque des revendications 11 à 15, comprenant en outre l'étape consistant à mettre à l'échelle (1808, 1812, 1816) au moins un élément parmi l'échantillon d'entrée et le ou les cas retardé(s) du signal de sortie (50).

17. Procédé selon l'une quelconque des revendications 11 à 16, comprenant en outre l'étape consistant à recevoir le signal d'entrée (40 ; 18), dans lequel le signal d'entrée (40 ; 18) est un signal radio.

18. Procédé selon l'une quelconque des revendications 11 à 17, comprenant en outre l'étape consistant à :

   d) régler au moins une caractéristique de sélectivité de fréquence.

19. Procédé selon la revendication 18, dans lequel l'étape d) comprend l'étape consistant à :

   i) accorder un paramètre parmi une fréquence centrale de filtre, une largeur de bande de filtre et une bande passante de filtre.

20. Procédé selon l'une quelconque des revendications 11 à 19, dans lequel l'étape a) comprend l'étape consistant à retarder (1608 ; 1806) l'échantillon d'entrée.

21. Procédé selon l'une quelconque des revendications 11 à 20, dans lequel le stockage d'énergie empêche substantiellement la reproduction précise de tension du signal d'entrée (40 ; 18) pendant lesdites impulsions.

FIG.1

Related Art

202

Operation of a Conventional
Receiver ~ 204

Filter (using a wideband filter) the RF spectrum to select
a frequency band ~ 206

Amplify the filtered RF
spectrum ~ 208

Down-convert the RF spectrum to an IF signal by mixing
the RF spectrum with a local oscillator (LO) signal ~ 210

Filter (using a narrowband filter) the IF signal to
select a channel ~ 212

Amplify the filtered IF
signal ~ 214

# FIG.2
Related Art

FIG.3
Related Art

EP 1 135 853 B1

Amplitude
A1
A2
421
420
RF Spectrum
114
(at node
118)

FIG.4A
Related Art

f1  f2  f3  f4  Frequency

Amplitude
Band Select
Bandwidth
402

FIG.4B
Related Art

f1  f2  fc  f3  f4  Frequency

Amplitude
A1
A2
421
420
Band Select Filtered
Spectrum 408
(at node 120)

FIG.4C
Related Art

f1  f2  f3  f4  Frequency

Amplitude
A3
A4
421
404B
420
404A
A5 404C
404D
Processed Spectrum
410
(at node 122)

FIG.4D
Related Art

f5  f6  f7  f8  Frequency

39

Amplitude

Channel Select
Bandwidth 406

f5    f6    f7    f8    Frequency

FIG. 4E
Related Art

Amplitude

A4

A5

404C

420

Channel Select
Filtered Signal
412
(at node 124)

f5    f6    f7    f8    Frequency

FIG. 4F
Related Art

Amplitude

A6

A7

404C

420

IF Signal
116
(at node 130)

f5    f6    f7    f8    Frequency

FIG. 4G
Related Art

$$Q = \text{Quality Factor} = \frac{f_c}{BW}$$

# FIG.5
### Related Art

Amplitude

Low Pass
Filter

602

Frequency

**FIG.6A**
Related Art

Amplitude

High Pass
Filter

604

Frequency

**FIG.6B**
Related Art

Amplitude

Band Pass
Filter

606

Frequency

**FIG.7**
Related Art

Amplitude

Notch
Filter

608

Frequency

**FIG.8**
Related Art

Phase Modulation Example
702

**FIG.9**

Related Art

Frequency Modulation Example
704

**FIG.10**

Related Art

Amplitude. Modulation Example
706

**FIG.11**

Related Art

Receiver
802

808

Frequency
Translation

810

Input
Spectrum → Frequency Selection → Output
Signal
804 806

812

Amplification

FIG.12

Output Signal 50

Unified Downconverting
and Filtering (UDF) Module
10

1202

frequency
selectivity

1302

1204

frequency
translation

**FIG.13**

Input
Signal
40

45

1402

1404

Unified frequency selection
and downconversion

1406

Generate the output signal from samples of the input signal and
instances of the output signal

# FIG.14

1502

| Time Node | t (rising edge of $\phi_1$) | t-1 (rising edge of $\phi_2$) | t (rising edge of $\phi_1$) | t (rising edge of $\phi_2$) | t+1 (rising edge of $\phi_1$) |
|---|---|---|---|---|---|
| 2602 | $VI_{t-1}$ <u>1504</u> | $VI_{t-1}$ <u>1508</u> | $VI_t$ <u>1516</u> | $VI_t$ <u>1526</u> | $VI_{t+1}$ <u>1538</u> |
| 2604 | — | $VI_{t-1}$ <u>1510</u> | $VI_{t-1}$ <u>1518</u> | $VI_t$ <u>1528</u> | $VI_t$ <u>1540</u> |
| 2606 | $VO_{t-1}$ <u>1506</u> | $VO_{t-1}$ <u>1512</u> | $VO_t$ <u>1520</u> | $VO_t$ <u>1530</u> | $VO_{t+1}$ <u>1542</u> |
| 2608 | — | $VO_{t-1}$ <u>1514</u> | $VO_{t-1}$ <u>1522</u> | $VO_t$ <u>1532</u> | $VO_t$ <u>1544</u> |
| 2610 | — <u>1507</u> | — | $VO_{t-1}$ <u>1524</u> | $VO_{t-1}$ <u>1534</u> | $VO_t$ <u>1546</u> |
| 2612 | — | — <u>1515</u> | — | $VO_{t-1}$ <u>1536</u> | $VO_{t-1}$ <u>1548</u> |
| 2618 | — | — | — | — | $VI_t -$ <u>1550</u> $0.1 \cdot VO_t - 0.8 \cdot VO_{t-1}$ |

FIG.15

EP 1 135 853 B1

1602

Unified frequency selection
and downconversion ⟞ 1604

↓

Sample the input signal ⟞ 1606

↓

Hold (delay) the input sample ⟞ 1608

↓

1610

Combine one or more delayed input samples (possibly
scaled) with one or more delayed instances of the output
signal (possibly scaled) to generate the current instance of
the output signal

Step
1406

FIG.16

FIG.17

Unified Downconverting and filtering (UDF) module 10

Input Filter 20

Frequency Translator 30

Input Signal 40

Output Signal 50

Downconvert and Delay Module 45

Control Signal 35A

Scaling Module 70A

Delay Module 60A

Control Signal 35B

Scaling Module 70B

Delay Module 60B

Control Signal 35C

Scaling Module 70C

Adder 15

1712

1790

1790

1790

1718

Delay Module 80A

Control Signal 35D

Scaling Module 90A

Delay Module 80B

Control Signal 35E

Scaling Module 90B

Delay Module 80C

Control Signal 35F

Scaling Module 90C

Control Signal Generator 25

Control Signal 35A-F

1802

```
┌─────────────────────────────────┐
│     Unified frequency selection  │
│       and downconversion         │──── 1804
│           (bandpass)             │
└─────────────────────────────────┘
                 │
                 ▼
┌─────────────────────────────────────────────────────────┐           ⎫  Steps
│ At time t-1, the input signal is under-sampled (the sample is an instance │── 1806    ⎬  1606
│ of a downconverted image of the input signal).  The input sample is held. │           ⎬  and
└─────────────────────────────────────────────────────────┘           ⎭  1608
                 │
                 ▼
     ┌─────────────────────────────────────────────┐                   ⎫
     │ At t, the input sample that has been held/delayed │── 1808           ⎪
     │ by one time unit ($VI_{t-1}$) is released and scaled. │                ⎪
     └─────────────────────────────────────────────┘                   ⎪
                 │                                                       ⎪
                 ▼                                                       ⎪
   ┌─────────────────────────────────────────────────┐                 ⎪
   │ At t, an instance of the output signal that has been held/ │── 1810    ⎪
   │ delayed by one time unit ($VO_{t-1}$) is released. │                     ⎪
   └─────────────────────────────────────────────────┘                 ⎪
                 │                                                       ⎪
                 ▼                                                       ⎪  Step
          ┌──────────────────────────────┐                              ⎬  1610
          │ At t, $VO_{t-1}$ is scaled.    ; │── 1812                      ⎪
          └──────────────────────────────┘                              ⎪
                 │                                                       ⎪
                 ▼                                                       ⎪
   ┌─────────────────────────────────────────────────┐                 ⎪
   │ At t, an instance of the output signal that has been held/ │── 1814    ⎪
   │ delayed by two time units ($VO_{t-2}$) is released. │                   ⎪
   └─────────────────────────────────────────────────┘                 ⎪
                 │                                                       ⎪
                 ▼                                                       ⎪
          ┌──────────────────────────────┐                              ⎪
          │ At t, $VO_{t-2}$ is scaled.      │── 1816                      ⎪
          └──────────────────────────────┘                              ⎪
                 │                                                       ⎪
                 ▼                                                       ⎪
   ┌─────────────────────────────────────────────────┐                 ⎪
   │ At t, $VI_{t-1}$ is combined with the scaled $VO_{t-1}$ and the │── 1818    ⎪
   │ scaled $VO_{t-2}$ to generate the current instance of the │               ⎪
   │ output signal, $VO_t$. │                                           ⎭
   └─────────────────────────────────────────────────┘
```

FIG.18

FIG.19

2002

| Time / Value | t-2 | t-1 | t | t+1 |
|---|---|---|---|---|
| Value held in Downconvert and Delay Module | $VI_{t-2}$ | $VI_{t-1}$  _2004_ | $VI_t$ | $VI_{t+1}$ |
| Value at node 1902 | $\alpha_1 * VI_{t-3}$ | $\alpha_1 * VI_{t-2}$ | $\alpha_1 * VI_{t-1}$  _2006_ | $\alpha_1 * VI_t$ |
| Value of Output Signal VO | $VO_{t-2} = \alpha_1 * VI_{t-3} - B_1 * VO_{t-3} - B_0 * VO_{t-4}$ | $VO_{t-1} = \alpha_1 * VI_{t-2} - B_1 * VO_{t-2} - B_0 * VO_{t-3}$ | $VO_t = \alpha_1 * VI_{t-1} - B_1 * VO_{t-1} - B_0 * VO_{t-2}$  _2008_ | $VO_{t+1} = \alpha_1 * VI_t - B_1 * VO_t - B_0 * VO_{t-1}$ |
| Value held in First Delay Module | $VO_{t-2}$ | $VO_{t-1}$ | $VO_t$  _2010_ | $VO_{t+1}$ |
| Value at node 1904 | $-B_1 \cdot VO_{t-3}$ | $-B_1 \cdot VO_{t-2}$ | $-B_1 \cdot VO_{t-1}$  _2012_ | $-B_1 \cdot VO_t$ |
| Value held in Second Delay Module | $VO_{t-3}$ | $VO_{t-2}$ | $VO_{t-1}$  _2014_ | $VO_t$ |
| Value at node 1906 | $-B_0 \cdot VO_{t-4}$ | $-B_0 \cdot VO_{t-3}$ | $-B_0 \cdot VO_{t-2}$  _2016_ | $-B_0 \cdot VO_{t-1}$ |

FIG.20

Filter 2102

$\alpha_2$    2106
$B_2$

Vin

$z-1$ 2104        2104 $z-1$

$\alpha_1$        $B_1$

2104        2104
$z-1$        $z-1$

$\alpha_0$        $B_0$

Vo

## FIG. 21
### Related Art

2202

Unified frequency selection
and downconversion (low pass) — 2204

At time t-2, the input signal is under-sampled (the sample is an instance of a downconverted image of the input signal). The input sample is held. — 2206 } Steps 1606 and 1608

At t, the input sample that has been held/delayed by two time units $(VI_{t-2})$ is released. — 2208

At t, $VI_{t-2}$ is scaled. — 2210

At t, an instance of the output signal that has been held/delayed by one time unit $(VO_{t-1})$ is released. — 2212

At t, $VO_{t-1}$ is scaled. — 2214 } Step 1610

At t, an instance of the output signal that has been held/delayed by two time units $(VO_{t-2})$ is released. — 2216

At t, $VO_{t-2}$ is scaled. — 2218

At t, $VI_{t-2}$ is combined with the scaled $VO_{t-1}$ and the scaled $VO_{t-2}$ to generate the current instance of the output signal, $VO_t$. — 2220

FIG.22

FIG.23

**FIG.24**

$$t: = 1..16000$$

$$\omega s: = 2 \cdot \pi$$

$$Zp(t):= \cos\left(\frac{t \cdot \omega s}{16000}\right) + i \cdot \sin\left(\frac{t \cdot \omega s}{16000}\right)$$

$$Hz(t):= \frac{Zp(t)}{Zp(t)^2 + (.1 \cdot Zp(t)) + .8}$$

2702

## FIG.25

2704

Z Plane frequency response

897 MHz    900.2 MHz

amplitude
$|Hz(t)|$

10

5

1

.57

0.1

0    2000    4000    6000    8000    $1 \cdot 10^4$    $1.2 \cdot 10^4$    $1.4 \cdot 10^4$    $1.6 \cdot 10^4$

t

frequency (kHz)

## FIG.26

FIG.27A — V(GAIN2:OUT) at node 2604

FIG.27B — V(GAIN7:OUT) at node 2614

FIG.27C — V(SUM1:IN2) at node 2616

FIG.27D — V(R8:2) at node 2618

FIG.27E — V(C15:2) at node 2620

$f_{in} = 900.2$ MHz
$f_s = 16$ MHz

VI

* C:\MSim_8\Projects\sample\digbp.sch

Temperature: 27.0

(A) digbp.dot

V(V4:+)

Page 1

900.2 MHz
2 volts peak-to-peak
1 volt amplitude

Time: 14:01:11

FIG.27F

FIG.28A — at node 2604 — V(GAIN2:OUT)

FIG.28B — at node 2614 — V(GAIN7:OUT)

FIG.28C — at node 2616 — V(GAIN7:OUT)

FIG.28D — at node 2618 — V(SUM1:IN2)

FIG.28E — at node 2620 — V(R8:2)

V(C15:2)

$f_{in} = 897$ MHz
$f_s = 16$ MHz

Time

Date/Time run: 10/08/98 13:55:38   * C:\MSim_8\Projects\sample\digbp.sch   Temperature: 27.0

(A) digbp.dat

Date: October 08, 1998   Page 1   Time: 13:58:34

FIG.28F

897 MHz
2 volts peak-to-peak
1 volt amplitude

EP 1 135 853 B1

Receiver 86

Input
Signal
40

Unified
Downconverting and
Filtering (UDF)
Module

10

Amplifier
(optional)

88

Output
Signal
72

FIG.29

EP 1 135 853 B1

3102

3104

Perform unified frequency selection and downconversion operations on input signal

3106

Amplify signal (optional)

FIG.30

Delay Module
60,80
(Switched Capacitor)

## FIG.31

$$V_2 = \frac{C1}{C2} \cdot V_1$$

FIG.32

FIG.33

Delay Module
60,80

Analog
Delay Line

3404

FIG.34

Scaling
Module 70,90

Resistor
Attenuator

3504

FIG.35

Resistor
Attenuator
3504

$V_1$

$R_1$

$V_2$

$R_2$

$V_2 = \dfrac{R_2}{R_1 + R_2} V_1$

FIG.36

Scaling Module
70,90

Amplifier
(Attenuator)

3704

FIG.37

Summer
15

Resistive
Summer

$V_1$
$V_2$
$V_N$

$V_0$

3804

FIG.38

Resistive
Summer
3804

$V_2$

$V_0 = \alpha_1 V_1 + \alpha_2 V_2 + \alpha_3 V_3$

$V_1$

$V_3$

FIG.39

Summer
15

Op Amp
Summer

$V_1$

$V_2$

$V_N$

$V_O$

4004

FIG.40

Op Amp
Summer
4004

$R_4$

$V_1$    $R_1$

$V_2$    $R_2$

$V_3$    $R_3$

$V_O = -R_4 \left( \dfrac{V_1}{R_1} + \dfrac{V_2}{R_2} + \dfrac{V_3}{R_3} \right)$

FIG.41

Control Signal
Generator
25

Oscillator

4205
Signal
Shaper
(Optional)

4212

4206
Signal
Splitter

4214

4208
Delay

4218

$\phi_2$

4210
Aperture
Optimizing
Module
(Optional)

$\phi_2'$

$\phi_1$

$\phi_1'$

4204

4216

## FIG.42

At node
4212

FIG.43A

At node
4216

$\phi_1$

FIG.43B

At node
4214

FIG.43C

At node
4218

$\phi_2$

FIG.43D

EP 1 135 853 B1

UDF Module
10

Input
Signal
40 → Frequency
Selectivity

Frequency
Translation

Frequency
Selectivity → Output
Signal
50

4408A

4410

4408B

FIG.44

FIG.45

EP 1 135 853 B1

4602

4604

At the rising edge of $Q_1$ during t, the first switch 55A closes, and the first capacitor 65A charges to $VI_t$, such that node 4516 is at $VI_t$

4606

At the rising edge of $Q_2$ during t, the second switch 55B closes, and the second capacitor 65B charges to $VI_t$, such that node 65B is at $VI_t$

4608

At the rising edge of $Q_1$ during t+1, the first switch 55A closes, and the first capacitor 65A charges to $VI_{t+1}$, such that node 4516 is at $V_{t+1}$. Also, the first switch 55C closes, and the first capacitor 65C charges to $VI_t$, such that node 4536 is at $VI_t$

4610

At the rising edge of $Q_2$ during t+1, the second switch 55B closes, and the second capacitor 65B charges to $VI_{t+1}$, such that node 4518 is at $VI_{t+1}$. Also, the second switch 55D closes, and the second capacitor 65D charges to $VI_t$, such that node 4538 is at $VI_t$

FIG. 46

4702

| Time / Node | $t$ (rising edge of $Q_1$) | | $t$ (rising edge of $Q_2$) | | $t+1$ (rising edge of $Q_1$) | | $t+1$ (rising edge of $Q_2$) | |
|---|---|---|---|---|---|---|---|---|
| 4516 | $VI_t$ | 4704 | $VI_t$ | 4706 | $VI_{t+1}$ | 4710 | $VI_{t+1}$ | 4716 |
| 4518 | — | | $VI_t$ | 4708 | $VI_t$ | 4712 | $VI_{t+1}$ | 4718 |
| 4536 | — | 4705 | — | | $VI_t$ | 4714 | $VI_t$ | 4720 |
| 4538 | — | | — | 4709 | — | | $VI_t$ | 4722 |

FIG. 47

FIG. 48

4902

4904

Design frequency translation characteristics

4906

Design frequency selectivity characteristics

4908

Construct UDF module

FIG. 49

5002

5004

| Select sampling rate based on frequency of the input signal and the desired frequency of the output signal (see EQ 7). |

Step 4904

5006

| Obtain S plane low pass transfer function. |

5008

| Convert S plane low pass transfer function to Z plane low pass transfer function.  Set T equal to the inverse of the sampling rate. |

Step 4906

5010

| If necessary, modify Z plane low pass transfer function to obtain desired filtering characteristics. |

5008

| Construct UDF module. |

FIG. 50

5102

| Filter Type | Transformation | Associated Design Formulas |
|---|---|---|
| Lowpass | $z^{-1} = \dfrac{Z^{-1} - \alpha}{1 - \alpha Z^{-1}}$<br><br>5104 | 5112<br>$\alpha = \dfrac{\sin\left(\dfrac{\theta_p - \omega_p}{2}\right)}{\sin\left(\dfrac{\theta_p + \omega_p}{2}\right)}$<br><br>$\omega_p$ = desired cutoff frequency |
| Highpass | $-\dfrac{Z^{-1} + \alpha}{1 + \alpha Z^{-1}}$<br><br>5106 | 5114<br>$\alpha = -\dfrac{\cos\left(\dfrac{\omega_p + \theta_p}{2}\right)}{\cos\left(\dfrac{\omega_p - \theta_p}{2}\right)}$<br><br>$\omega_p$ = desired cutoff frequency |
| Bandpass | $-\dfrac{Z^{-2} - \dfrac{2\alpha k}{k+1} Z^{-1} + \dfrac{k-1}{k+1}}{\dfrac{k-1}{k+1} Z^{-2} - \dfrac{2\alpha k}{k+1} Z^{-1} + 1}$<br><br>5108 | 5116<br>$\alpha = \dfrac{\cos\left(\dfrac{\omega_2 + \omega_1}{2}\right)}{\cos\left(\dfrac{\omega_2 - \omega_1}{2}\right)}$<br><br>$k = \cot\left(\dfrac{\omega_2 - \omega_1}{2}\right) \tan\dfrac{\theta_p}{2}$<br><br>$\omega_2, \omega_1$ = desired upper and lower cutoff frequencies |
| Bandstop | $\dfrac{Z^{-2} - \dfrac{2\alpha}{1+k} Z^{-1} + \dfrac{1-k}{1+k}}{\dfrac{1-k}{1+k} Z^{-2} - \dfrac{2\alpha}{1+k} Z^{-1} + 1}$<br><br>5110 | 5118<br>$\alpha = \dfrac{\cos\left(\dfrac{\omega_2 + \omega_1}{2}\right)}{\cos\left(\dfrac{\omega_2 - \omega_1}{2}\right)}$<br><br>$k = \tan\left(\dfrac{\omega_2 - \omega_1}{2}\right) \tan\dfrac{\theta_p}{2}$<br><br>$\omega_2, \omega_1$ = desired upper and lower cutoff frequencies |

# FIG.51

SWITCH
S

CONTROL
SIGNAL
35

PULSES
12

CAPACITOR
65

T

FIG. 52A

$$q = C \cdot V \qquad \text{EQ.29}$$

$$V = A \cdot \sin(t) \qquad \text{EQ.30}$$

$$q(t) = C \cdot A \cdot \sin(t) \qquad \text{EQ.31}$$

$$\Delta q(t) = C \cdot A \cdot \sin(t) - C \cdot A \cdot \sin(t-T) \qquad \text{EQ.32}$$

$$\Delta q(t) = C \cdot A \cdot (\sin(t) - \sin(t-T)) \qquad \text{EQ.33}$$

$$\sin(\alpha) - \sin(\beta) = 2 \cdot \sin\left(\frac{\alpha-\beta}{2}\right) \cdot \cos\left(\frac{\alpha+\beta}{2}\right) \qquad \text{EQ. 34}$$

$$\Delta q(t) = 2 \cdot C \cdot A \cdot \sin\left[\frac{t-(t-T)}{2}\right] \cdot \cos\left[\frac{t+(t-T)}{2}\right] \qquad \text{EQ.35}$$

$$\Delta q(t) = 2 \cdot C \cdot A \cdot \sin\left(\frac{1}{2} \cdot T\right) \cdot \cos\left(t - \frac{1}{2} \cdot T\right) \qquad \text{EQ.36}$$

$$q(t) = \int C \cdot A \cdot (\sin(t) - \sin(t-T)) dt \qquad \text{EQ.37}$$

$$q(t) = -\cos(t) \cdot C \cdot A + \cos(t-T) \cdot C \cdot A \qquad \text{EQ.38}$$

$$q(t) = C \cdot A \cdot (\cos(t-T) - \cos(t)) \qquad \text{EQ.20}$$

# FIG.52B

FIG.52C

C=1,A=.5,T=π /10:

FIG.52D

POWER–CHARGE RELATIONSHIP

$$q = C \cdot V \qquad\qquad \text{EQ.21}$$

$$V = \frac{q}{C} \qquad\qquad \text{EQ.22}$$

$$V = \frac{J}{q} \qquad\qquad \text{EQ.23}$$

$$J = \frac{q^2}{C} \qquad\qquad \text{EQ.24}$$

$$P = \frac{J}{S} \qquad\qquad \text{EQ.25}$$

$$P = \frac{q^2}{C \cdot S} \qquad\qquad \text{EQ.26}$$

FIG.52E

## INSERTION LOSS

Insertion loss in dB is expressed by:

$$ILdB = 10 \cdot \log \left( \frac{Pin}{Pout} \right) \qquad EQ.27$$

or

$$ILdB = 10 \cdot \log \left[ \frac{\left( \frac{Vin^2}{Rin} \right)}{\left( \frac{Vout^2}{Rout} \right)} \right] \qquad EQ.28$$

# FIG.52F

FIG.53A

EP 1 135 853 B1

FIG.53A-1

DOWN-CONVERTED OUTPUT SIGNAL 22

ALIASING MODULE 16

65

55

CONTROL SIGNAL 35

14

INPUT SIGNAL 18

5314

**FIG.53B**

t₀  t₁  t₂  t₃  t₄

5316

5322

**FIG.53C**

t₀

5318

12

**FIG.53D**

t₀

5322

5324

**FIG.53E**

5326

**FIG.53F**

$$V_{OUT} = \sum_{j=0}^{n} \alpha_j \, Z^{-j} \, V_{IN} - \sum_{K=1}^{m} \beta_K \, Z^{-K} \, V_{OUT}$$

EQ. 11

$$V_{OUT} = \sum_{j=0}^{n=1} \alpha_j \, Z^{-j} \, V_{IN} - \sum_{K=1}^{m=2} \beta_K \, Z^{-K} \, V_{OUT}$$

EQ. 12

FIG. 54

$$V_{OUT} = \alpha_0 \, Z^0 \, V_{IN} + \alpha_1 Z^{-1} V_{IN} - \beta_1 Z^{-1} V_{OUT} - \beta_2 Z^{-2} V_{OUT}$$

EQ. 13

$$\alpha_0 = 0$$
$$V_{OUT} = \alpha_1 Z^{-1} V_{IN} - \beta_1 Z^{-1} V_{OUT} - \beta_2 Z^{-2} V_{OUT}$$

EQ. 14

UNIFIED DOWNCONVERTING
AND FILTERING
(UDF) MODULE
10

FREQUENCY TRANSLATOR ～30

FILTER ～20

DOWNCONVERT AND DELAY MODULE 45

OUTPUT MODULE 34

INPUT SIGNAL ($V_{IN}$) 40

OUTPUT SIGNAL ($V_{OUT}$) 50

55A

55B

65A

5622

C

R

CS1 (F1)

CS2 (F2)

**FIG. 55**

CHARGE ACCUMULATES IN C – LITTLE IF ANY DISCHARGE 5650A

CHARGE ACCUMULATES IN C – LITTLE IF ANY DISCHARGE 5650B

DISCHARGE FROM C 5652

**FIG. 56**

FILTER PASS BAND 5702

CUTOFF FREQUENCY 5704

**FIG. 57**

FIG.58

55

SWITCH
MODULE

6404

S          D

6416          6408

G

6418

**FIG.59**

55

SWITCH
MODULE

**FIG.60**

**FIG.61A**

**FIG.61B**

A. RISING EDGE PULSE GENERATOR

## FIG.62A

B. FALLING EDGE PULSE GENERATOR

## FIG.62B

FIG.63

nand

INPUT
SIGNAL
6524

FIG.64

PULSES
12

INPUT
SIGNAL
6524

OSCILLATOR
6530

FIG.65

FIG. 66